(19) Europäisches Patentamt
European Patent Office
Office européen des brevets

(11) EP 4 764 545 A1

(12) EUROPEAN PATENT APPLICATION
published in accordance with Art. 153(4) EPC

(43) Date of publication:
24.06.2026 Bulletin 2026/26

(51) International Patent Classification (IPC):
G01R 31/392 (2019.01)    G01R 31/3835 (2019.01)
G01R 31/36 (2020.01)     G01R 19/10 (2006.01)
G01R 31/367 (2019.01)    G01R 19/165 (2006.01)
G01R 19/00 (2006.01)     G01R 19/12 (2006.01)
G01R 31/52 (2020.01)

(21) Application number: 25783155.2

(52) Cooperative Patent Classification (CPC):
G01R 31/367; G01R 31/392

(22) Date of filing: 03.04.2025

(86) International application number:
PCT/KR2025/004443

(87) International publication number:
WO 2025/211796 (09.10.2025 Gazette 2025/41)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 03.04.2024  KR 20240045175
07.05.2024  KR 20240059709
02.04.2025  KR 20250042886

(71) Applicant: LG Energy Solution, Ltd.
Seoul 07335 (KR)

(72) Inventors:
• BYUN, Ha Eun
Daejeon 34122 (KR)
• KIM, Cheol Taek
Daejeon 34122 (KR)
• PARK, Jung Uk
Daejeon 34122 (KR)
• CHOI, Jung Hwan
Daejeon 34122 (KR)
• KIM, Young Min
Daejeon 34122 (KR)

(74) Representative: Plasseraud IP
104 Rue de Richelieu
CS92104
75080 Paris Cedex 02 (FR)

(54) BATTERY DIAGNOSIS DEVICE AND OPERATION METHOD THEREOF

(57) A method concerning on a battery's health includes: providing a battery apparatus comprising a plurality of battery cells; measuring a voltage for each of the plurality of battery cells; processing the plurality of voltages to provide a composite voltage; first determining if any of the plurality of battery cells has a rate of its voltage decrease that is greater than a rate of decrease of the composite voltage over the first predetermined length of time; second determining if any of the plurality of battery cells has a rate of voltage decrease that is greater than a rate of decrease of the composite voltage over the second predetermined length of time; and generating an alert if any battery cell is identified with any of the first determining step and the second determining step.

FIG.2

## Description

TECHNICAL FIELD

Cross-reference to Related Applications

The present application claims priority to Korean Patent Application No. 10-2024-0045175 filed on April 3, 2024, Korean Patent Application No. 10-2024-0059709 filed on May 7, 2024 and Korean Patent Application No. 10-2025-0042886 filed on April 2, 2025, the entire contents of which is incorporated herein for all purposes by these references.

Technical Field

Embodiments disclosed herein relate to a battery diagnosis apparatus and an operating method thereof.

BACKGROUND ART

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

DISCLOSURE OF THE INVENTION

TECHNICAL PROBLEM

When a short circuit or a failure of another type occurs inside a battery, the possibility of damage to devices (e.g., EV, ESS) including the battery may increase. Accordingly, there is a need for a scheme to reduce the possibility of damage to devices including a battery by detecting an abnormal state of the battery.

Conventionally, a battery cell has been diagnosed by a calculation scheme using all of a state of charge (SOC), current, capacity, and open circuit voltage (OCV) information. According to such a diagnosis method, because of use of many factors, it may be difficult to perform diagnosis when specific information out of the foregoing information is missing. This may be a big issue in the battery management system implemented with a server device that has to collect data from the vehicle, and may excessively increase memory usage. Thus, there is a need for data simplification required for battery diagnosis.

According to embodiments disclosed herein, there may be provided a battery diagnosis apparatus and an operating method thereof by which abnormality of a battery may be diagnosed merely using battery OCV data information.

Technical problems of the embodiments disclosed herein are not limited to the aforementioned technical problems, and other unmentioned technical problems would be clearly understood by those of ordinary skill in the art from the following description.

TECHNICAL SOLUTION

A battery diagnosis apparatus according to an embodiment disclosed herein includes an interface configured to obtain open circuit voltage (OCV) data of a battery cell and one or more processors configured to calculate a plurality of OCV deviations indicating a difference between an average OCV corresponding to a plurality of points in time for each of a plurality of battery cells included in a specific battery unit and an OCV of the battery cell, based on the OCV data, obtain a plurality of OCV deviation variances indicating a change degree of the plurality of OCV deviations for each of the plurality of points in time, apply a weighted moving average to the plurality of OCV deviation variances to obtain an OCV moving average, and diagnose abnormality of the battery cell based on the OCV moving average.

In the battery diagnosis apparatus according to an embodiment disclosed herein, the one or more processors may be further configured to, when a kth OCV deviation variance corresponding to a kth point in time among the plurality of points in time is less than a first threshold OCV deviation variance and a (k-1)th OCV deviation corresponding to a (k-1)th point in time previous to the kth point in time is greater than or equal to a threshold OCV deviation, change the kth OCV deviation variance into a specific OCV deviation variance and apply the weighted moving average to the plurality of OCV deviation variances including the specific OCV deviation variance to obtain the OCV moving average.

In the battery diagnosis apparatus according to an embodiment disclosed herein, the one or more processors may be further configured to diagnose abnormality of the battery cell based on a result of comparing the OCV moving average with a threshold moving average.

In the battery diagnosis apparatus according to an embodiment disclosed herein, the one or more processors may be further configured to, when the OCV moving average is less than the threshold moving average, increase a diagnosis count by a first increment and diagnose abnormality of the battery cell based on a result of comparing the diagnosis count with a threshold count.

In the battery diagnosis apparatus according to an embodiment disclosed herein, the one or more processors may be further configured to calculate a second increment based on a degree to which the OCV moving average is less than the threshold moving average, and further increase the diagnosis count by the second increment.

In the battery diagnosis apparatus according to an embodiment disclosed herein, the one or more processors may be further configured to reduce the diagnosis count when the OCV moving average is greater than or equal to the threshold moving average.

In the battery diagnosis apparatus according to an embodiment disclosed herein, the one or more processors may be further configured to change some OCV deviation variances less than a second threshold OCV deviation variance among the plurality of OCV deviation variances into the second threshold OCV deviation variance and apply the weighted moving average to the plurality of OCV deviation variances including the some OCV deviation variances to obtain the OCV moving average.

In the battery diagnosis apparatus according to an embodiment disclosed herein, the one or more processors may be further configured to apply an exponentially weighted moving average to the plurality of OCV deviation variances to obtain the OCV moving average.

In the battery diagnosis apparatus according to an embodiment disclosed herein, the OCV data may include a result of compensating for before-compensation OCV data of at least some of the battery cells by using a balancing capacity based on balancing processing performed on the at least some of the battery cells.

In the battery diagnosis apparatus according to an embodiment disclosed herein, the balancing capacity may include a result of accumulating a discharging capacity of the battery cell based on the balancing processing.

A battery diagnosis method according to an embodiment disclosed herein includes obtaining open circuit voltage (OCV) data of a battery cell, calculating a plurality of OCV deviations indicating a difference between an average OCV corresponding to a plurality of points in time for each of a plurality of battery cells included in a specific battery unit and an OCV of the battery cell, based on the OCV data, obtaining a plurality of OCV deviation variances based on the plurality of OCV deviations, applying a weighted moving average to the plurality of OCV deviation variances to obtain an OCV moving average, and diagnosing abnormality of the battery cell based on the OCV moving average.

In the battery diagnosis method according to an embodiment disclosed herein, the obtaining of the OCV moving average may include, when a kth OCV deviation variance corresponding to a kth point in time among the plurality of points in time is less than a first threshold OCV deviation variance and a (k-1)th OCV deviation corresponding to a (k-1)th point in time previous to the kth point in time is greater than or equal to a threshold OCV deviation, changing the kth OCV deviation variance into a specific OCV deviation variance and applying the weighted moving average to the plurality of OCV deviation variances including the specific OCV deviation variance to obtain the OCV moving average.

In the battery diagnosis method according to an embodiment disclosed herein, the diagnosing of abnormality of the battery cell may include diagnosing abnormality of the battery cell based on a result of comparing the OCV moving average with a threshold moving average.

In the battery diagnosis method according to an embodiment disclosed herein, the diagnosing of abnormality of the battery cell may include, when the OCV moving average is less than the threshold moving average, increasing a diagnosis count by a first increment and diagnosing abnormality of the battery cell based on a result of comparing the diagnosis count with a threshold count.

In the battery diagnosis method according to an embodiment disclosed herein, the diagnosing of abnormality of the battery cell may include calculating a second increment based on a degree to which the OCV moving average is less than the threshold moving average, and further increasing the diagnosis count by the second increment.

In the battery diagnosis method according to an embodiment disclosed herein, the diagnosing of abnormality of the battery cell may include reducing the diagnosis count when the OCV moving average is greater than or equal to the threshold moving average.

In the battery diagnosis method according to an embodiment disclosed herein, the obtaining of the OCV moving average may include changing some OCV deviation variances less than a second threshold OCV deviation variance among the plurality of OCV deviation variances into the second threshold OCV deviation variance and applying the weighted moving average to the plurality of OCV deviation variances including the some OCV deviation variances to obtain the OCV moving average.

In the battery diagnosis method according to an embodiment disclosed herein, the obtaining of the OCV moving average may include applying an exponentially weighted moving average to the plurality of OCV deviation variances to obtain the OCV moving average.

In the battery diagnosis method according to an embodiment disclosed herein, the OCV data may include a result of compensating for before-compensation OCV data of at least some of the battery cells by using a balancing capacity based on balancing processing performed on the at least some of the battery cells.

In the battery diagnosis method according to an embodiment disclosed herein, the balancing capacity may include a result of accumulating a discharging capacity of the battery cell based on the balancing processing.

A battery diagnosis method according to an embodiment disclosed herein includes providing a battery apparatus comprising a plurality of battery cells; measuring a voltage for each of the plurality of battery cells at a single measurement timeframe, which provides a plurality of voltages of the plurality of battery cells measured at the single measurement timeframe; processing the plurality of voltages for the plurality of battery cells measured at the single measurement timeframe to provide a composite voltage for the plurality of battery cells for the single measurement timeframe; repeating the step of measuring a voltage multiple times to provide multiple voltages for each battery cell measured at multiple measurement timeframes, which provides multiple sets of voltages for the plurality of battery cells such that each set of voltages represents voltages for the plurality of battery cells measured at one of the multiple measurement timeframes; repeating the step of processing each set of voltages to provide multiple composite voltages for the plurality of battery cells such that each of the multiple composite voltages represents a composite voltage for the plurality of battery cells at one of the multiple measurement timeframes; first determining if any of the plurality of battery cells has a rate of its voltage decrease that is greater, by at least a first predetermined threshold over a first predetermined length of time, than a rate of decrease of the composite voltage for the plurality of battery cells over the first predetermined length of time; second determining if any of the plurality of battery cells has a rate of voltage decrease that is greater, by at least a second predetermined threshold over a second predetermined length of time, than a rate of decrease of the composite voltage for the plurality of battery cells over the second predetermined length of time; and generating an alert if any battery cell is identified with any of the first determining step and the second determining step, wherein the first predetermined threshold is substantially smaller than the second predetermined threshold while the first predetermined length of time is longer than the second predetermined length of time such that the first determining step is to identify any battery cell that has its voltage decreasing substantially slower than any battery cell that would be identified with the second determining step and therefore would not be identified with the second determining step.

In the battery diagnosis method according to an embodiment disclosed herein, the voltage measured is an open circuit voltage (OCV), wherein the composite voltage is an average voltage.

In the battery diagnosis method according to an embodiment disclosed herein, no alert is generated even if any of the plurality of battery cells has a rate of voltage decrease being greater, by at least the first predetermined threshold over a third predetermined length of time, than a rate of decrease of the composite voltage for the plurality of battery cells over the third predetermined length of time when the third predetermined length of time shorter than the second predetermined length of time and further when the rate of voltage decrease for any of the plurality of battery cells is within an acceptable range of fluctuation of the rate of voltage decrease for individual cells over the third predetermined length of time.

In the battery diagnosis method according to an embodiment disclosed herein, the third predetermined length of time is within a range formed with two ones selected from the group consisting of 1 hour, 2 hours, 3 hours, 4 hours, 5 hours, 6 hours, 7 hours, 8 hours, 10 hours, 11 hours, 12 hours, 13 hours, 14 hours, 15 hours, 16 hours, 17 hours, 18 hours, 19 hours, 20 hours, 21 hours, 22 hours, 23 hours, 1 day, 2 days, 3 days, 4 days, 5 days, 6 days, 7 days, 8 days, 9 days, and 10 days.

In the battery diagnosis method according to an embodiment disclosed herein, the acceptable range of fluctuation is within a range formed with two ones selected from the group consisting of 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50 mV/t.

In the battery diagnosis method according to an embodiment disclosed herein, the alert comprises information suggesting a consultation about the battery's health, suggesting a service with regard to the battery apparatus, and/or replacing at least part of the battery apparatus.

In the battery diagnosis method according to an embodiment disclosed herein, third determining if any of the plurality of battery cells has a rate of its voltage decrease that is greater, by a third predetermined threshold over a third predetermined length of time, than a rate of decrease of the composite voltage for the plurality of battery cells over the third predetermined length of time; and generating an alert if any battery cell is identified with any of the first determining step, the second determining step, and the third determining step, wherein the second predetermined threshold is substantially smaller than the third predetermined threshold while the third predetermined length of time is shorter than the second predetermined length of time.

In the battery diagnosis method according to an embodiment disclosed herein, no alert is generated even if any of the plurality of battery cells has a rate of voltage decrease being greater, by at least the first predetermined threshold over the third predetermined length of time, than the rate of decrease of the composite voltage for the plurality of battery cells over the third predetermined length of time when the rate of voltage decrease for any of the plurality of battery cells is within an acceptable range of fluctuation of the rate of voltage decrease for individual cells over the third predetermined length of time.

In the battery diagnosis method according to an embodiment disclosed herein, measuring the voltage for each of the plurality of battery cells at the single measurement timeframe occurs simultaneously or consecutively such that measurements for the plurality of battery cells are completed within a generally same timeframe.

In the battery diagnosis method according to an embodiment disclosed herein, the step of first determining comprises: for each of the plurality of battery cells, computing a difference between the voltage of the battery cell and the composite voltage for the plurality of battery cells for a first measurement timeframe of the multiple measurement timeframes, which provides a first set of values for the difference for the plurality of battery cells for the first measurement timeframe such that the first set of values comprises a value for the difference for each of the plurality of cells for the first measurement timeframe; repeating the step of computing a difference for additional measurement timeframes of the multiple timeframes, which provides additional sets of values for the difference for the plurality of battery cells for the additional measurement timeframes such that each set of values comprises a value for the difference for each of the plurality of cells for one measurement timeframe of the additional measurement timeframes; for each of the plurality of battery cells, computing a rate of change in the difference over the first predetermined length of time using at least part of the first set of values and the additional sets of values; and determining if there is any battery cell having a rate of voltage decrease over the first predetermined length of time greater than the first predetermined threshold using the computed rate of change for each of the plurality of battery cells.

In the battery diagnosis method according to an embodiment disclosed herein, the step of computing a rate of change in the difference over the first predetermined length of time computes the rate of change in the difference for the first predetermined length of time beginning at the first measurement timeframe, wherein the step of first determining further comprises: for each of the plurality of battery cells, repeating the step of computing a rate of change in the difference over the first predetermined length of time beginning at one or more of the additional measurement timeframes, which provides rates of change in the difference for each of the plurality of battery cells such that each of the rates of change in the difference for each of the plurality of battery cells represents the rate of change for the battery cell for one of the one or more of the additional measurement timeframes; and using at least part of the rates of change in the difference as computed for each of the plurality of battery cells to determine if there is any battery cell having a rate of voltage decrease over the first predetermined length of time greater than the first predetermined threshold for the first predetermined length of time beginning at one or more of the additional measurement timeframes.

In the battery diagnosis method according to an embodiment disclosed herein, wherein, when at least one of the plurality of battery cell is determined to have its rate of voltage decrease greater than the first predetermined threshold over the first predetermined length of time beginning any of the measurement timeframes, the battery cell is identified, which causes generating the alert.

In the battery diagnosis method according to an embodiment disclosed herein, the step of first determining further comprises: counting, for each of the plurality of battery cells, each time when the battery cell is determined to have its rate of voltage decrease over the first predetermined length of time to be greater than the first predetermined threshold; and determining, for each of the plurality of battery cells, if counting reaches a predetermined counting threshold.

In the battery diagnosis method according to an embodiment disclosed herein, when counting for one of the plurality of battery cell reaches the predetermined counting threshold, the battery cell is identified, which causes generating the alert.

In the battery diagnosis method according to an embodiment disclosed herein, the step of second determining comprises: for each of the plurality of battery cells, computing a rate of change in the difference over the second predetermined length of time using at least part of the first set of values and the additional sets of values; and determining if there is any battery cell having a rate of voltage decrease over the second predetermined length of time greater than the second predetermined threshold using the computed rate of change for each of the plurality of battery cells.

In the battery diagnosis method according to an embodiment disclosed herein, the step of computing a rate of change in the difference over the second predetermined length of time computes the rate of change in the difference for the second predetermined length of time beginning at the first measurement timeframe or another measurement timeframe, wherein the step of second determining further comprises: for each of the plurality of battery cells, repeating the step of computing a rate of change in the difference over the second predetermined length of time beginning at one or more of the additional measurement timeframes, which provides rates of change in the difference for each of the plurality of battery cells such that each of the rates of change in the difference for each of the plurality of battery cells represents the rate of change for the battery cell for one of the one or more of the additional measurement timeframes; and using at least part of the rates of change in the difference as computed for each of the plurality of battery cells to determine if there is any battery cell having a rate of voltage decrease over the second predetermined length of time greater than the second predetermined threshold for the second predetermined length of time beginning at one or more of the additional measurement timeframes.

In the battery diagnosis method according to an embodiment disclosed herein, when at least one of the plurality of battery cell is determined to have its rate of voltage decrease greater than the second predetermined threshold over the second predetermined length of time beginning any of the measurement timeframes, the battery cell is identified, which causes generating the alert.

In the battery diagnosis method according to an embodiment disclosed herein, the step of second determining further comprises: counting, for each of the plurality of battery cells, each time when the battery cell is determined to have its rate of voltage decrease over the second predetermined length of time to be greater than the second predetermined threshold; and determining, for each of the plurality of battery cells, if counting reaches a predetermined counting threshold.

In the battery diagnosis method according to an embodiment disclosed herein, when counting for one of the plurality of battery cell reaches the predetermined counting threshold, the battery cell is identified, which causes generating the alert.

In the battery diagnosis method according to an embodiment disclosed herein, the step of second determining comprises: for each of the plurality of battery cells, computing a difference between the voltage of the battery cell and the composite voltage for the plurality of battery cells for a first measurement timeframe of the multiple measurement timeframes, which provides a first set of values for the difference for the plurality of battery cells for the first measurement timeframe such that the first set of values comprises a value for the difference for each of the plurality of cells for the first measurement timeframe; repeating the step of computing a difference for additional measurement timeframes of the multiple timeframes, which provides additional sets of values for the difference for the plurality of battery cells for the additional measurement timeframes such that each set of values comprises a value for the difference for each of the plurality of cells for one measurement timeframe of the additional measurement timeframes; for each of the plurality of battery cells, computing a rate of change in the difference over the second predetermined length of time using at least part of the first set of values and the additional sets of values; and determining if there is any battery cell having a rate of voltage decrease over the second predetermined length of time greater than the second predetermined threshold using the computed rate of change for each of the plurality of battery cells.

In the battery diagnosis method according to an embodiment disclosed herein, the step of computing a rate of change in the difference over the second predetermined length of time computes the rate of change in the difference for the second predetermined length of time beginning at the first measurement timeframe or another measurement timeframe, wherein the step of second determining further comprises: for each of the plurality of battery cells, repeating the step of computing a rate of change in the difference over the second predetermined length of time beginning at one or more of the additional measurement timeframes, which provides rates of change in the difference for each of the plurality of battery cells such that each of the rates of change in the difference for each of the plurality of battery cells represents the rate of change for the battery cell for one of the one or more of the additional measurement timeframes; and using at least part of the rates of change in the difference as computed for each of the plurality of battery cells to determine if there is any battery cell having a rate of voltage decrease over the second predetermined length of time greater than the second predetermined threshold for the second predetermined length of time beginning at one or more of the additional measurement timeframes.

In the battery diagnosis method according to an embodiment disclosed herein, when at least one of the plurality of battery cell is determined to have its rate of voltage decrease greater than the second predetermined threshold over the second predetermined length of time beginning any of the measurement timeframes, the battery cell is identified, which causes generating the alert.

In the battery diagnosis method according to an embodiment disclosed herein, the step of second determining further comprises: counting, for each of the plurality of battery cells, each time when the battery cell is determined to have its rate of voltage decrease over the second predetermined length of time to be greater than the second predetermined threshold; and determining, for each of the plurality of battery cells, if counting reaches a predetermined counting threshold.

In the battery diagnosis method according to an embodiment disclosed herein, when counting for one of the plurality of battery cell reaches the predetermined counting threshold, the battery cell is identified, which causes generating the alert.

A non-transitory computer readable medium storing instructions that, when executed, performs the method according to an embodiment disclosed herein.

## ADVANTAGEOUS EFFECTS

According to embodiments disclosed herein, data used for abnormality diagnosis of a battery may be simplified.

According to embodiments disclosed herein, by diagnosing abnormality of a battery cell based on an OCV moving average obtained by applying a weighted moving average to an OCV deviation, the accuracy of battery abnormality diagnosis may be improved.

According to embodiments disclosed herein, a voltage behavior of dropping for a long term may be diagnosed, thereby preventing fire from occurring.

In addition, various effects identified directly or indirectly through this document may be provided.

## BRIEF DESCRIPTION OF THE DRAWINGS

FIG. 1 is a block diagram of a battery diagnosis apparatus according to an embodiment;

FIG. 2 is a view for describing an embodiment in which a battery diagnosis apparatus diagnoses abnormality of a battery cell;

FIGS. 3A to 3C are views for describing an embodiment in which a battery diagnosis apparatus diagnoses abnormality of a battery cell;

FIG. 4 is an operating flowchart of a battery diagnosis apparatus according to an embodiment; and

FIG. 5 illustrates a block diagram of another electronic device, in accordance with one embodiment.

FIG. 6 is a graph illustrating Open Circuit Voltage (OCV) measurement at corresponding timepoints for a certain length of time for each battery cell of a battery module, in accordance with one embodiment.

FIG. 7 is a graph illustrating OCV measurements of multiple battery cells including first, second, third, fourth, and fifth battery cells, at corresponding timepoints and an average OCV thereof for a certain length of time.

FIG. 8A is a graph illustrating the OCV measurement for battery cell 1, along with the average OCV, in accordance with one embodiment.

FIG. 8B is a graph showing the difference between the OCV values of battery cell 1 and the average OCV.

FIG. 8C is a graph depicting the slope of the OCV difference values over a shorter-term(or first) length of time for battery cell 1, compared to a shorter-term threshold.

FIG. 8D is a graph representing the count of occurrences where the slope shown in FIG. 8C falls below the shorter-term threshold level.

FIG. 8E is a graph illustrating a moving average calculated over the shorter-term length of time for the battery cell 1.

FIG. 8F is a graph representing the count of occurrences based on the moving average calculation.

FIG. 8G is a graph illustrating a weighted moving average calculated over the shorter-term length of time for the battery cell 1.

FIG. 8H is a graph illustrating the count of occurrences based on the weighted moving average calculation.

FIG. 8I is a graph illustrating the slope from FIG. 8C alongside the average slope for multiple battery cells.

FIG. 8J is a graph illustrating the slope of the OCV difference values over a longer-term (or second) length of time for battery cell 1, compared to a longer-term threshold.

FIG. 8K is a graph showing the count of occurrences where the slope of FIG. 8F falls below the longer-term threshold.

FIG. 8L is a graph illustrating a moving average calculated over the longer-term length of time for the battery cell 1.

FIG. 8M is a graph representing the count of occurrences based on the moving average calculation.

FIG. 8N is a graph illustrating a weighted moving average calculated over the longer-term length of time for the battery cell 1.

FIG. 8O is a graph illustrating the count of occurrences based on the weighted moving average calculation.

FIG. 8P is a graph depicting the slope from FIG. 8J alongside the average slope for multiple battery cells.

FIG. 8Q is a graph comparing the slopes FIG. 8C and FIG. 8F with their respective short- and long-term thresholds.

FIG. 9A is a graph illustrating the OCV measurement for battery cell 2, along with the average OCV, in accordance with one embodiment.

FIG. 9B is a graph showing the difference between the OCV values of battery cell 2 and the average OCV.

FIG. 9C is a graph depicting the slope of the OCV difference values over a shorter-term length of time for battery cell 2, compared to a shorter-term threshold.

FIG. 9D is a graph representing the count of occurrences where the slope shown in FIG. 9C falls below the shorter-term threshold level.

FIG. 9E is a graph illustrating a moving average calculated over the shorter-term length of time for the battery cell 2.

FIG. 9F is a graph representing the count of occurrences based on the moving average calculation.

FIG. 9G is a graph illustrating a weighted moving average calculated over the shorter-term length of time for the battery cell 2.

FIG. 9H is a graph illustrating the count of occurrences based on the weighted moving average calculation.

FIG. 9I is a graph illustrating the slope from FIG. 9C alongside the average slope for multiple battery cells.

FIG. 9J is a graph illustrating the slope of the OCV difference values over a longer-term length of time for battery cell 2, compared to a longer-term threshold.

FIG. 9K is a graph showing the count of occurrences where the slope of FIG. 9F falls below the longer-term threshold.

FIG. 9L is a graph illustrating a moving average calculated over the longer-term length of time for the battery cell 2.

FIG. 9M is a graph representing the count of occurrences based on the moving average calculation.

FIG. 9N is a graph illustrating a weighted moving average calculated over the longer-term length of time for the battery cell 2.

FIG. 9O is a graph illustrating the count of occurrences based on the weighted moving average calculation.

FIG. 9P is a graph depicting the slope from FIG. 9J alongside the average slope for multiple battery cells.

FIG. 9Q is a graph comparing the slopes FIG. 9C and FIG. 9F with their respective short- and long-term thresholds.

FIG. 10A is a graph illustrating the OCV measurement for battery cell 4, along with the average OCV, in accordance with one embodiment.

FIG. 10B is a graph showing the difference between the OCV values of battery cell 4 and the average OCV.

FIG. 10C is a graph depicting the slope of the OCV difference values over a shorter-term length of time for battery cell 4, compared to a shorter-term threshold.

FIG. 10D is a graph representing the count of occurrences where the slope shown in FIG. 10C falls below the shorter-term threshold level.

FIG. 10E is a graph illustrating a moving average calculated over the shorter-term length of time for the battery cell 4.

FIG. 10F is a graph representing the count of occurrences based on the moving average calculation.

FIG. 10G is a graph illustrating a weighted moving average calculated over the shorter-term length of time for the battery cell 4.

FIG. 10H is a graph illustrating the count of occurrences based on the weighted moving average calculation.

FIG. 10I is a graph illustrating the slope from FIG. 10C alongside the average slope for multiple battery cells.

FIG. 10J is a graph illustrating the slope of the OCV difference values over a longer-term length of time for battery cell 4, compared to a longer-term threshold.

FIG. 10K is a graph showing the count of occurrences where the slope of FIG. 10F falls below the longer-term threshold.

FIG. 10L is a graph illustrating a moving average calculated over the longer-term length of time for the battery cell 4.

FIG. 10M is a graph representing the count of occurrences based on the moving average calculation.

FIG. 10N is a graph illustrating a weighted moving average calculated over the longer-term length of time for the battery cell 4.

FIG. 10O is a graph illustrating the count of occurrences based on the weighted moving average calculation.

FIG. 10P is a graph depicting the slope from FIG. 10J alongside the average slope for multiple battery cells.

FIG. 10Q is a graph comparing the slopes FIG. 10C and FIG. 10F with their respective short- and long-term thresholds.

FIG. 11A is a graph illustrating an expanded view of FIG. 3 over a frequent-term (or third) length of time, for the OCV measurement of the multiple battery cells.

FIG. 11B is a graph illustrating an expanded view of FIG. 4.

FIG. 11C is a graph illustrating an expanded view of FIG. 8A.

FIG. 11D is a graph illustrating an expanded view of FIG. 8B.

FIG. 11E is a graph illustrating an expanded view of FIG. 8C.

FIG. 11F is a graph illustrating an expanded view of FIG. 8E.

FIG. 11G is a graph illustrating an expanded view of FIG. 8G.

FIG. 11H is a graph illustrating an expanded view of FIG. 8J.

FIG. 11I is a graph illustrating an expanded view of FIG. 8L.

FIG. 11J is a graph illustrating an expanded view of FIG. 8N.

FIGS. 12A-14 illustrate flowcharts of a method for detecting battery abnormality, in accordance with one embodiment.

FIG. 15 illustrates one or more computing systems for use with one or more implementations

MODE FOR CARRYING OUT THE INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to various embodiments, each of the above-described components (e.g., a module or program) may include a single entity or a plurality of entities, some of which may be separately disposed on other components. According to various embodiments, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

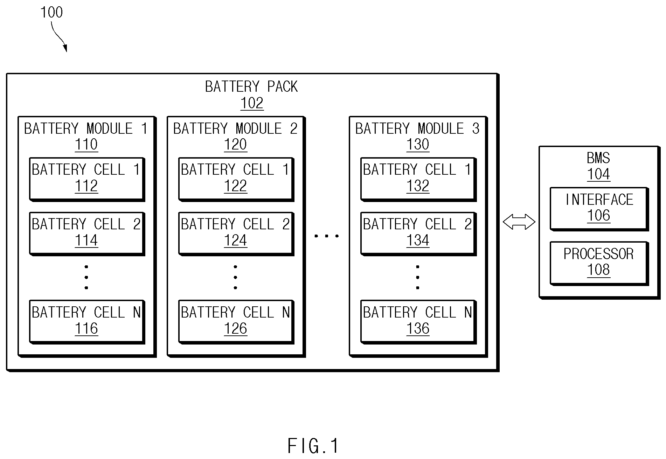

FIG. 1 is a block diagram of a battery diagnosis apparatus according to an embodiment.

Referring to FIG. 1, a battery pack 102 may include a plurality of modules 110, 120, and 130, which respectively include a plurality of battery cells 112, 114, 116, 122, 124, 126, 132, 134, and 136. According to an embodiment, the battery pack 102 may be a battery mounted inside an electric vehicle to supply power to the electric vehicle.

According to an embodiment, a battery diagnosis apparatus 100 may diagnose abnormality of a battery unit based on OCV data obtained from a battery unit. In the present disclosure, the battery unit may mean the battery pack 102, the battery module 110, 120, or 130, or the battery cell 112, 114, 116, 122, 124, 126, 132, 134, or 136.

According to an embodiment, the battery diagnosis apparatus 100 may be formed integrally with the battery unit. In this case, the battery diagnosis apparatus 100 may be included in a battery management system (BMS) of the battery unit.

According to an embodiment, the battery diagnosis apparatus 100 may be formed separately from the battery unit. In this case, the battery diagnosis apparatus 100 may be implemented as an external server connected to the battery unit through a wireless network.

The following operation of the battery diagnosis apparatus 100 may also be performed in various devices such as not only a battery management system (BMS) in a vehicle, but also a server, a cloud, a charger, a charger/discharger, etc.

According to an embodiment, the battery diagnosis apparatus 100 may include an interface 106 and one or more processor 108.

According to an embodiment, the interface 106 may obtain OCV data of the battery cell 112, 114, 116, 122, 124, 126, 132, 134, and/or 136. For example, the interface 106 may obtain information regarding voltage, current, and/or temperature of the battery cell 112, 114, 116, 122, 124, 126, 132, 134, and/or 136 and configure OCV data based on the obtained information. In this case, the interface 106 may include a sensor for obtaining the information regarding the voltage, current, and/or temperature and a processor for configuring the OCV data based on the obtained information. In another example, the interface 106 may receive the OCV data of the battery cell 112, 114, 116, 122, 124, 126, 132, 134, and/or 136, obtained by the battery unit. In this case, the interface 106 may include a communication circuit capable of performing wired and/or wireless network communication.

For reference, a feature deviation between a plurality of battery cells may occur due to internal/external factors in a manufacturing process and/or use process, and the feature deviation between the plurality of battery cells may cause a voltage unbalancing state. A balancer may execute balancing processing (e.g., discharging) with respect to at least some of the plurality of battery cells so as to be used for resolving the voltage unbalancing state among the plurality of battery cells. When balancing processing is executed, the voltage unbalancing state is entirely or partially resolved even for a battery cell with abnormality occurring therein, such that balancing processing conducted in the past may act as an obstacle to detection of a battery cell with abnormality occurring therein.

When a battery cell with abnormality occurring therein is charged, a part of charging power may be consumed as leakage current without being stored in the battery cell with abnormality occurring therein. When the battery cell with abnormality occurring therein is discharged, a part of discharging power may be consumed as leakage current without being supplied to an electric load. As a result, in charging, a voltage change (i.e., an increasing amount of SOC) of the battery cell with abnormality occurring therein may be less than a normal battery cell. On the other hand, in discharging, a voltage change (i.e., a decreasing amount of SOC) of the battery cell with abnormality occurring therein may be greater than the normal battery cell. Even in a non-load state, energy stored in the battery cell with abnormality occurring therein may be consumed as leakage current.

A balancer (not shown) may be configured to perform balancing processing on at least some battery cells requiring balancing among the plurality of battery cells.

The present disclosure may compensate for before-compensation OCV data of each of the plurality of battery cells, by using a balancing capacity of each of the plurality of battery cells. The compensated OCV data of the battery cell may be an estimate value of the OCV data of the battery cell when balancing processing on the battery cell is not executed.

According to an embodiment, the OCV data may be a result of compensating for the before-compensation OCV data of each battery cell by using the balancing capacity based on balancing processing executed by the balancer for each battery cell.

According to an embodiment, the balancing capacity may be a result of accumulating a discharging capacity of a battery cell through balancing processing. For example, the balancing capacity may be an accumulative value of the discharging capacity of the battery cell through balancing processing conducted during a specific period, i.e., a total discharging capacity during the specific period. For example, the balancing capacity of the battery cell on which balancing processing is not performed even once during the specific period may be 0.

According to an embodiment, (i) an SOC estimate value of each battery cell may be determined by applying an SOC-OCV map to the before-compensation OCV data of each battery cell, (ii) the SOC estimate value of each battery cell may be compensated for by summing an SOC variance corresponding to the balancing capacity to the SOC estimate value of each battery cell, and (iii) the SOC-OCV map may be applied to the compensated SOC estimate value of each battery cell to determine the OCV data (i.e., the compensated OCV data).

As such, by compensating for the before-compensation OCV data of the battery cell on which balancing processing is performed, a battery cell with abnormality occurring therein among the plurality of battery cells may be accurately detected even in a state where the voltage unbalancing state is resolved by balancing processing among the plurality of battery cells.

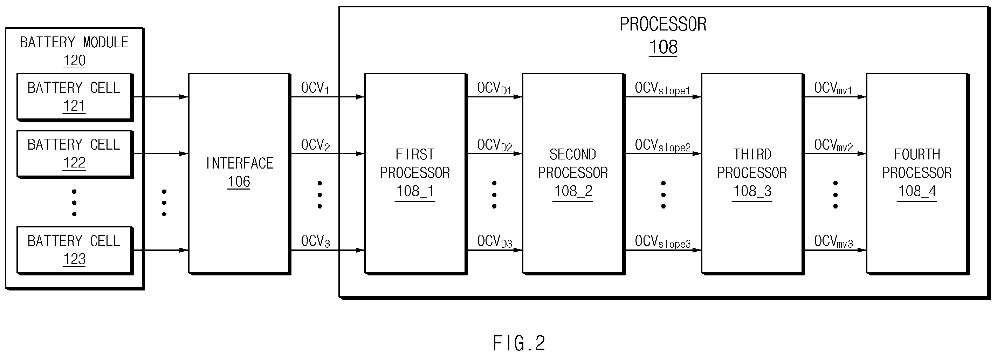

According to an embodiment, the processor 108 may calculate a determination value (e.g., an OCV deviation, an OCV deviation variance, an OCV moving average, and/or diagnosis discount) based on the OCV data obtained by the interface 106. According to an embodiment, the processor 108 may extract OCV data in a designated voltage range from the OCV data. The processor 108 may calculate a determination value based on the extracted OCV data in the designated voltage range. Various embodiments where the processor 108 calculates the determination value may be described in detail with reference to FIGS. 2 to 3C described below.

According to an embodiment, the processor 108 may diagnose abnormality of the battery unit based on the calculated determination value.

According to an embodiment, the processor 108 may diagnose abnormality of the battery unit by comparing the determination value with a corresponding threshold value. For example, the processor 108 may diagnose the battery unit (e.g., the battery cell 112, 114, 116, 122, 124, 126, 132, 134, and/or 136 as an abnormal battery unit when the determination (e.g., a diagnosis count) is greater than or equal to a threshold value (e.g., 40).

The processor 108 may be implemented with one processor or separate processors. The processor may execute software to control at least another component (e.g., a hardware or software component) of the battery diagnosis apparatus 100 connected to the processor and may process or compute various data.

According to an embodiment, the battery diagnosis apparatus 100 may transmit a battery diagnosis result to outside (e.g., a cloud server or a user terminal). Herein, the cloud server may provide a service for providing a battery diagnosis result to each of a plurality of users. A user terminal may include a terminal such as a personal computer (PC) or a smartphone. For example, the battery diagnosis apparatus 100 may provide information about the abnormal battery cell to the user terminal through a communication unit (not shown) and provide the information about the abnormal battery cell through a display provided in a vehicle, a charger, etc.

Hereinbelow, referring to FIGS. 2 to 3C, various embodiments will be described in which the processor 108 diagnoses abnormality of the battery unit. FIGS. 2 to 3C may be described using components of FIG. 1 (e.g., the interface 106 and the processor 108).

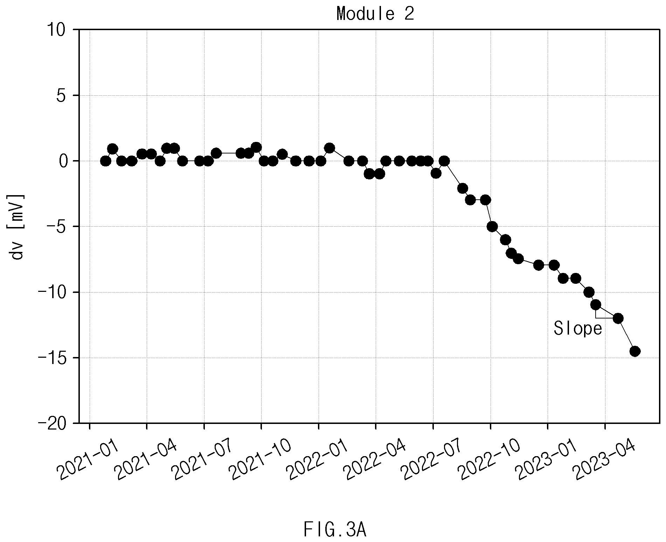

FIG. 2 is a view for describing an embodiment in which a battery diagnosis apparatus calculates a determination value. FIGS. 3A to 3C are views for describing an embodiment in which a battery diagnosis apparatus diagnoses abnormality of a battery cell.

Referring to FIG. 2, the processor 108 may include a first processor 108_1, a second processor 108_2, a third processor 108_3, and a fourth processor 108_4.

According to an embodiment, the interface 106 may transmit OCV data of a plurality of battery cells included in a plurality of battery units (e.g., a plurality of battery modules) to the first processor 108_1. For example, the interface 106 may transmit OCV data $OCV_1$, $OCV_2$, and $OCV_3$ of the plurality of battery cells 121, 122, and 123 of a specific battery module 120 to the first processor 108_1. For reference, for convenience of a description, one battery module 120 will be described as an example, but the number of battery modules is not limited thereto.

According to an embodiment, the first processor 108_1 may calculate, based on the OCV data $OCV_1$, $OCV_2$, and $OCV_3$, for each of the plurality of battery cells 121, 122, and 123 included in a specific battery unit (e.g., the specific battery module 120), a plurality of OCV deviations $OCV_{D1}$, $OCV_{D2}$, and $OCV_{D3}$ indicating differences between an average OCV corresponding to a plurality of points in time and the OCV data $OCV_1$, $OCV_2$, and $OCV_3$ of the plurality of battery cells 121, 122, and 123. For example, the first processor 108_1 may calculate an OCV deviation $OCV_{D1\_1}$ indicating a difference between an average OCV (e.g., ($(OCV_{1\_1}+OCV_{2\_1}+OCV_{3\_1})/3)$) of the plurality of battery cells 121, 122, and 123 included in the specific battery module 120, corresponding to a first point in time, and OCV data $OCV_{1\_1}$ of the battery cell 121, corresponding to the first specific point in time, and calculate an OCV deviation $OCV_{D1\_2}$ indicating a difference between an average OCV (e.g., ($(OCV_{1\_2}+OCV_{2\_2}+OCV_{3\_2})/3)$)) of the plurality of battery cells 121, 122, and 123 included in the specific battery module 120, corresponding to a second point in time, and OCV data $OCV_{1\_2}$ of the battery cell 121, corresponding to the second specific point in time.

According to an embodiment, the first processor 108_1 may transmit the plurality of calculated OCV deviations $OCV_{D1}$, $OCV_{D2}$, and $OCV_{D3}$ corresponding to a plurality of points in time to the second processor 108_2.

According to an embodiment, the second processor 108_2 may obtain a plurality of OCV deviation variances $OCV_{slope1}$, $OCV_{slope2}$, and $OCV_{slope3}$ indicating change degrees of a plurality of OCV deviations for each of a plurality of points in time for the plurality of battery cells 121, 122, and 123. Herein, the plurality of OCV deviation variances $OCV_{slope1}$, $OCV_{slope2}$, and $OCV_{slope3}$ may respectively correspond to the plurality of battery cells 121, 122, and 123. For example, the second processor 108_2 may obtain the plurality of OCV deviation variances $OCV_{slope1}$ of the battery cell 121, corresponding to each of the plurality of points in time, based on the plurality of OCV deviations $OCV_{D1}$ of the battery cell 121, corresponding to each of the plurality of points in time.

According to an embodiment, the plurality of OCV deviation variances may be slopes of the plurality of OCV deviations for each of the plurality of points in time. For example, a kth OCV deviation variance of the battery cell 121 corresponding to a kth point in time may be a value obtained by dividing a value, obtained by subtracting a (k-1)th OCV deviation corresponding to a (k-1)th point in time from a kth OCV deviation corresponding to a kth point in time, by an interval between the kth point in time and the (k-1)th point in time.

However, the slopes of the plurality of OCV deviations may be an example for describing the change degrees of the plurality of OCV deviations, and the plurality of OCV deviation variances disclosed herein are not limited to the slopes of the plurality of OCV deviations. According to an embodiment, the plurality of OCV deviation variances may be differences between the plurality of OCV deviations for each of the plurality of points in time. For example, the kth OCV deviation variance of the battery cell 121 corresponding to the kth point in time may be a value obtained by subtracting the (k-1)th OCV deviation corresponding to the (k-1)th point in time from the kth OCV deviation corresponding to the kth point in time.

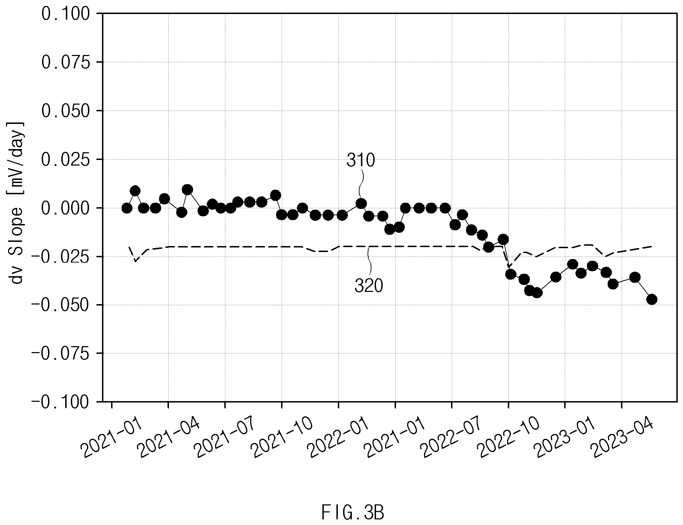

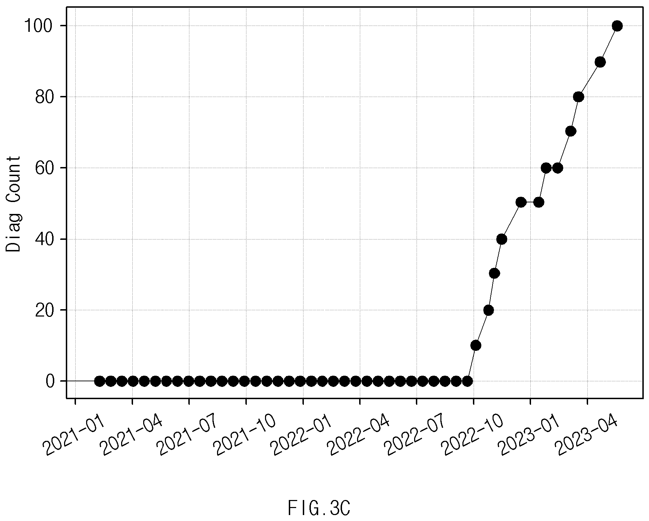

Referring to FIG. 3A, OCV deviations for each of the plurality of points in time for a specific battery cell are shown, and it may be seen that the plurality of OCV deviation variances of the specific battery cell corresponding to the plurality of points in time may be obtained. For reference, FIG. 3A and FIGS. 3B and 3C described later show an OCV deviation having a specific period calculated based on OCV data obtained at specific intervals (e.g., 10 days), and an OCV moving average, an OCV moving average deviation, and an OCV evaluation value, calculated based thereon, in which a horizontal axis indicates a time (day), one scale thereof corresponds to three months, and a vertical axis indicates a voltage (mV). However, for convenience of a description, it is described with reference to FIGS. 3A to 3C that OCV data is obtained at specific intervals, but aperiodic obtaining of the OCV data is not excluded.

According to an embodiment, the second processor 108_2 may transmit the plurality of calculated OCV deviation variances $OCV_{slope1}$, $OCV_{slope2}$, and $OCV_{slope3}$ to the third processor 108_3.

According to an embodiment, the third processor 108_3 may obtain OCV moving averages $OCV_{mv1}$, $OCV_{mv2}$, and $OCV_{mv3}$ by applying a weighted moving average to the plurality of OCV deviation variances $OCV_{slope1}$, $OCV_{slope2}$, and $OCV_{slope3}$. For example, the third processor 108_3 may obtain the OCV moving average $OCV_{mv1}$ by applying the weighted moving average to the plurality of OCV deviation variances $OCV_{slope1}$ of the battery cell 121, corresponding to the plurality of points in time.

For reference, each of the OCV moving averages $OCV_{mv1}$, $OCV_{mv2}$, and $OCV_{mv3}$ may have a value corresponding to each of the plurality of points in time, and OCV moving averages corresponding to two different points in time may be different from each other, but the present disclosure is not limited thereto. For example, an OCV moving average corresponding to two different points in time may have the same value. For example, the OCV moving average corresponding to the first point in time and the OCV moving average corresponding to the second point in time among the OCV moving averages $OCV_{mv1}$ of the battery cell 121 may be the same as or different from each other.

According to an embodiment, the third processor 108_3 may obtain the OCV moving averages $OCV_{mv1}$, $OCV_{mv2}$, and $OCV_{mv3}$ by applying an exponentially weighted moving average to the plurality of OCV deviation variances $OCV_{slope1}$, $OCV_{slope2}$, and $OCV_{slope3}$. For example, the third processor 108_3 may obtain the OCV moving average $OCV_{mv1}$ by applying the exponentially weighted moving average to the plurality of OCV deviation variances $OCV_{slope1}$ of the battery cell 121, corresponding to the plurality of points in time.

When the exponentially weighted moving average is applied, a size of a window (e.g., the number of data to which the exponentially weighted moving average is applied) may be 19, and a weight value applied to the current OCV deviation variance may be 0.1 and a weight value applied to the past exponentially weighted moving average may be 0.9.

According to an embodiment, when the kth OCV deviation variance corresponding to the kth point in time among the plurality of points in time is less than a first threshold OCV deviation variance and the (k-1)th OCV deviation corresponding to the (k-1)th point in time previous to the kth point in time is greater than or equal to a threshold OCV deviation, the third processor 108_3 may change the kth OCV deviation variance into a specific OCV deviation variance and apply the weighted moving average to the plurality of OCV deviation variances including the changed OCV deviation variance (e.g., the specific OCV deviation variance), thereby obtaining the OCV moving average. For example, when a kth OCV deviation variance $OCV_{slope1\_k}$ of the battery cell 121 corresponding to the kth point in time among the plurality of points in time is less than the first threshold OCV deviation variance and a (k-1)th OCV deviation $OCV_{D1\_(k-1)}$ of the battery cell 121 corresponding to the (k-1)th point in time previous to the kth point in time is greater than or equal to the threshold OCV deviation, the third processor 108_3 may change (or update) the kth OCV deviation variance $OCV_{slope1\_k}$ into a specific OCV deviation variance and apply the weighted moving average to the plurality of OCV deviation variances including the changed OCV deviation variance (e.g., the specific OCV deviation variance), thereby obtaining the OCV moving average.

According to an embodiment, the first threshold OCV deviation variance may be set to -0.2, the threshold OCV deviation may be set to 0, and the specific deviation variance may be set to 0. For reference, -0.2, 0, etc., may be examples for helping understanding, but the first threshold OCV deviation variance, the threshold OCV deviation, and the specific OCV deviation variances disclosed herein may not be limited to the foregoing values. At least some of the first threshold OCV deviation variances corresponding to the respective cells may be different from or the same as each other. At least some of the threshold OCV deviations corresponding to the respective cells may be different from or the same as each other. At least some of the specific OCV deviation variances corresponding to the respective cells may be different from or the same as each other. In this way, an over-detection rate that may occur due to the OCV deviation variance having the excessively great absolute value may be reduced.

According to an embodiment, the third processor 108_3 may change some OCV deviation variances less than the second threshold OCV deviation variance, among the plurality of OCV deviation variances $OCV_{slope1}$, $OCV_{slope2}$, and $OCV_{slope3}$, into the second threshold OCV deviation variance, and apply the weighted moving average to the plurality of OCV deviation variances including some OCV deviation variances, thereby obtaining the OCV moving average. For example, the third processor 108_3 may change some OCV deviation variances less than the second threshold OCV deviation variance, among the plurality of OCV deviation variances $OCV_{slope1}$ of the battery cell 121, into the second threshold OCV deviation variance, and apply the weighted moving average to the plurality of OCV deviation variances including some OCV deviation variances, thereby obtaining the OCV moving average corresponding to the battery cell 121.

According to an embodiment, the second threshold OCV deviation variance may be set to -0.7. In this way, an over-detection rate that may occur due to the OCV deviation variance having the excessively great absolute value may be reduced.

According to an embodiment, the third processor 108_3 may transmit the calculated OCV moving averages $OCV_{mv1}$, $OCV_{mv2}$, and $OCV_{mv3}$ to the fourth processor 108_4.

According to an embodiment, the fourth processor 108_4 may diagnose abnormality of the battery cells 121, 122, and 123 based on the OCV moving averages $OCV_{mv1}$, $OCV_{mv2}$, and $OCV_{mv3}$. For example, the fourth processor 108_4 may diagnose abnormality of the battery cell 121 based on the OCV moving average $OCV_{mv1}$ of the battery cell 121.

According to an embodiment, the fourth processor 108_4 may diagnose abnormality of the battery cell based on a result of comparing the OCV moving averages $OCV_{mv1}$, $OCV_{mv2}$, and $OCV_{mv3}$ with a threshold moving average. For example, the fourth processor 108_4 may diagnose abnormality of the battery cell 121 based on a result of comparing the OCV moving average $OCV_{mv1}$ of the battery cell 121 with the threshold moving average.

According to an embodiment, the threshold moving average may be determined such that a product of a first preset value and a standard deviation of OCV moving averages of a specific battery module corresponding to a plurality of points in time may be added by an average of the OCV moving averages of the specific battery module, a result thereof may be compared with a second preset value to select a less value, and the selected value may be compared with a third preset value to determine the greater value as the threshold moving average.

For example, the first preset value may be -6, the second preset value may be -0.02, and the third preset value may be -0.05, but they are examples for helping understanding and the present disclosure is not limited the examples.

Based on a value excluding a maximum value and a minimum value among OCV moving averages of the specific battery module corresponding to the plurality of points in time, the standard deviation and the average may be calculated.

Referring to FIG. 3B, an OCV moving average 310 may be identified, which is a result of applying an exponentially weighted moving average to the OCV deviation variance for each of the plurality of points in time, obtained based on the OCV deviation for each of the plurality of points in time for the specific battery cell of FIG. 3A. A threshold moving average 320 for comparison with the OCV moving average may also be identified.

According to an embodiment, when the OCV moving average $OCV_{mv1}$, $OCV_{mv2}$, and/or $OCV_{mv3}$ is less than the threshold moving average, the fourth processor 108_4 may increase a diagnosis count by a first increment and diagnose abnormality of the battery cell 121, 122, and/or 123 based on a result of comparing the diagnosis count with a threshold count. For example, when the OCV moving average $OCV_{mv1}$ of the first battery cell 121 is less than the threshold moving average, the fourth processor 108_4 may increase a diagnosis count corresponding to the battery cell 121 by the first increment (e.g., 10) and diagnose abnormality of the battery cell 121, 122, and/or 123 based on a result of comparing the increased diagnosis count with the threshold count.

According to an embodiment, when a diagnosis count increase condition is further satisfied in a state where the OCV moving average $OCV_{mv1}$, $OCV_{mv2}$, and/or $OCV_{mv3}$ is less than the threshold moving average, the fourth processor 108_4 may increase the diagnosis count by the first increment. The diagnosis count increase condition for increasing a diagnosis count based on OCV data corresponding to a specific point in time may include (i) when an OCV deviation of a specific battery cell corresponding to the specific point in time is less than an OCV deviation corresponding to an immediately previous point in time and an OCV deviation corresponding to the immediately previous point in time is less than a preset value (e.g., 0), and (ii) the number of OCV deviations of the specific battery cell is greater than or equal to a predetermined number and a data accumulative collection period is greater than or equal to a predetermined period.

In this case, the fourth processor 108_4 may increase the diagnosis count more as the OCV moving average $OCV_{mv1}$, $OCV_{mv2}$, and/or $OCV_{mv3}$ is less than the threshold moving average.

According to an embodiment, based on a degree to which the OCV moving average $OCV_{mv1}$, $OCV_{mv2}$, and/or $OCV_{mv3}$ is less than the threshold moving average, the fourth processor 108_4 may further calculate a second increment, further increase the diagnosis count by the second increment (e.g., 1), and diagnose abnormality of the battery cell 121, 122, and/or 123 based on a result of comparing the increased diagnosis count with the threshold count. For example, based on a degree to which the OCV moving average $OCV_{mv1}$ of the battery cell 121 is less than the threshold moving average, the fourth processor 108_4 may further calculate the second increment, further increase the diagnosis count corresponding to the battery cell 121 by the second increment, and diagnose abnormality of the battery cell 121 based on a result of comparing the increased diagnosis count with the threshold count.

According to an embodiment, the fourth processor 108_4 may reduce the diagnosis count when the OCV moving average $OCV_{mv1}$, $OCV_{mv2}$, and/or $OCV_{mv3}$ is greater than or equal to the threshold moving average. For example, the fourth processor 108_4 may reduce the diagnosis discount value corresponding to the battery cell 121 by a first decrement (e.g., 1) when the OCV moving average $OCV_{mv1}$ corresponding to the battery cell 121 is greater than or equal to the threshold moving average. A lower limit of the diagnosis count may be set to a specific value (e.g., 0).

Referring to FIG. 3C, a result of increasing or reducing the diagnosis count based on a result of comparing the OCV moving average 310, obtained by applying a weighted moving average to an OCV deviation variance of a specific battery cell of FIG. 3B for each of a plurality of points in time, with the threshold moving average 320 may be identified. Referring back to FIG. 3B, it may be seen that the OCV moving average 310 for a specific battery cell has been less than the threshold moving average 320 since October 2022, such that as shown in FIG. 3C, it may be seen that a diagnosis count for the specific battery cell has increased since October 2022.

When a threshold count is 100, the diagnosis count corresponding to the specific battery cell has a value of 100 in April 2023 as shown in FIG. 3C, which means that the diagnosis count corresponding to the specific battery cell is greater than or equal to the threshold count, such that the fourth processor 108_4 may diagnose that abnormality occurs in the specific battery cell.

The first processor 108_1 to the third processor may be implemented with one processor or separate processors. The processor may execute software to control at least another component (e.g., a hardware or software component) of the battery diagnosis apparatus 100 connected to the processor and may process or compute various data.

According to an embodiment, the battery diagnosis apparatus 100 may transmit a battery diagnosis result to outside (e.g., a cloud server or a user terminal). Herein, the cloud server may provide a service for providing a battery diagnosis result to each of a plurality of users. A user terminal may include a terminal such as a PC or a smartphone.

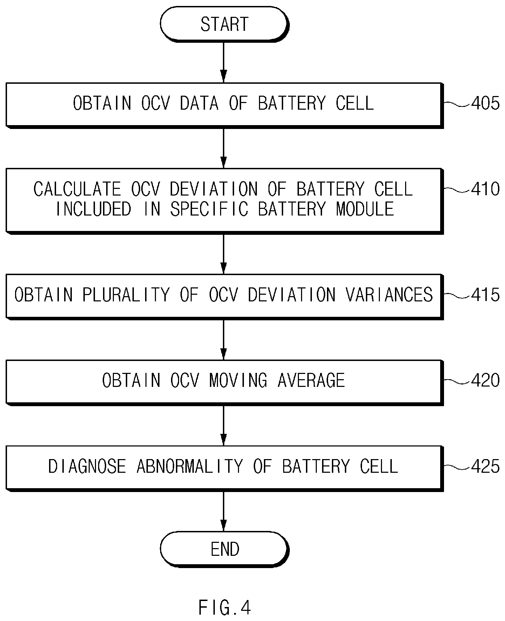

FIG. 4 is an operating flowchart of a battery diagnosis apparatus according to an embodiment. FIG. 4 is intended for a description of an operation of the battery diagnosis apparatus 100 of FIG. 1, and will be described using components of FIG. 1.

An embodiment shown in FIG. 4 is merely an embodiment, and an order of operations according to various embodiments of the present disclosure may be different from that shown in FIG. 4, some operations shown in FIG. 4 may be omitted, or an order of the operations may be changed or operations may be merged.

Referring to FIG. 4, in operation 405, the battery diagnosis apparatus 100 may obtain OCV data of the battery cell 121, 122, 123, 131, 132, 133, 141, 142, and/or 143. For example, the battery diagnosis apparatus 100 may configure the OCV data based on voltage, current, and/or temperature measurement information of the battery cell 121, 122, 123, 131, 132, 133, 141, 142, and/or 143. In another example, the battery diagnosis apparatus 100 may receive the OCV data of the battery cell 121, 122, 123, 131, 132, 133, 141, 142, and/or 143, obtained by the battery module 110, 120, or 130 or the battery cell 121, 122, 123, 131, 132, 133, 141, 142, and/or 143.

In operation 410, the battery diagnosis apparatus 100 may calculate a plurality of OCV deviations indicating a difference between an average OCV corresponding to a plurality of points in time for each of a plurality of battery cells included in a specific battery unit (e.g., a specific battery module) and an OCV of a battery cell, based on the OCV data obtained in operation 405. According to an embodiment, the battery diagnosis apparatus 100 may extract OCV data in a designated voltage range (e.g., a voltage range of 3.9 V or greater) from the OCV data. The battery diagnosis apparatus 100 may calculate the plurality of OCV deviations based on the extracted OCV data in the designated voltage range.

In operation 415, the battery diagnosis apparatus 100 may obtain a plurality of OCV deviation variances based on the plurality of OCV deviations.

In operation 420, the battery diagnosis apparatus 100 may obtain an OCV moving average by applying a weighted moving average to the plurality of OCV deviation variances. Herein, the plurality of OCV moving averages may corresponding to a battery cell. According to an embodiment, when the kth OCV deviation variance corresponding to the kth point in time among the plurality of points in time is less than a first threshold OCV deviation variance and the (k-1)th OCV deviation corresponding to the (k-1)th point in time previous to the kth point in time is greater than or equal to a threshold OCV deviation, the battery diagnosis apparatus 100 may change the kth OCV deviation variance into a specific OCV deviation variance and apply the weighted moving average to the plurality of OCV deviation variances including the specific OCV deviation variance, thereby obtaining the OCV moving average. According to an embodiment, the battery diagnosis apparatus 100 may change some OCV deviation variances less than a second threshold OCV deviation variance among the plurality of OCV deviation variances into a second threshold OCV deviation variance and apply the weighted moving average to the plurality of OCV deviation variances including the some OCV deviation variances to obtain the OCV moving average. According to an embodiment, the battery diagnosis apparatus 100 may apply an exponentially weighted moving average to the plurality of OCV deviation variances to obtain the OCV moving average.

In operation 425, the battery diagnosis apparatus 100 may diagnose abnormality of the battery cell based on the OCV moving average. According to an embodiment, the battery diagnosis apparatus 100 may diagnose abnormality of the battery cell based on a result of comparing the OCV moving average with a threshold moving average. According to an embodiment, when the OCV moving average is less than the threshold moving average, the battery diagnosis apparatus 100 may increase a diagnosis count by a first increment and diagnose abnormality of the battery cell based on a result of comparing the diagnosis count with a threshold count. According to an embodiment, the battery diagnosis apparatus 100 may calculate a second increment based on a degree to which the OCV moving average is less than the threshold moving average, further increase the diagnosis count by a second increment, and diagnose abnormality of the battery cell based on a result of comparing the diagnosis count with the threshold count. According to an embodiment, the battery diagnosis apparatus 100 may reduce the diagnosis count when the OCV moving average is greater than or equal to the threshold moving average.

Detecting potential battery fires is crucial for ensuring the safety and longevity of battery systems. The present disclosure provides a method that involves monitoring the rate of change of the Open Circuit Voltage (OCV) difference between an individual battery cell and the average OCV of a group of cells including the individual cell itself. By analyzing this difference over time, abnormal behaviors that may indicate internal failures, overcharging, or early signs of thermal runaway can be identified before they escalate into hazardous conditions.

The detection method begins by calculating the OCV difference for each cell. This difference, denoted as $\Delta V_i$, is obtained by subtracting the average OCV ($V_{avg}$) of a set of battery cells from the OCV of an individual cell ($V_i$). Tracking how $\Delta V_i$ changes over time provides insights into the relative performance and stability of each cell within the system. A significant deviation from the expected range could signal potential issues such as imbalance, degradation, or an emerging failure. To enhance detection accuracy, the rate of change of the OCV difference, represented as $d(\Delta V_i)/dt$, is monitored. A rapidly increasing or irregular trend in this rate suggests that a cell is behaving abnormally compared to its peers. Such deviations can indicate internal shorts, excessive self-discharge, or other fault conditions that may lead to overheating and, in extreme cases, a battery fire.

For robust fault detection, the analysis may be conducted over at least two different time durations: a long-term and a short-term period. The long-term trend, which may span months, helps identify gradual degradation effects such as capacity loss, lithium plating, or persistent imbalances between cells due to aging. On the other hand, the short-term trend, which may be measured over days or weeks, detects more immediate and unexpected changes, which may be indicative of safety risks such as internal shorts, abnormal self-discharge, or localized thermal issues. By combining at least two different timescales, the system can distinguish between normal wear-and-tear and sudden, potentially dangerous failures.

A threshold-based approach is employed to trigger warnings or protective actions. If the rate of change of the OCV difference exceeds a predetermined threshold within either the short-term or long-term monitoring window, an alert may be raised, prompting further investigation or preventive measures such as cell isolation or system shutdown. This method improves early fault detection, reducing the likelihood of catastrophic failures while maintaining the overall health and reliability of the battery system.

Batteries are a crucial component in electronic devices, providing the power necessary for the electronic devices to operate and perform their functions. While batteries offer several benefits, they also present challenges. One of the main risks associated with them is the potential for fire, which can result from the chemical and electrical processes occurring within the battery cells. Various factors, such as thermal runaway, overcharging, short circuits, overheating, and battery aging, can trigger these hazardous conditions. In the event of a fire, the safety of the device and its systems may be severely compromised.

Given the crucial role of the batteries in electronic devices, ensuring its safety is paramount. As such, the electronic devices may be equipped with some kind of battery monitoring and/or diagnostic devices designed to detect potential fire risks within the battery packs.

As shown in the non-limiting example illustrated in FIG. 1, the electronic device includes a battery apparatus 102 and a Battery Management System (BMS) 104 that communicates with the battery apparatus 102 to ensure the battery pack is functioning safely.

The battery apparatus 102 may include several battery modules 110, 120, 130, and others and may be in constant communication with the BMS 104. The "battery apparatus" may be any device or equipment that involves batteries or parts of batteries. For example, the battery apparatus may be a battery pack, battery unit, battery cell, battery system, battery assembly, battery module, power pack, energy pack, or energy storage unit, etc. In the example illustrated in FIG. 1, the battery apparatus 102 is a battery pack including several battery modules, and each battery module includes one or more battery cells that are connected together to meet certain power needs. In some instances, each battery cell may also be referred to as a battery apparatus.

As shown in FIG. 1, each battery module (like 110, 120, and 130) has several individual battery cells (for example, 112, 114, 116, 132, 134, 136, etc.). The number of battery modules and cells in a pack can be different depending on what the device needs. A battery pack might have one, two, three or more battery modules, and each battery module may include one, two, three, or more cells based on the design of the device. Each individual battery cell may be made up of several important parts, such as cathode, anode, separator, electrolyte, and battery case.

The BMS 104 monitors the battery apparatus' performance. As illustrated in FIG. 1, the BMS 104 may include an interface 106 and a processor 108, designed to receive and process important data for the battery. The BMS monitors several key parameters such as the state of charge (SOC), voltage, Open-Circuit Voltage (OCV), current, and temperature of the battery. This data is vital for maintaining the health of the battery, enhancing its safety, and ensuring optimal energy management. The BMS 104 can be integrated directly into the battery and/or manage it remotely. It gathers data that provides information regarding the battery's performance and safety. By using one or more processors, the BMS can control different components, perform calculations, and transmit diagnostic results to external devices like cloud servers or user terminals for further analysis. The BMS 104 monitors and evaluates the battery pack's status either directly or indirectly. In some embodiments, the BMS 104 identifies any abnormalities within the battery pack 102 by analyzing OCV data obtained from the battery unit. When irregularities are detected, the BMS 104 can trigger an alarm, which may include visual, audio, and/or haptic notifications. The term "battery unit" refers to components such as the battery pack, individual battery modules, and battery cells. In some cases, the BMS 104 may be integrated within the battery unit itself as part of a larger system. Alternatively, the BMS 104 can operate separately from the battery unit, functioning as an external server connected via a wireless network.

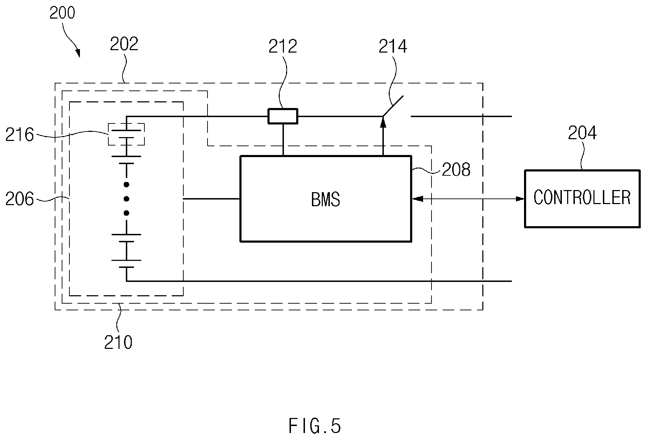

FIG. 5 illustrates another example of an electronic device 200 that includes a battery system 202 and a controller 204, which work in harmony to ensure efficient functionality and safety. The controller, also called the electronic control unit (ECU) or module (ECM), acts like the brain of the device. It can be used to manage and coordinate all the components inside an electronic device. It may communicate directly with the battery system 202 to control how the power flows, making sure the device gets the right amount of energy when needed. The battery system 202 may include a battery module 206, a Battery Management System (BMS) 208, a sensor unit 212, and a switching unit 214, which work together to keep the device running smoothly. In some instance, the electronic device 200 may include multiple battery modules 206, sensor units 212, switching units 214, and BMS 208.

The BMS 208 shown here may be the same as or different than the BMS 104 shown in FIG. 1, and the battery module 206 may be the same as or different from the battery modules 110, 120, or 130 in FIG. 1.

The sensor unit 212 may be equipped with various sensors, such as current sensors, voltage sensors, and temperature sensors, each responsible for monitoring different aspects of the battery's performance. The current sensors measure the flow of electricity into and out of the battery during both charging and discharging cycles. These sensors may take measurements at regular intervals, such as during charging (when the battery is being replenished with power) and discharging (when the battery is powering the device), and can measure each datapoint at a single measurement timeframe. The data collected is sent to the BMS for analysis, providing critical real-time information on the battery's performance. Voltage sensors, placed in parallel with the battery, monitor the voltage across the battery terminals. The voltage sensor generates a voltage signal, which represents the battery's voltage level. This information may be crucial for ensuring the battery's proper functioning and safety, as any significant changes in voltage can indicate potential issues that need to be addressed. These sensors provide comprehensive data that allows the BMS to effectively monitor and/or manage the battery's health and performance, ensuring safe and efficient operation.

The switching unit 214 may be connected to the battery module 206 at either the positive (+) or negative (-) terminal. The switching unit 214 controls the flow of charge and discharge currents within the battery system. The BMS 208 manages the ON/OFF operation of the switching unit 214, which may be implemented as a relay or contactor. The switching unit 214 may be integrated with the battery module 206, allowing the BMS to monitor the battery's performance. By controlling the switching unit 214, the BMS 208 can regulate the current flow during both charging and discharging cycles, ensuring that the battery operates optimally and safely. This setup enables the BMS to accurately measure the OCV of each individual battery cell. These precise measurements are essential for evaluating potential fire risks and identifying abnormal conditions, such as short circuits or internal failures.

The OCV is measured between the two terminals (the positive and negative ends) of a battery. The OCV indicates how much charge is left in the battery and whether the battery is in good shape. How OCV changes over time can indicate problems of the battery, such as short circuit or aging of the battery. For devices like electric cars (EVs) or portable electronics, keeping track of battery health is important because it affects how well the device works and how safe it is to use. In the electronic device illustrated in FIG. 2, the BMS 208 obtains OCV data directly from the battery cells 216. The sensor unit 212 measures important parameters, including the OCV data. The sensor unit 212 may also include communication circuits, which send the data to the BMS 208, through wires or wirelessly.

The OCV drops within individual battery cells may be observed with time. By comparing the OCV drop of a single cell with the average OCV drop across a battery apparatus including this single cell over a relatively short duration of time, it is possible to identify abnormal drops that are sharp and/or sudden, indicating potential underlying issues of the battery apparatus, such as short circuits or battery failures. These abnormal voltage drops are key indicators of potential fire hazards. They can be closely monitored, allowing early detection of problems that could compromise safety. This proactive approach may help prevent catastrophic events and enhance the overall reliability of the battery system.

Investigations into fire incidents have shown that long-term monitoring, which captures more gradual, gentle OCV declines, can also reveal early warning signs of fire risks. A slow or moderate decrease in voltage over time may not trigger alarms in a short-term OCV monitoring system but could still indicate underlying issues that could eventually lead to fire.

This disclosure provides a method that combines two types of OCV drops--steep, short-term drops and more gradual, long-term declines--to identify fire risks. By paying attention to the combination of voltage changes, the method provided herein offers an effective approach for early battery fire risk detection, catching both immediate threats and subtle risks, making the battery apparatus safer and more reliable.

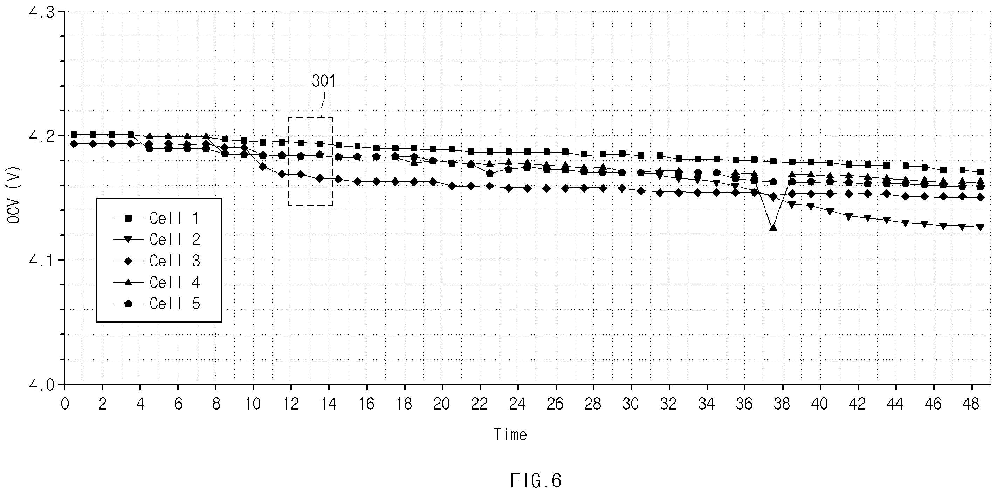

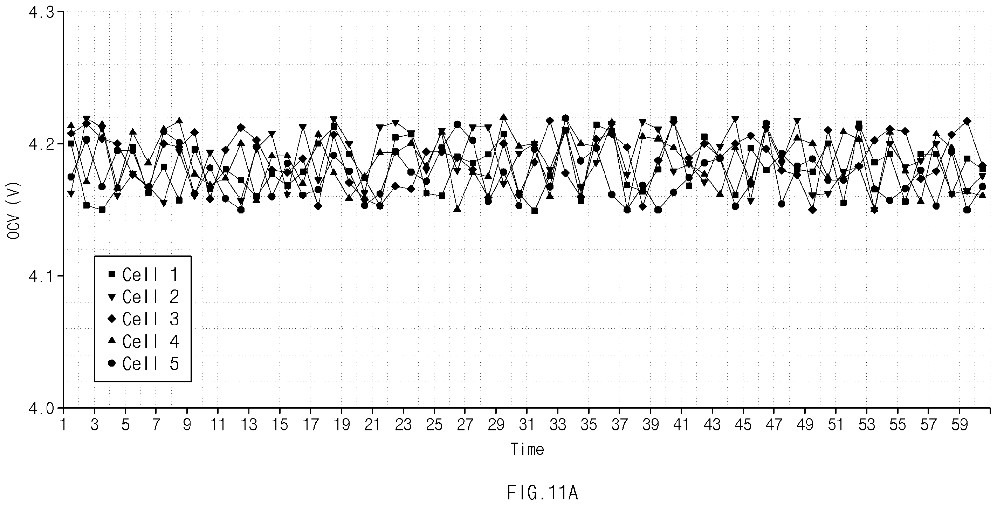

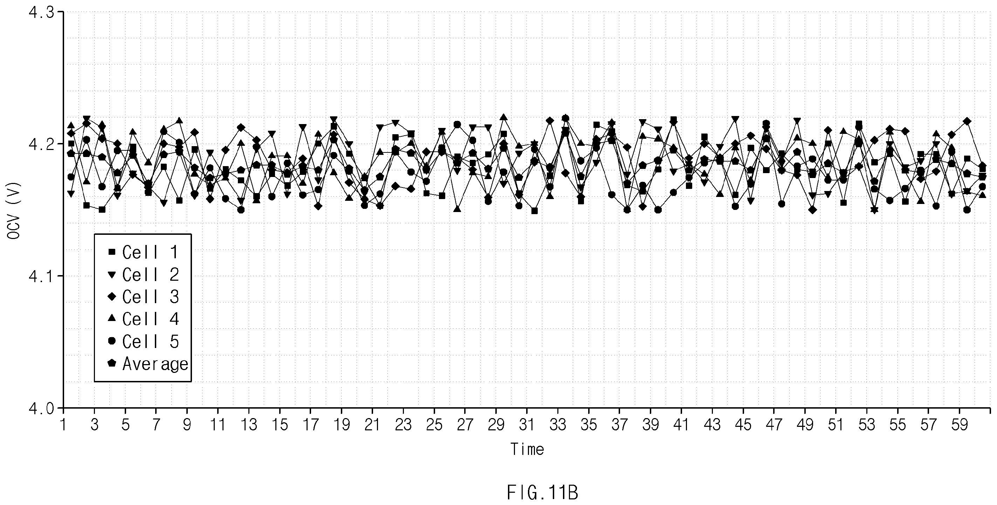

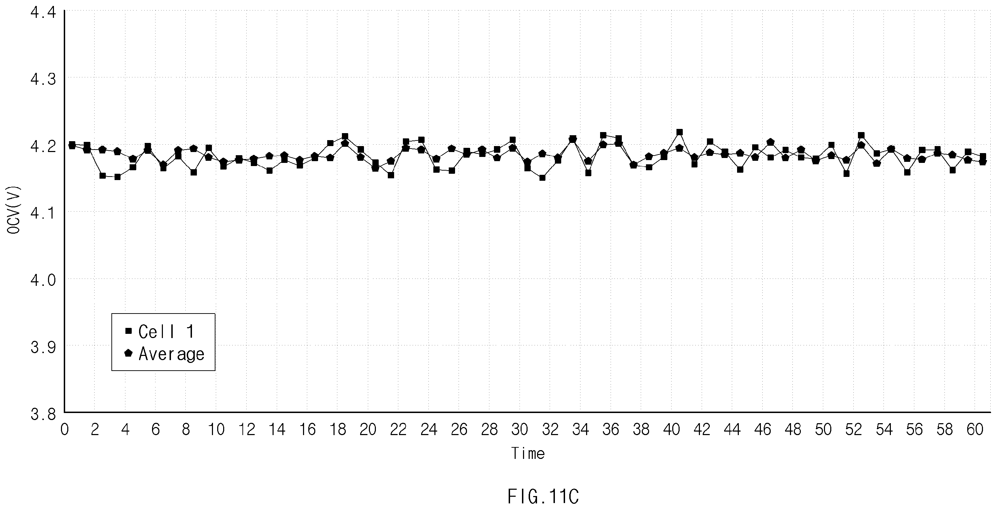

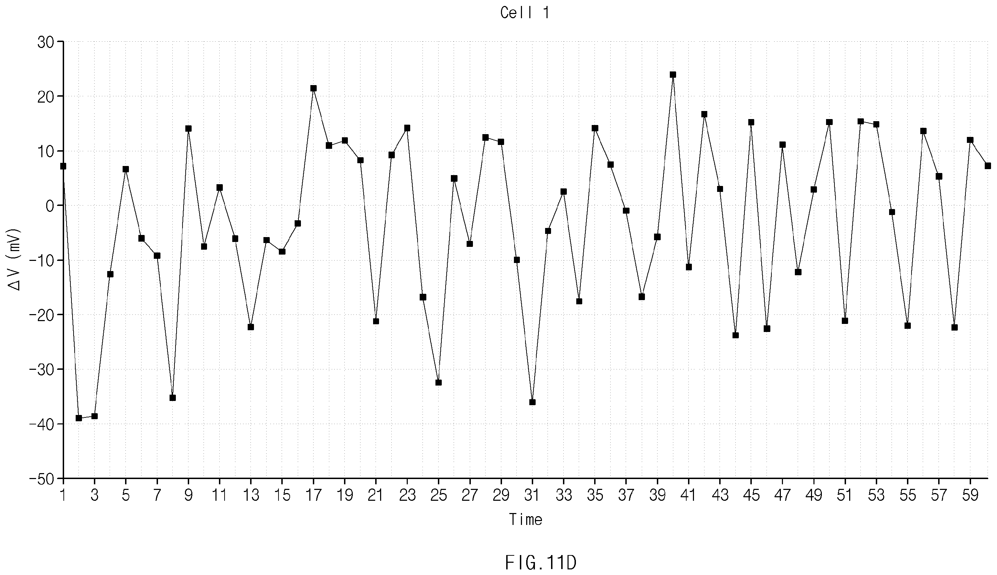

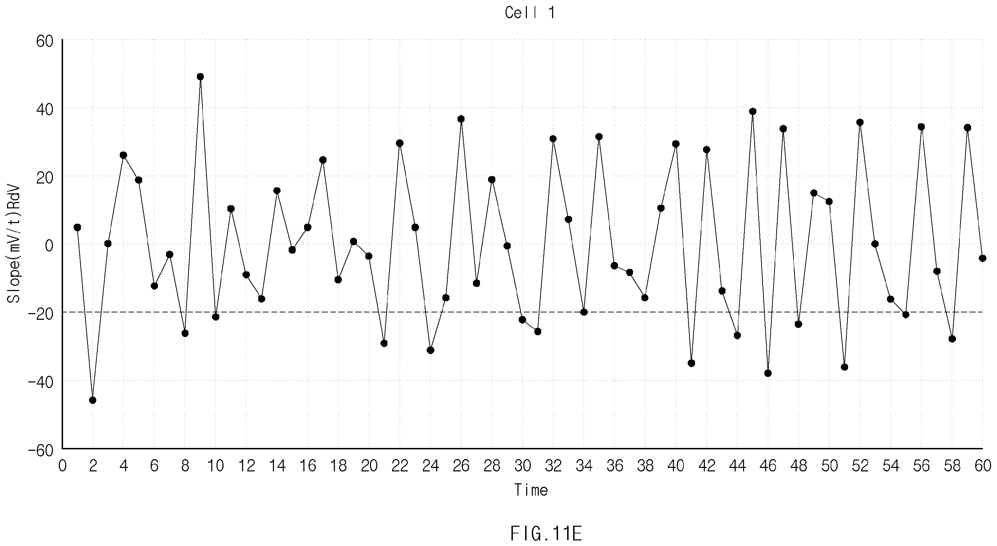

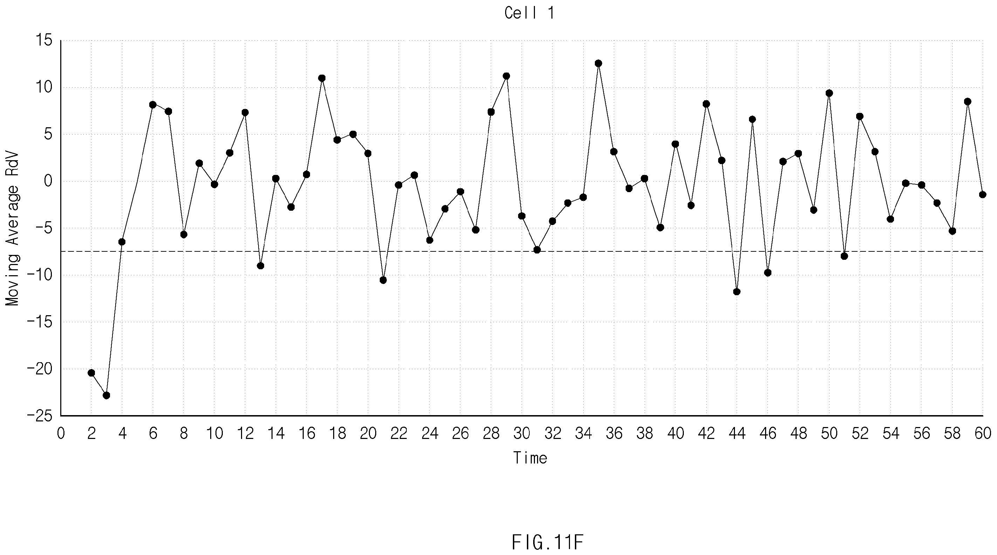

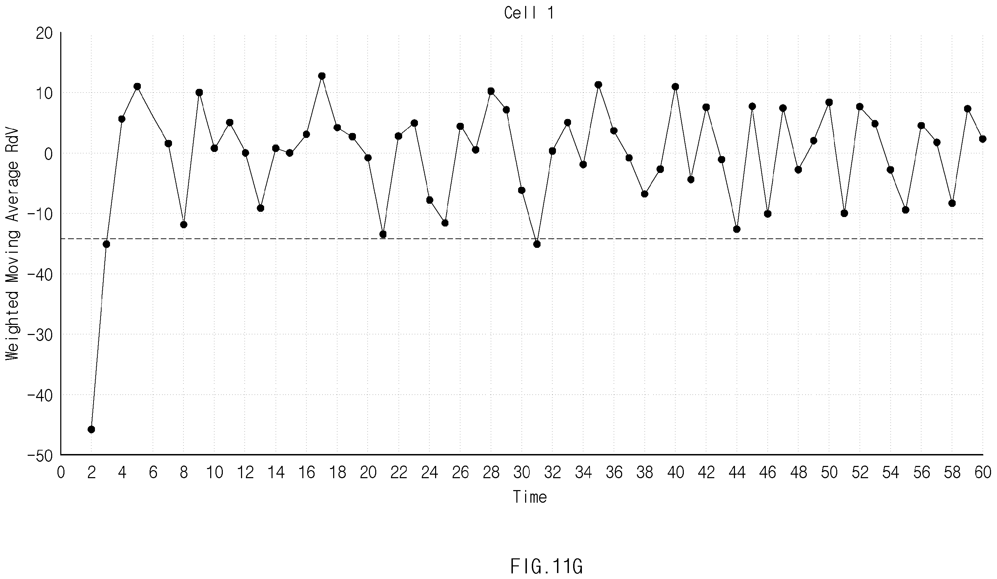

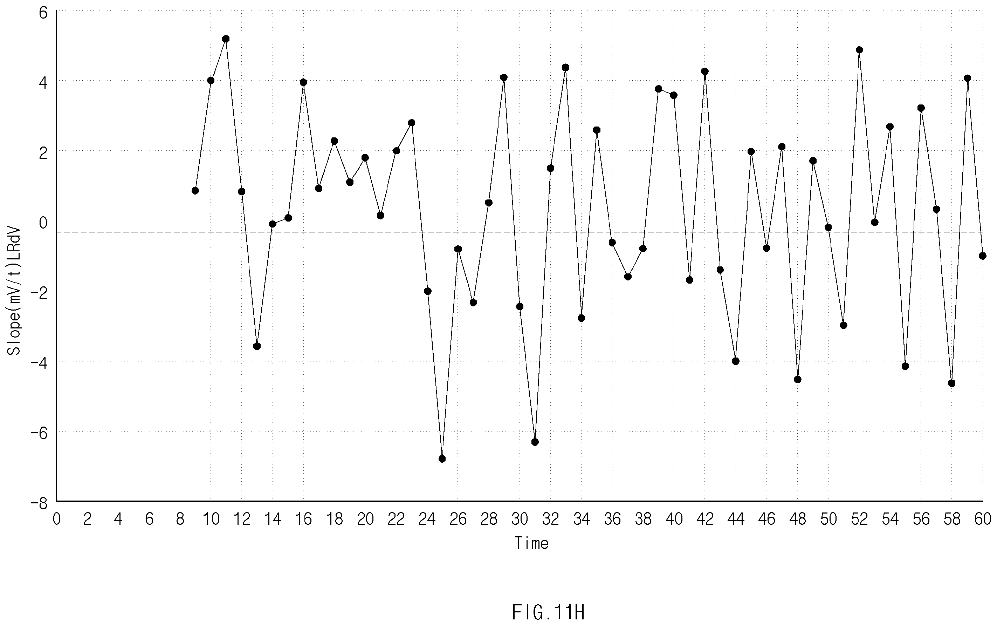

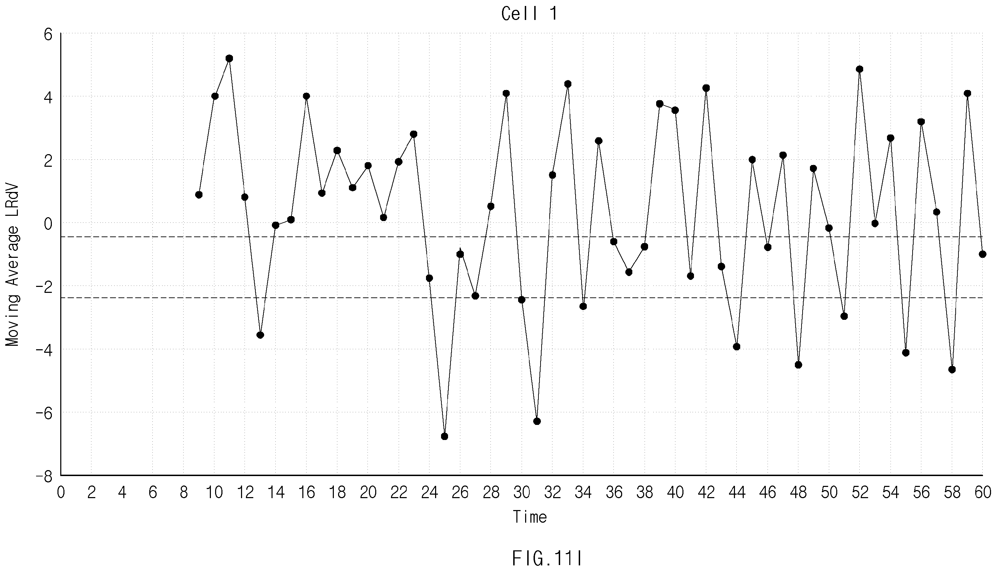

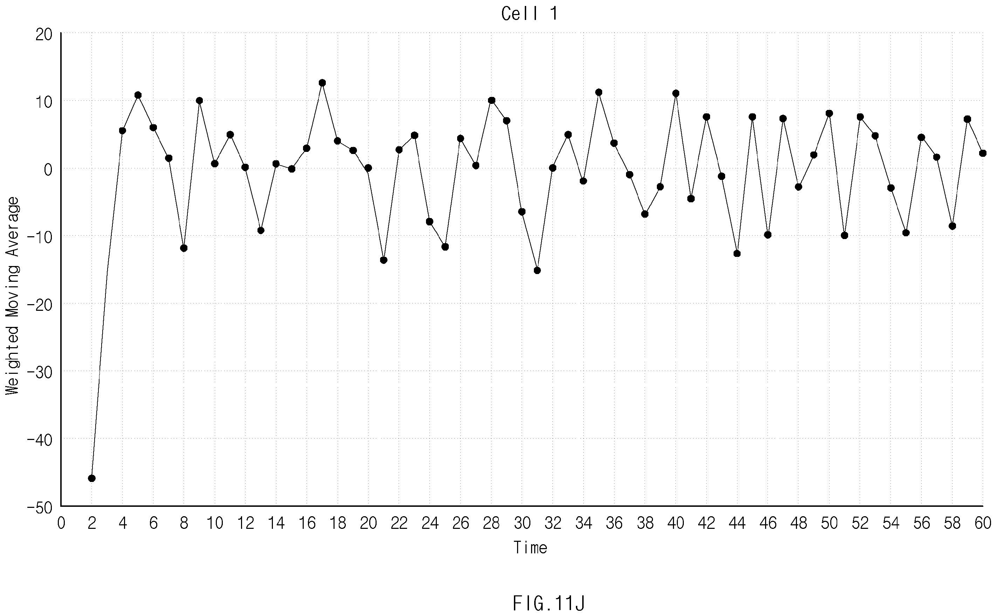

In FIGS. 6-11J, example OCV values of five example battery cells in one example battery module are measured. As mentioned earlier, the OCV tends to go down over time. In these examples, the measurements are repeatedly taken over a period of 48 units, which can be months in some embodiments, to provide multiple sets of voltages for the plurality of battery cells. This time frame is just an example for illustration and can be shorter or longer. The measurements may be taken once a month, and it can be on the first day, the second day, the last day of the month, or any other day of the month. The measurement can be taken on the same day each month and/or on different days in different months. The frequency of the measurements can vary. Instead of once a month, the measurements can be taken more often or less often, such as once every two months, once every three months, twice a month, three times a month, once a week, once every hour (or every 2 hours, every 3 hours, etc.), daily (or every other day, every 3 days, etc.), weekly (or every other week, every 3 weeks, etc.), or at any other frequency. For example, FIGS. 11A-11J show measurements taken more frequently than those shown in FIGS. 6-10P, such as daily or hourly, which illustrate how taking measurements more often can be helpful and used in real life.

FIG. 6 shows OCV data measured from the battery cells inside a battery module. These measurements are taken at regular intervals, such as daily, weekly, or monthly, over a duration of time units, which can be months, weeks, or days, etc. Each battery cell is measured multiple times at each interval. In one embodiment, measurements are taken once a month over a span of 48 months. These measurements may occur on the first day of the month, the last day of a previous month, or any other selected day. The OCV values, or the power levels of the battery, are plotted on the vertical axis, with time on the horizontal axis. This figure shows that these example battery cells may initially lose power at a similar rate, but over time, their behaviors may start to differ. For example, cell 2 has the largest OCV drops as time goes by after 38 months, and cell 4 shows a noticeable large drop in power after about 37 months. The other cells, on the other hand, have slower and steadier drops over the whole 48 months. Further detailed data, with measurements taken more frequently, can be seen in FIG. 11A through FIG. 11J, which will be described in detail later.

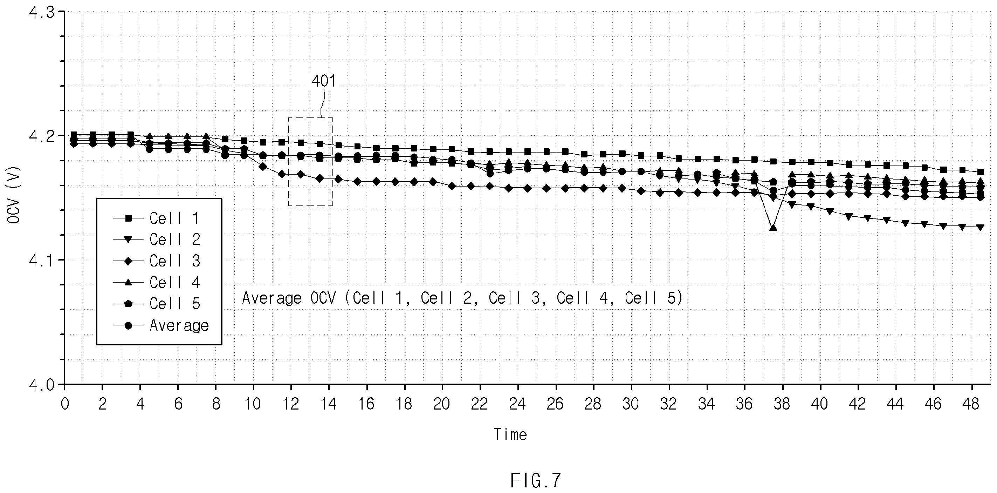

The measurements from the five cells are taken multiple times and then averaged at each measurement timeframe to create multiple composite voltages for the corresponding measurement points. This average value is shown in FIG. 7. The average serves as a reference to compare the power levels of each cell, making it easier to spot any unusual changes in the cells' performance.

SHORT-TERM VOLTAGE DROP ANALYSIS (RdV)

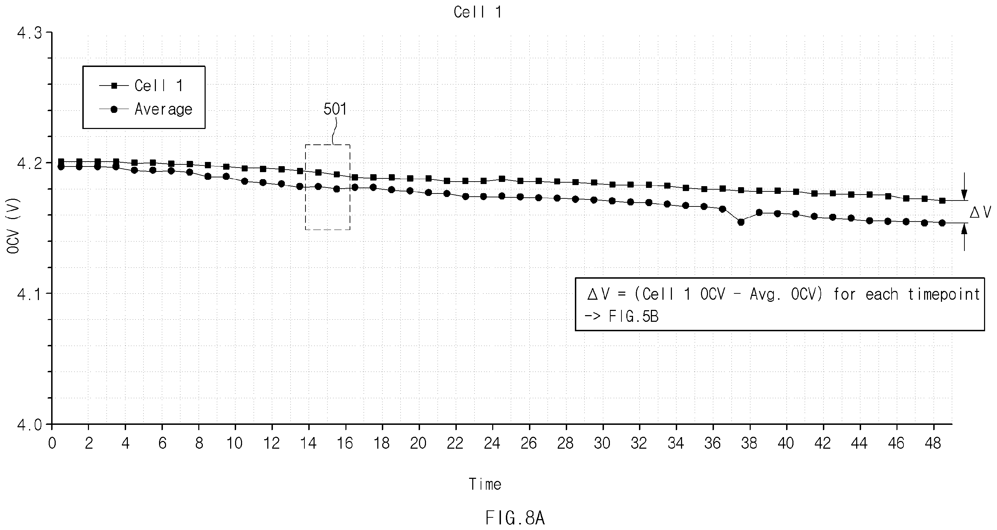

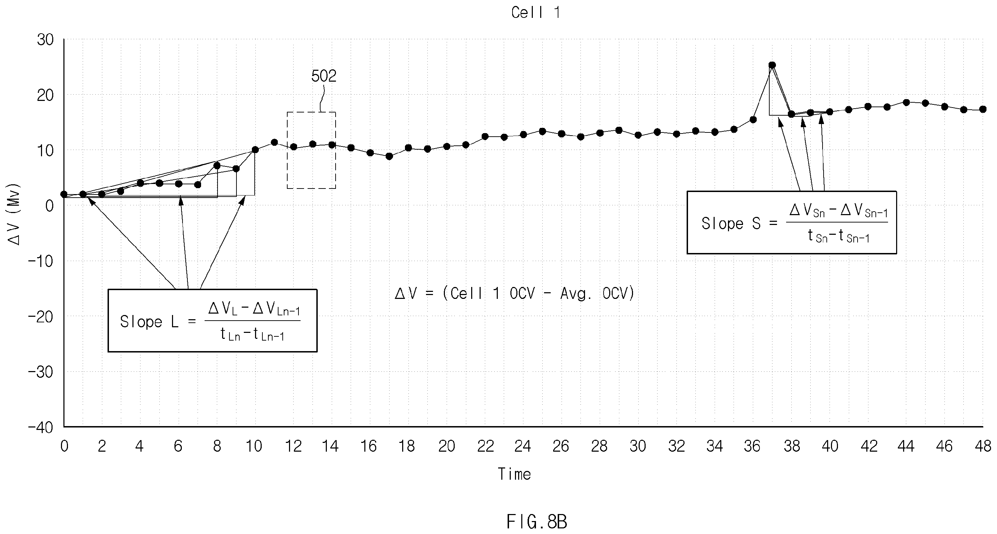

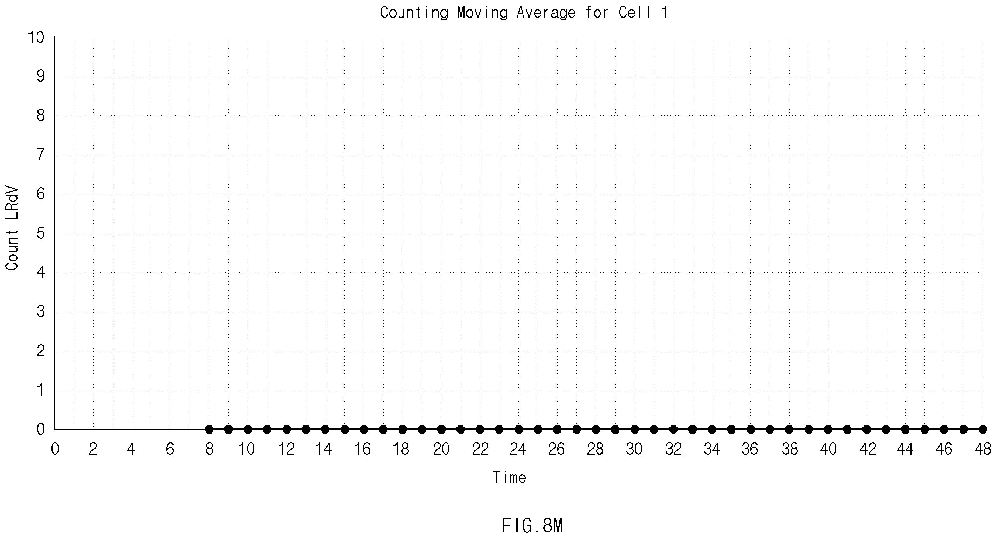

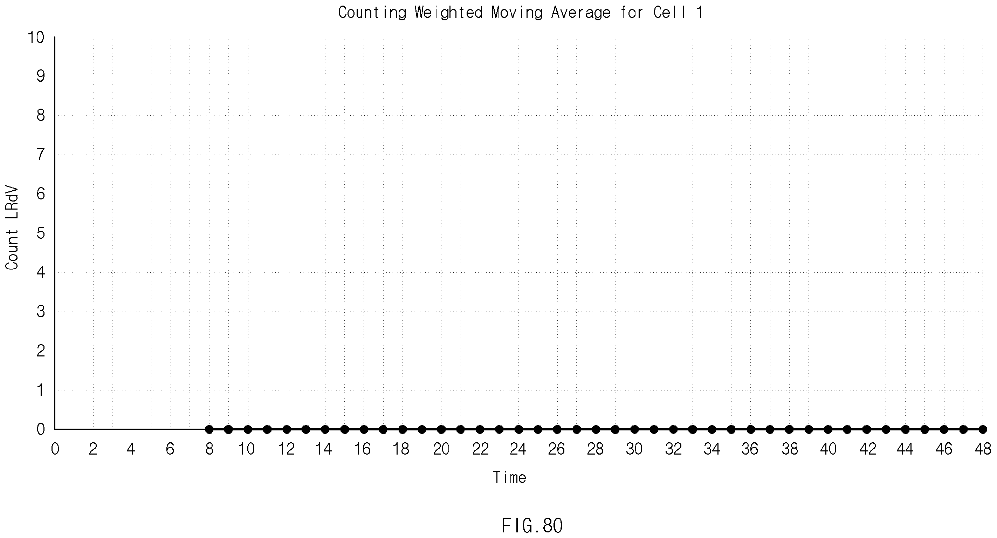

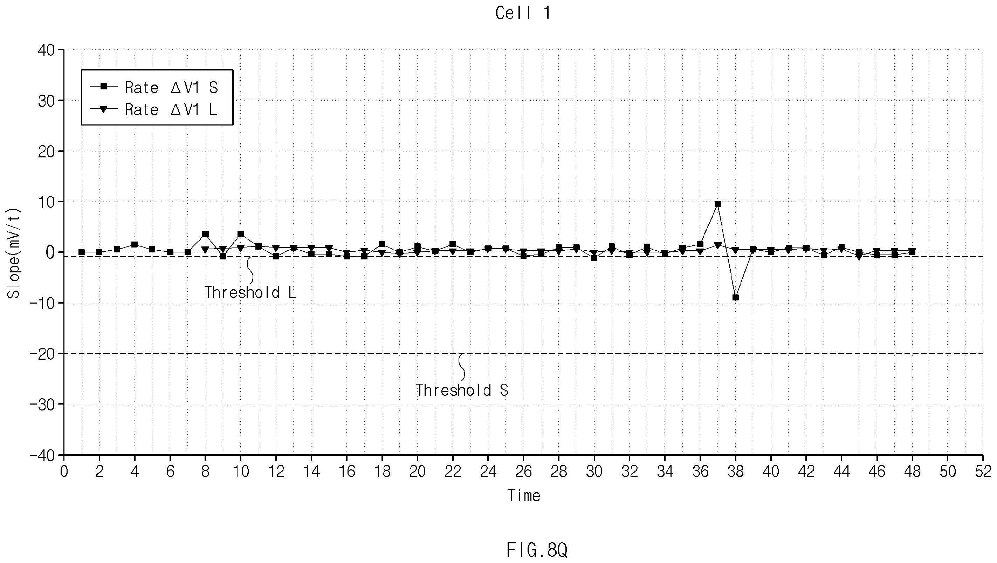

The process for detecting quick voltage drops involves looking at how the voltage of each battery cell compares to the average voltage of all the cells. FIG. 8A shows the OCV values of an individual cell (cell 1) and the average OCV values of all five cells over time. FIG. 8B shows the differences between the power levels of cell 1 and the average power levels of all five cells at each measurement time point, shown in FIG. 8A. At each time point when the OCV values of the cells are measured, the difference between cell 1's OCV and the average OCV of all cells is calculated as $\Delta V$ = OCV for cell 1- Avg. OCV. These $\Delta V$ values are plotted against the time units in FIG. 8B. For example, in FIG. 8A, at time point 18, the OCV for cell 1 is 4.189 V, and the average OCV for all cells is 4.1788 V. Thus, at time point 18, the $\Delta V$ is 10.2 mV, and the $\Delta V$ and time units are plotted in FIG. 8B. As another example, at time point 48, the OCV for cell 1 is 4.171 V, and the average OCV for all cells is 4.1536 V. Thus, at time point 48, the $\Delta V$ is 17.4 mV, and the $\Delta V$ and time units

are plotted in FIG. 8B. Then, the rate of change (e.g., voltage decrease) in the OCV difference, $\Delta V$, or the "slope" of the change in the difference over a predetermined length of time, is calculated. An example Slope S (for the shorter term/duration measurement) is determined by calculating the change in the difference between month 37 and month 38, month 38 and month 39, and so on, over a 1-month duration of time. For example, in FIG. 8B, at 37 time units (e.g., 37 months), the $\Delta V$ value is 25 mV, and at 38 time units (e.g., 38 months), the $\Delta V$ value is 16.4 mV. Thus, the Slope S for 37 to 38 time units is calculated by dividing the change in $\Delta V$ by the 1 time unit, i.e., -8.6 mV, which indicates the rate of change in the $\Delta V$ value over the duration of time from 37 time units to 38 time units (e.g., 1-month duration of time). Slope L (for the longer term/duration measurement) is calculated by looking at the change between month 0 and month 8, month 2 and month 9, month 3 and month 10, and so on, over an 8 or 7-month duration of time. For instance, in FIG. 8B, at 3 time units (e.g., 3 months), the $\Delta V$ value is 2.4 mV, and at 11 time units (e.g., 11 months), the $\Delta V$ value is 11.2. Thus, the Slope L for 3 to 11 time units is calculated by dividing the change in $\Delta V$ by the 8 time units, i.e., 1.1, which indicates the rate of change in the $\Delta V$ value over the duration of time from 3 time units to 11 time units (e.g., 8-month duration of time). If the slope of the change in difference is steep, meaning the difference is changing quickly, it can be considered an anomaly. This helps identify rapid voltage drops that might suggest problems, like overheating, damage, or other issues in the battery module.

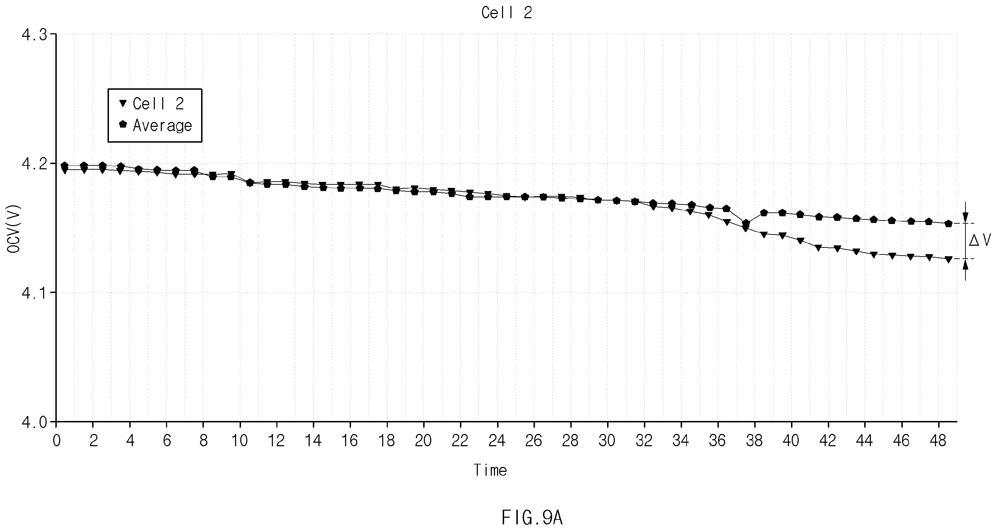

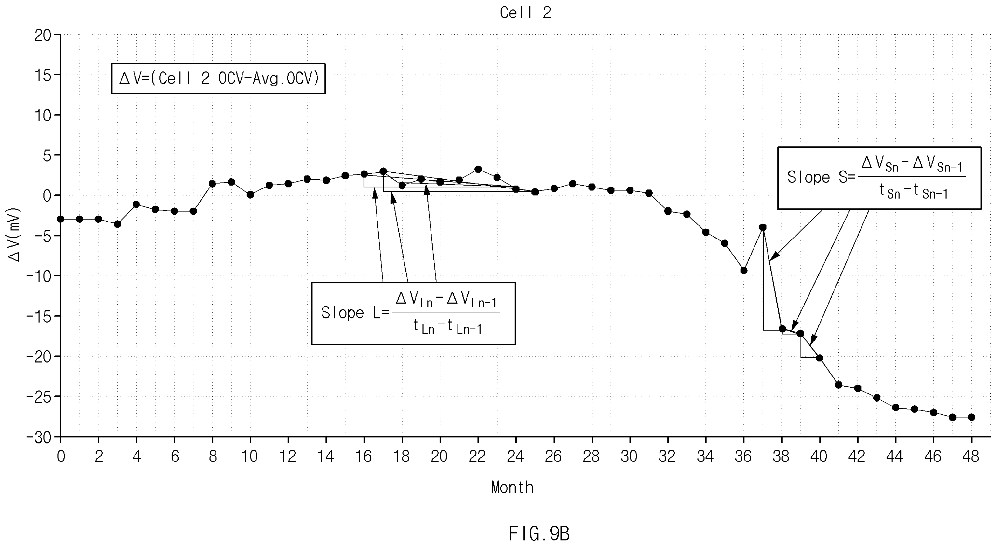

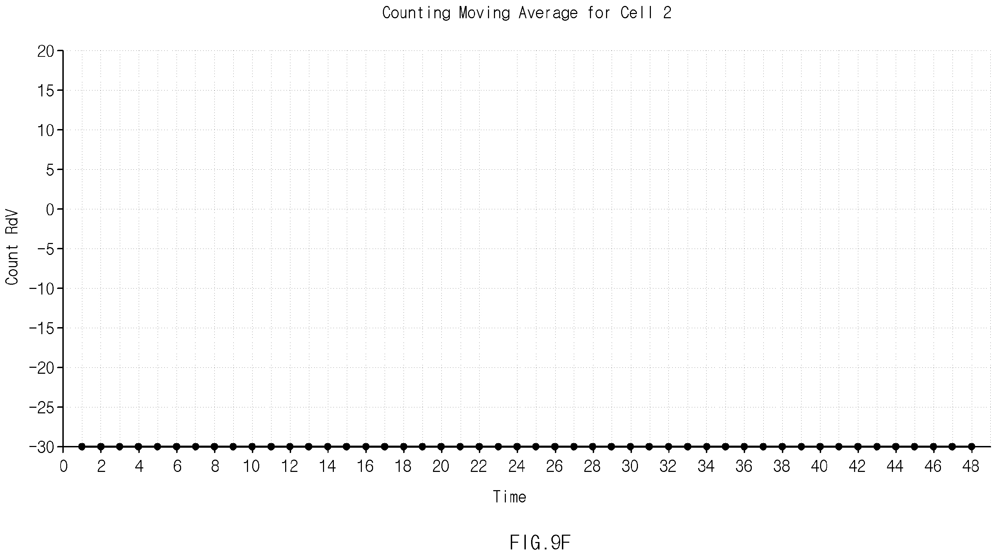

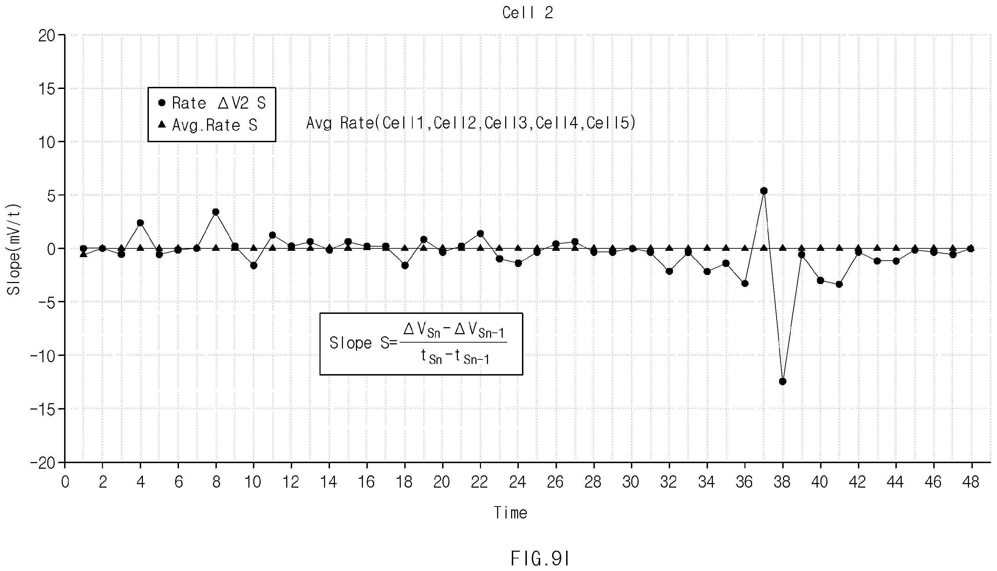

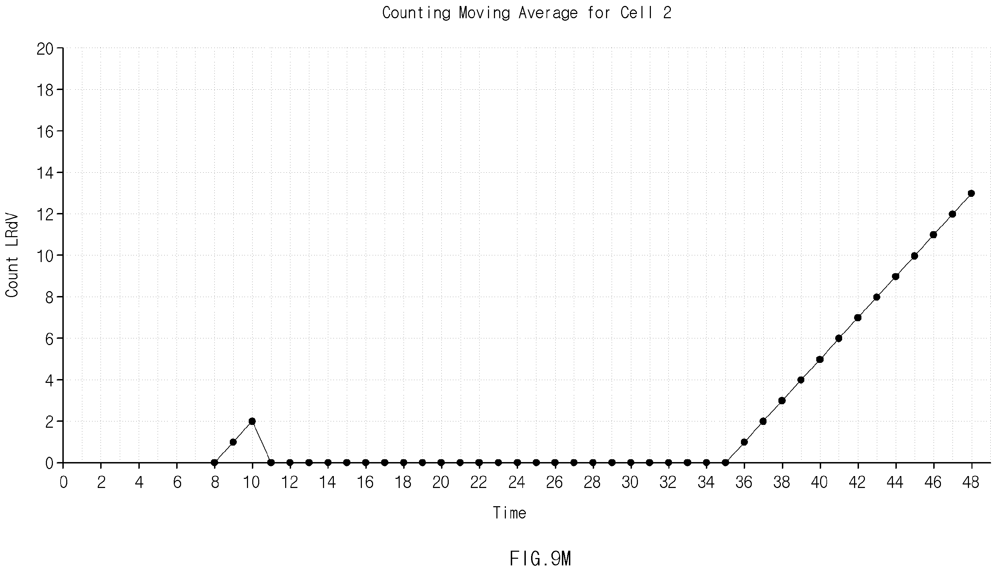

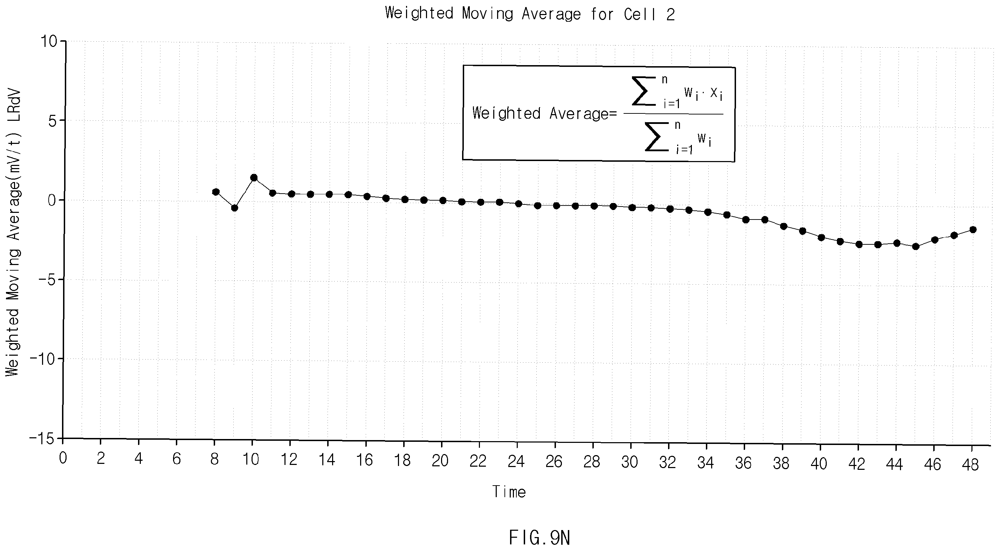

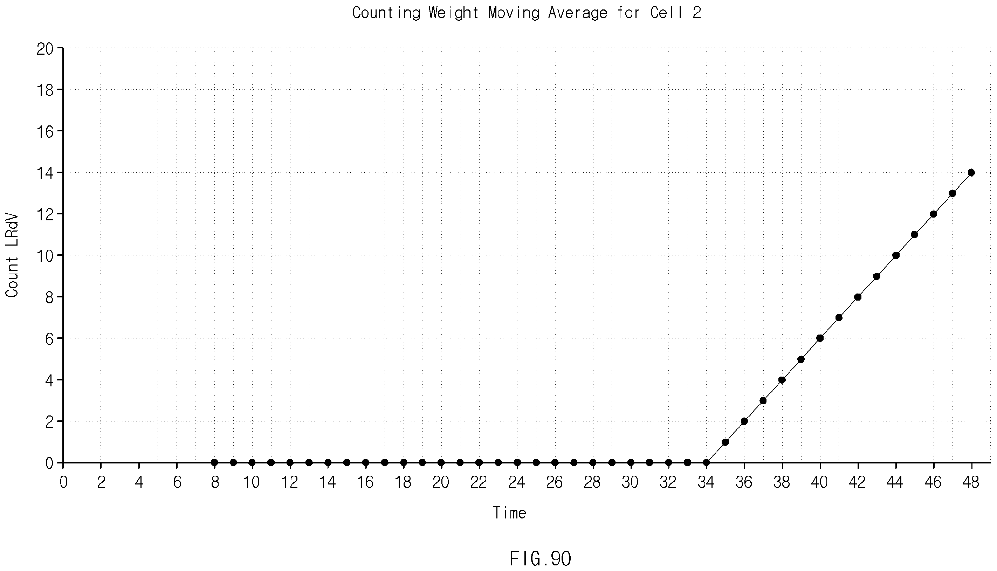

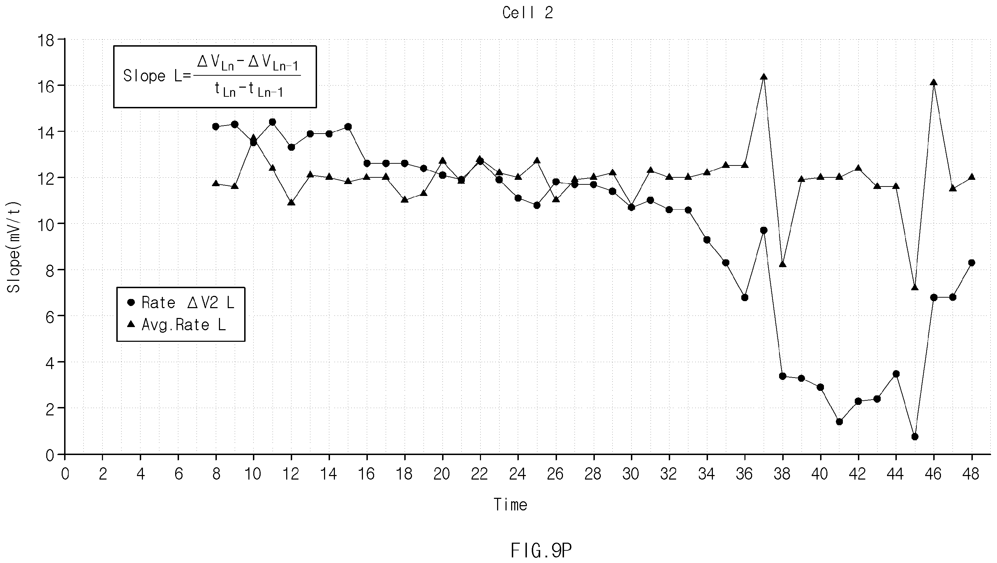

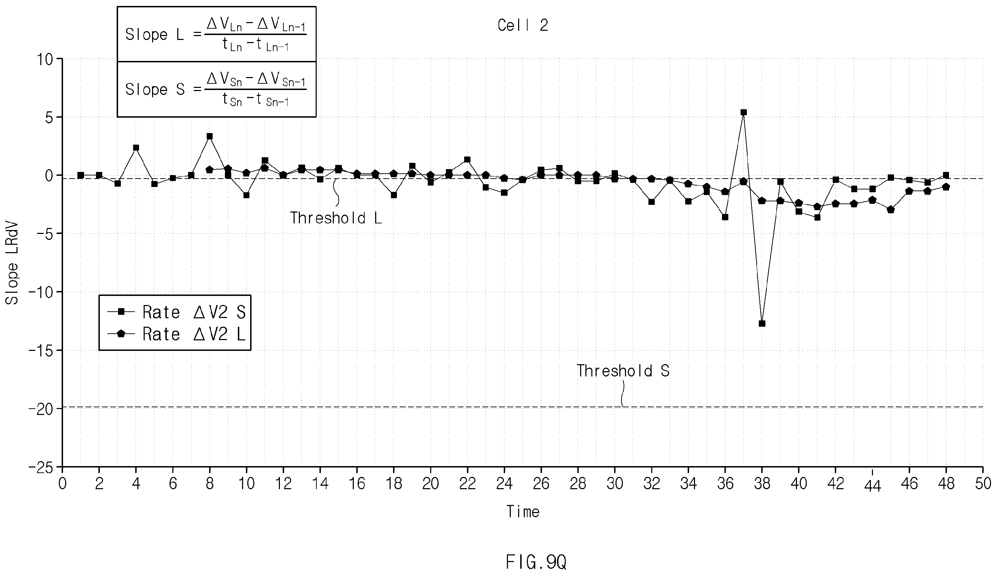

Similarly, FIG. 9A illustrates a comparison between cell 2 OCV values And the average OCV values of the five cells, and FIG. 9B shows the differential values ($\Delta V$ = OCV for cell 2 - Avg. OCV) between the OCV values of cell 2 and the average OCV values of five cells at each measurement time point in FIG. 9A. These two graphs are similar to FIGS. 8A and 8B, respectively, but for cell 2, and therefore, the detailed description is omitted herein. In addition, similar to the slope calculation described for battery cell 1, an example Slope L is determined by the change in $\Delta V$ between month 16 and month 24, over an 8-month duration of time, and an example Slope S is determined by the change in $\Delta V$ between month 37 to month 38, over a 1-month duration of time.

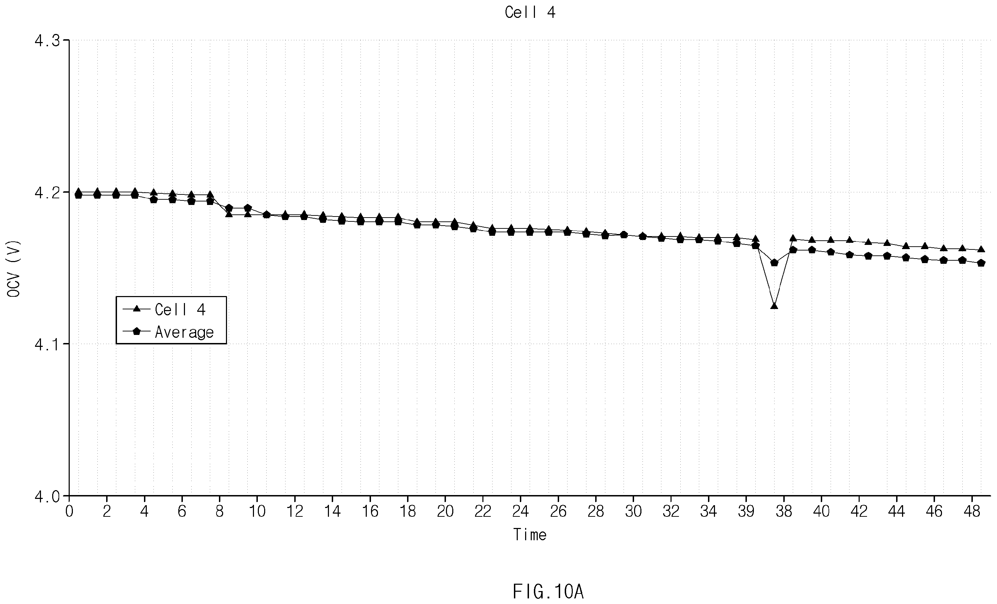

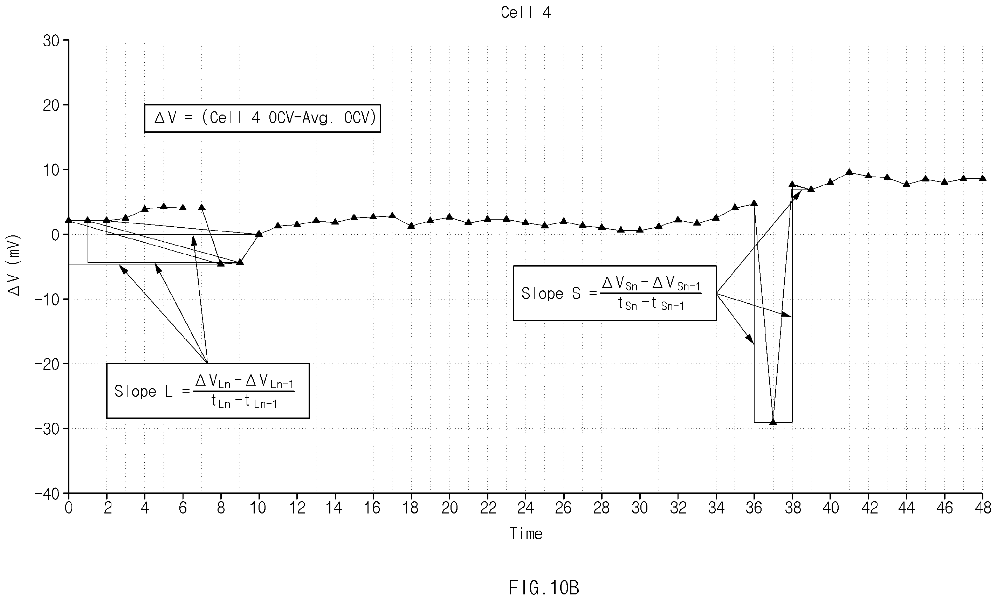

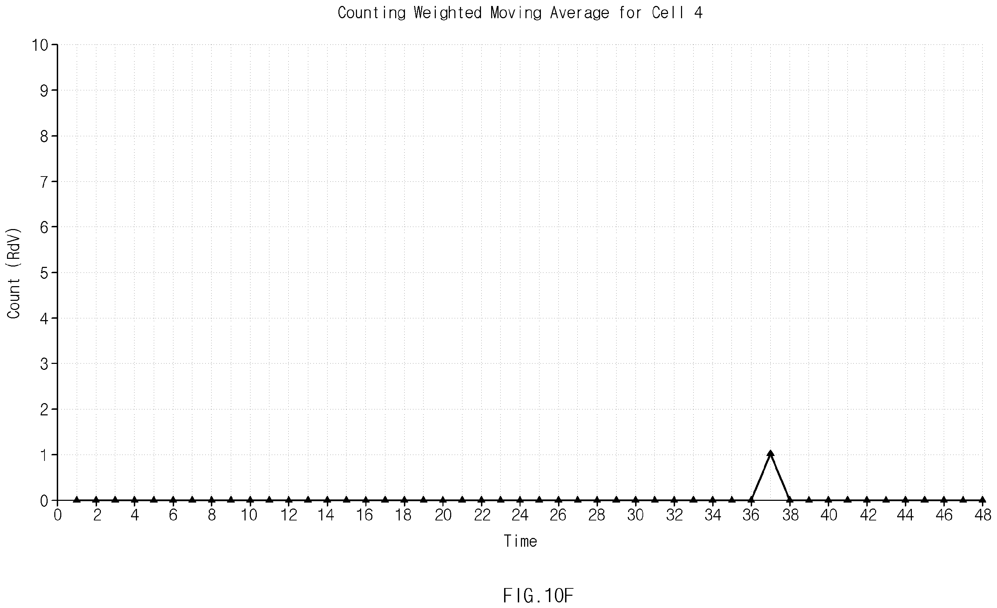

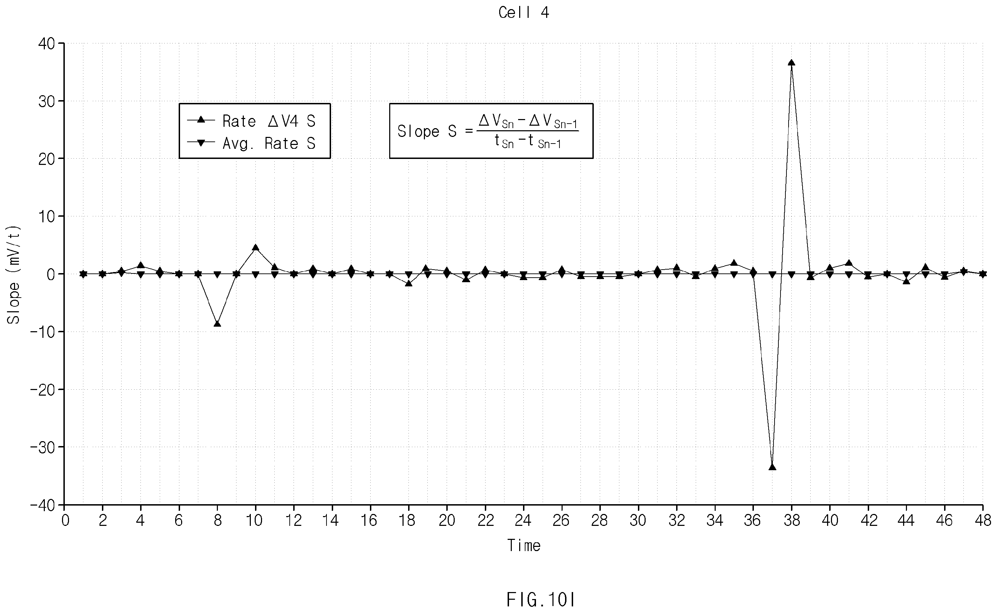

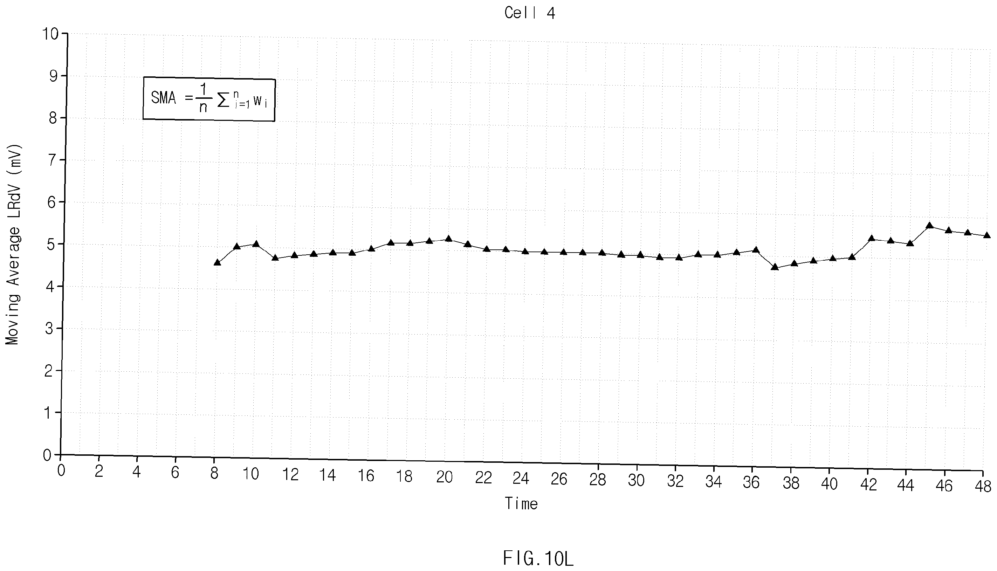

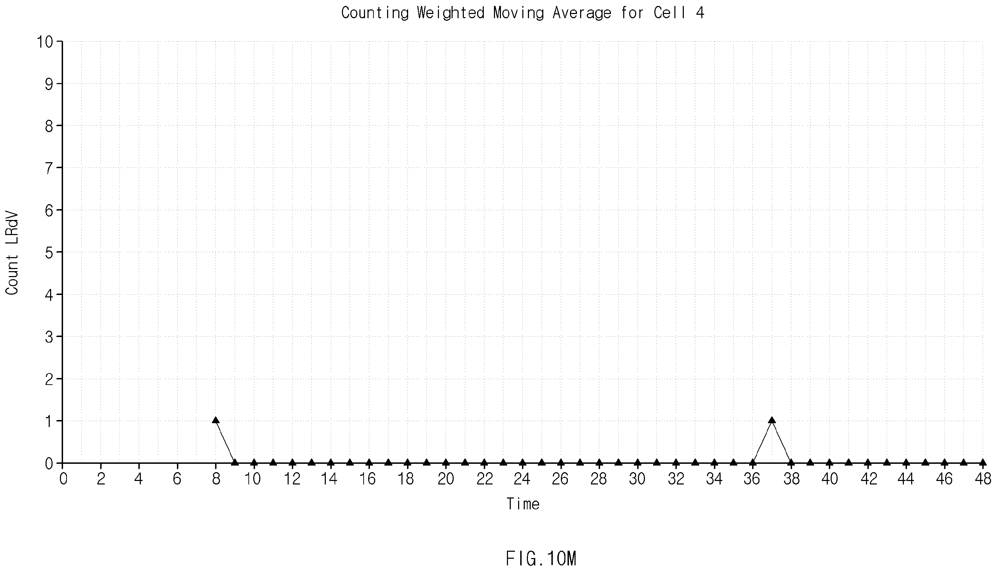

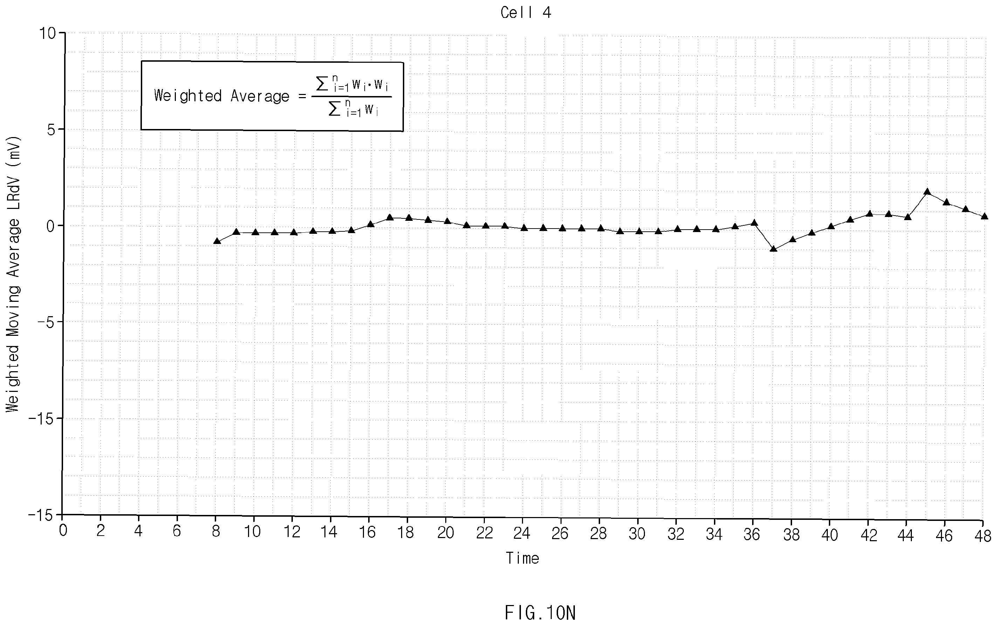

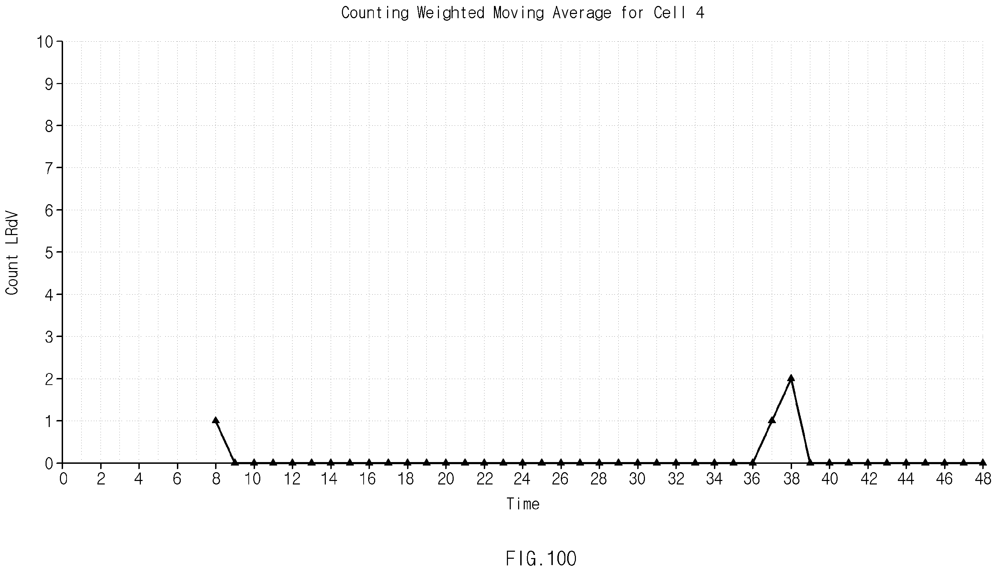

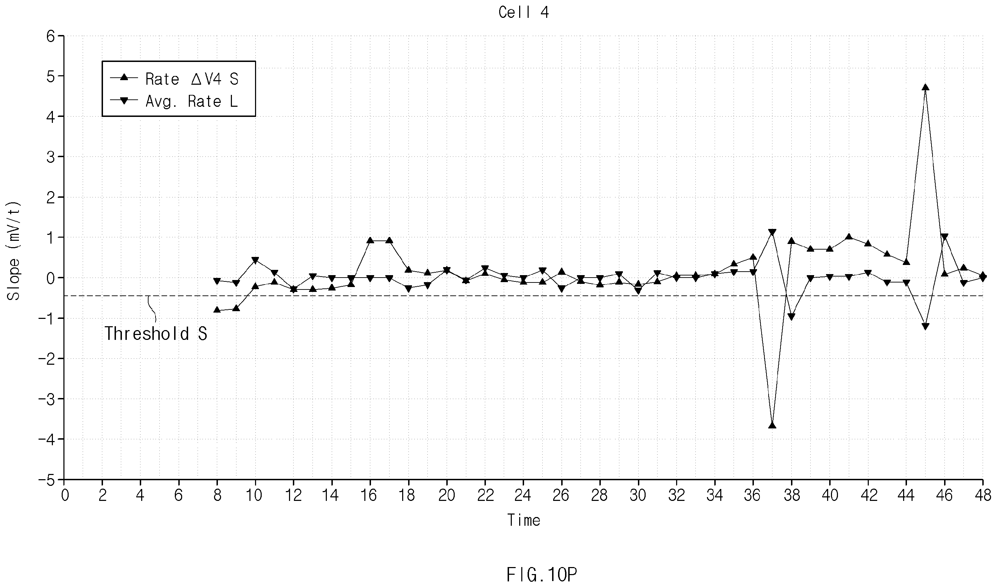

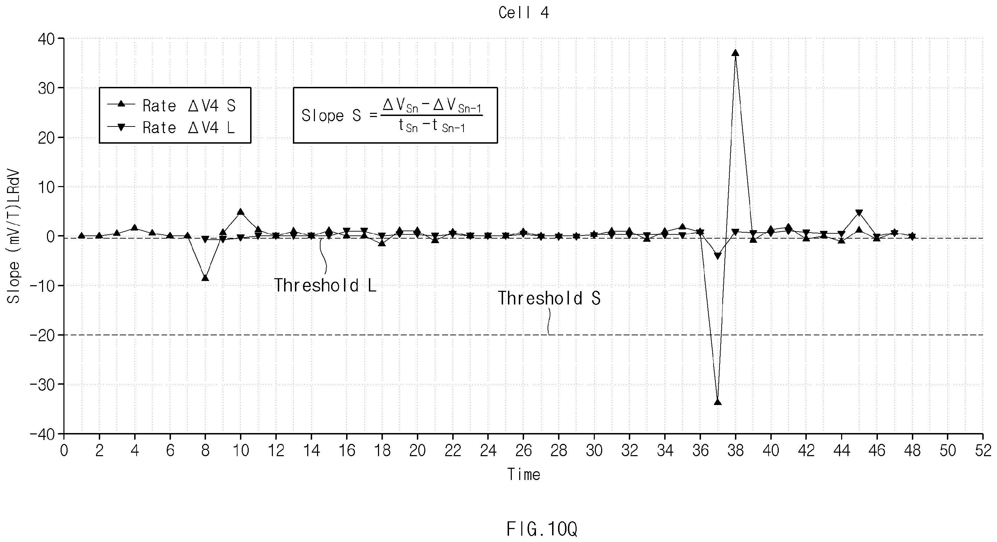

FIG. 10A illustrates the comparison between the OCV values of cell 4 and the average OCV values of the five cells, and FIG. 10B shows the differential values ($\Delta V$ = OCV for cell 4 - Avg. OCV) between the OCV measurements of cell 3 and the average OCV of the five cells at each measurement time point shown in FIG. 10A. These two graphs are similar to those in FIGS. 8A and 8B, but for cell 4, and the detailed description is omitted. Similarly, an example Slope L for cell 4 is determined by calculating the rate of change in $\Delta V$ between months 16 and 24 over an 8-month period, and an example Slope S is determined by calculating the rate of change in $\Delta V$ between months 37 and 38 over a 1-month period.

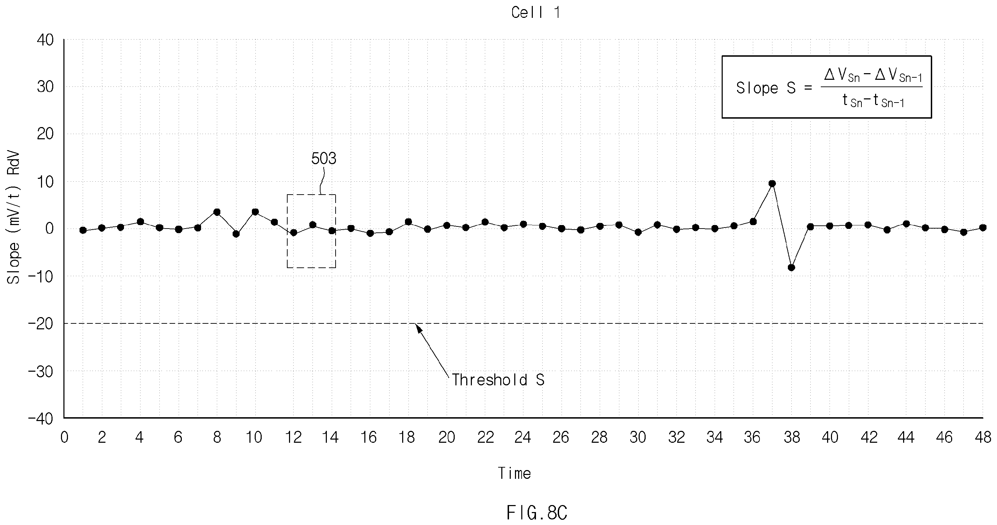

FIG. 8C illustrates the slope (e.g., Slope S), namely, the rate of change of the OCV difference values of cell 1 over a certain length of time, e.g., a 1-month duration of time shown in FIG. 8B. The vertical axis represents the slope (or variances), while the horizontal axis represents time. A steep slope (indicating a large rate of change) could signify rapid degradation or abnormal behavior, such as an internal short circuit or excessive heat generation. The slope data is compared to a threshold, e.g., Threshold S, which is a predetermined value representing the maximum allowable voltage drop before fire occurs. If the slope exceeds this threshold, i.e., if cell 1's rate of voltage decrease over the certain duration of time is greater than this threshold, it may indicate that cell 1 is experiencing an abnormal condition that requires further investigation. The graph in FIG. 8C illustrates that there is no slope value, in absolute, greater than the absolute value of Threshold S (e.g., (-)20mV/t) according to this example analysis.

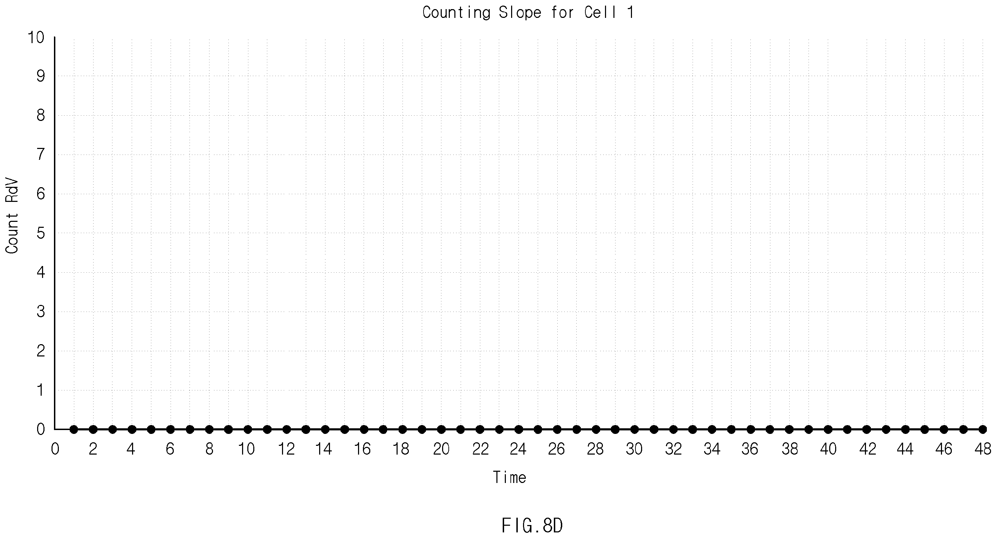

The plot in FIG. 8C can be differently plotted to show how often the slope drops below the predetermined threshold, e.g., Threshold S, as illustrated in FIG. 8D. In this example, the vertical axis of FIG. 8D represents the count of occurrences, while the horizontal axis represents time or different measurement intervals. Every time the slope falls below the threshold, it signals that the battery is showing unusual behavior-specifically, that the rate of change in the OCV difference is faster than what is considered normal or acceptable. Keeping track of how often the slope falls below this threshold is an important tool for monitoring the battery's health. By counting these occurrences, it is possible to determine the likelihood of a problem, such as battery failure or potential fire risks. For example, if the count is one, it might simply be some minor issue, but if the count is more than two, it could indicate more serious concerns and the need for additional safety checks. In this specific example, since the slope has never dropped below the shorter-term threshold, i.e., the absolute value of the slope is never greater than the absolute value of the predetermined threshold, the count remains at zero, meaning the battery is operating normally and does not pose any immediate danger.

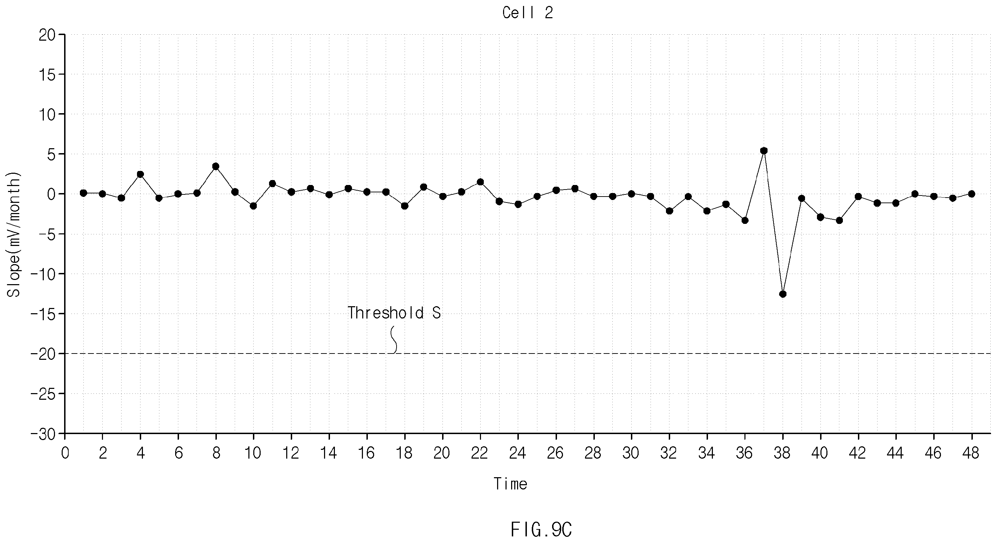

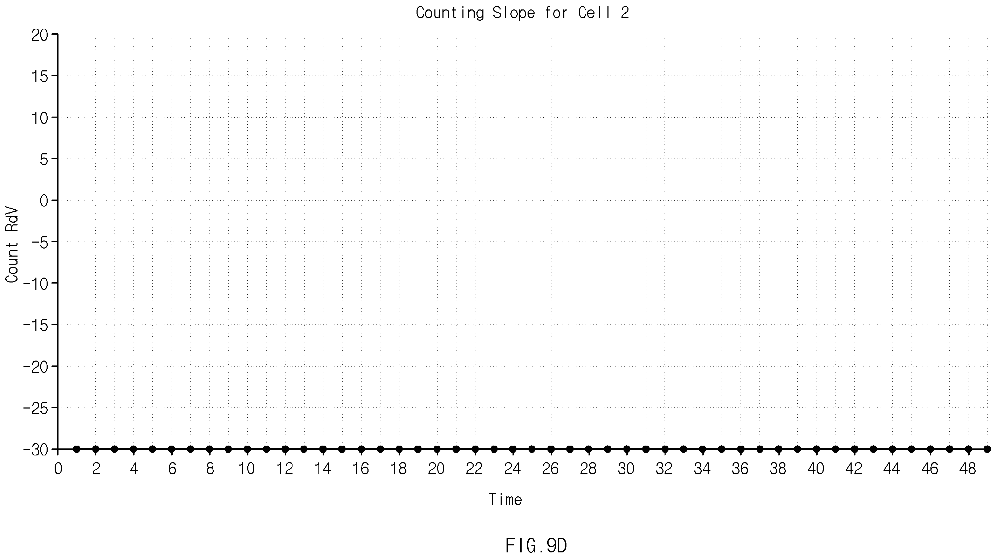

FIG. 9C illustrates the slope (Slope S) of the OCV difference values over a 1-month period from FIG. 9B. FIG. 9D shows the count of occurrences where the slope, shown in FIG. 9C, falls below the short-term threshold (Threshold S). Similar to the example illustrated in FIGS. 8C and 8D, the OCV differential value for cell 2 does not drop faster than the threshold absolute values. This shows that the battery is operating within the expected range, with no significant issues detected.

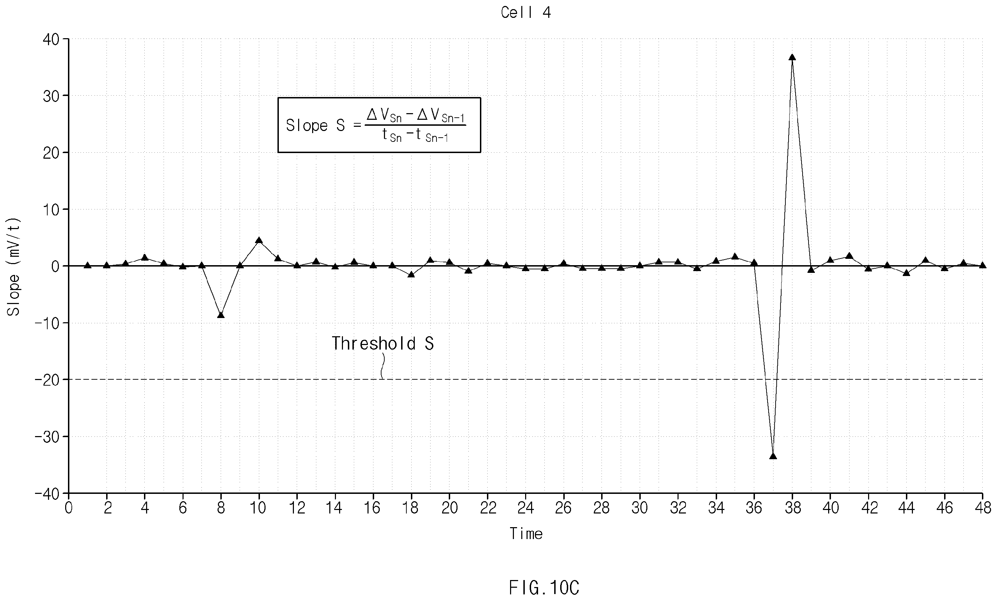

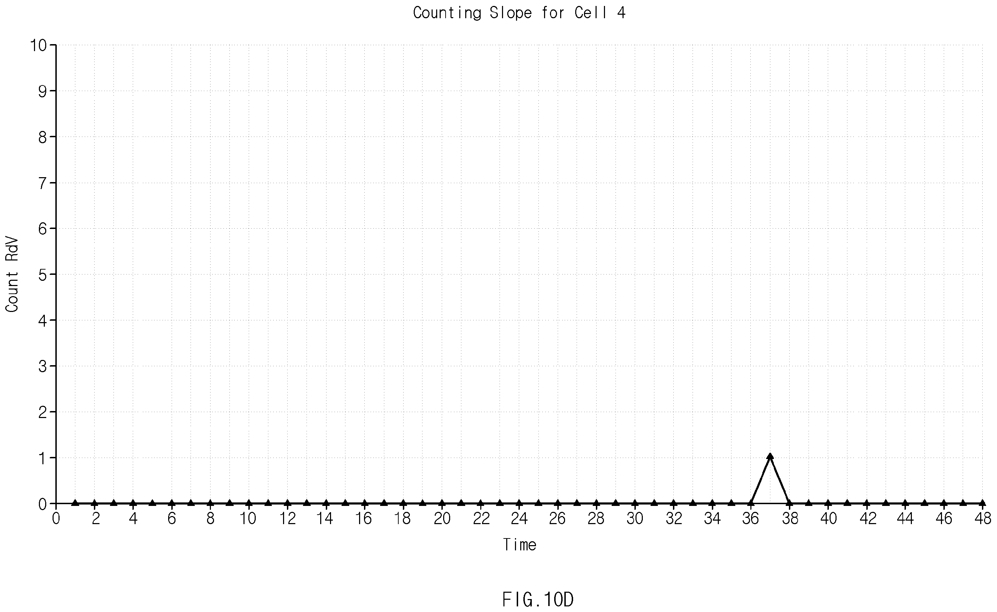

FIG. 10C shows the slope (Slope S) of the OCV difference values from FIG. 10B, while FIG. 10D illustrates the count of occurrences where the slope from FIG. 10C drops below the threshold (Threshold S). In contrast to cells 1 and 2, cell 4 has one instance where the OCV differential value drops faster than the threshold absolute value, specifically at the 37-time point mark. As a result, the count value in FIG. 10D is 1 at that time point. This count can be used to assess potential fire risk; for example, if there is at least one occurrence or more, it may signal a higher risk of fire, prompting further safety actions.

The slope analysis mentioned earlier is just one example of how to predict potential risks in battery cells. In other cases, different data smoothing methods, such as Simple Moving Average (SMA) or Moving Average (MA), can be used with OCV data to detect unusual battery behaviors. When applied to OCV data, the moving average calculates the average OCV over a specific time frame, helping identify any abnormal shifts in the battery's performance. For example, if the OCV of a battery cell increases or drops sharply beyond a certain limit, it could be a warning that the battery is failing or at risk of fire. The MA can be calculated over a fixed window, such as the average of the last 5, 10, or 15 measurements. As new OCV data is collected, the oldest value is dropped, creating a "moving" window that tracks changes over time.

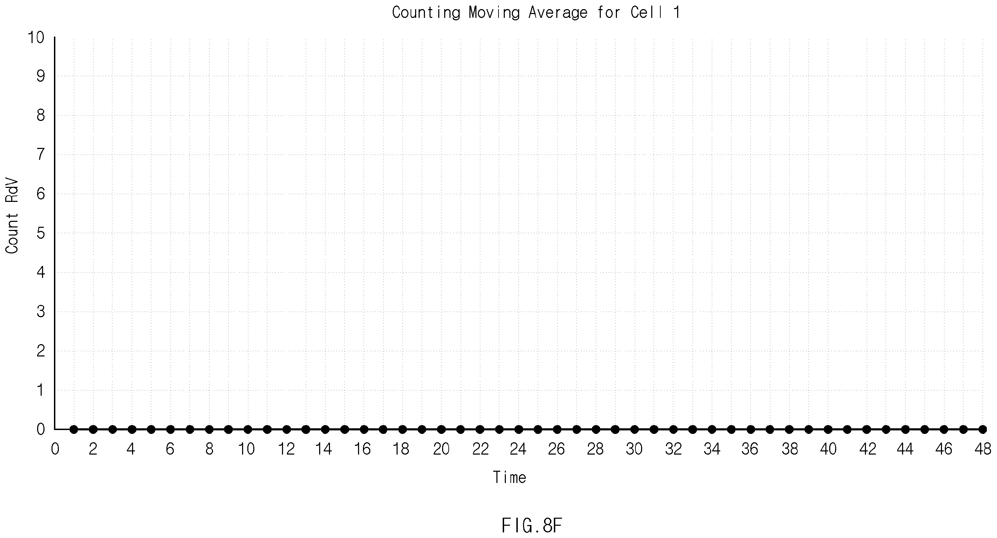

For example, the MA at 8 time units is a moving average of 4 short-term slope values. The window of size n (length of time) can vary, e.g., 2, 3, 4, 5, 6, or the like, for each battery cell. If the moving average of the slope data of a cell (e.g., cell 1) suddenly shifts past a pre-set threshold, it might suggest the battery is experiencing issues like overheating or component failure. Further, similar to how the rate of change occurrences were counted, the MA data is also compared with the threshold, and the number of occurrences it falls outside the threshold is counted, as shown in FIG. 8F.

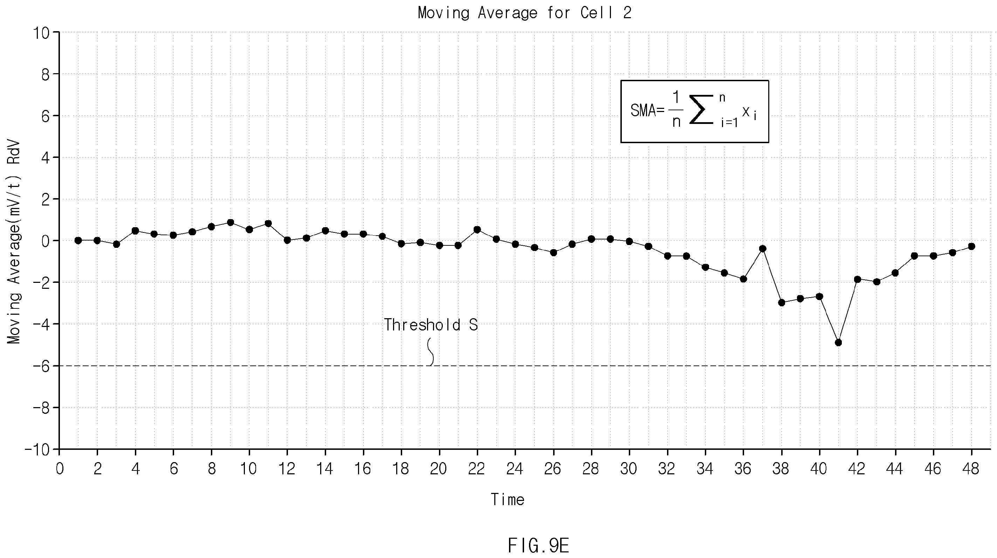

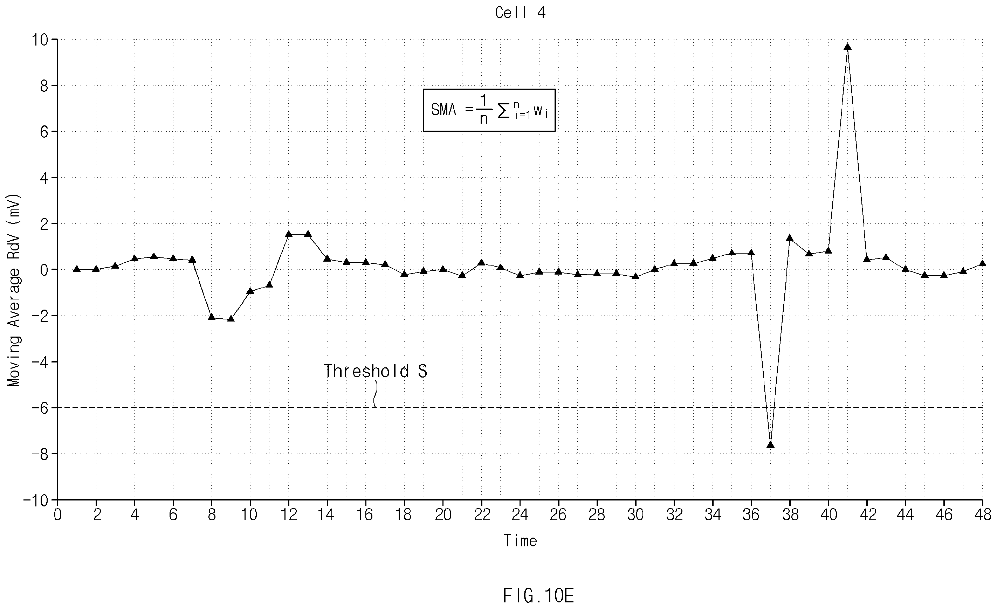

Moving average values are calculated and plotted for cell 2 and cell 4 comparison, as shown in FIGS. 9E and 10E, respectively. As seen, one moving average in cell 4 falls below the threshold, i.e., the absolute value thereof is greater than the absolute value of the threshold, which is consistent with the slope analysis results.

The weighted moving average (WMA) is a more advanced form of the moving average where different weights are assigned to each data point within the time window. More recent data points may be given higher weights. Similar to the MA, the WMA also calculates the average of OCV values within a specific cell over a specified period. The formular for WMA is

$$WMA = \frac{w1*x1 + w2*x2 + \ldots + wn*xn}{w1 + w2 + \ldots + wn}$$

where $x_1, x_2, \ldots, x_n$ are the data points (OCV values), and $w_1, w_2, \ldots, w_n$ are the respective weights assined to each point.

If the most recent OCV values are disproportionately higher than previous values, it suggests that the specific battery cell may be behaving abnormally. By giving more weight to recent measurements, the WMA can help detect more immediate risks, such as a rapid OCV increase, which could indicate imminent failure

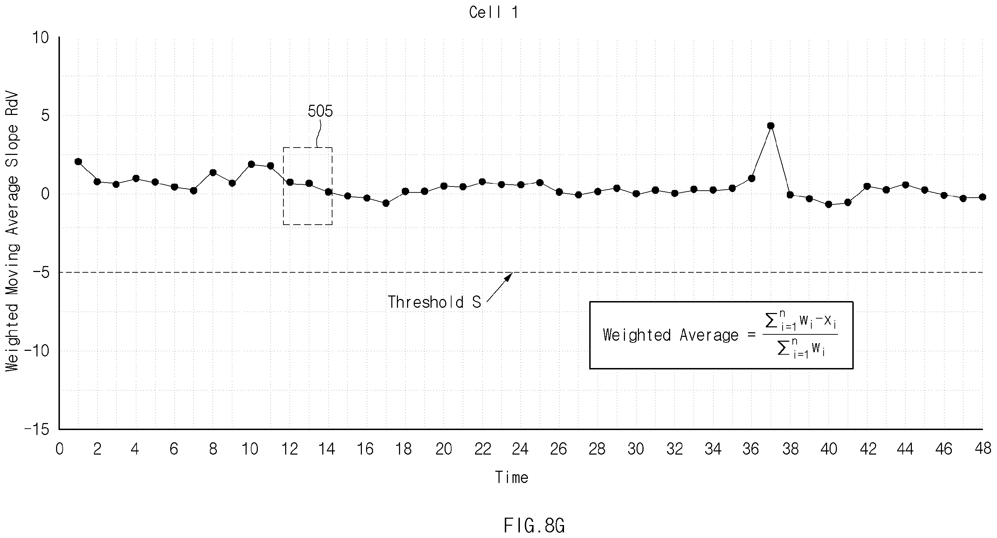

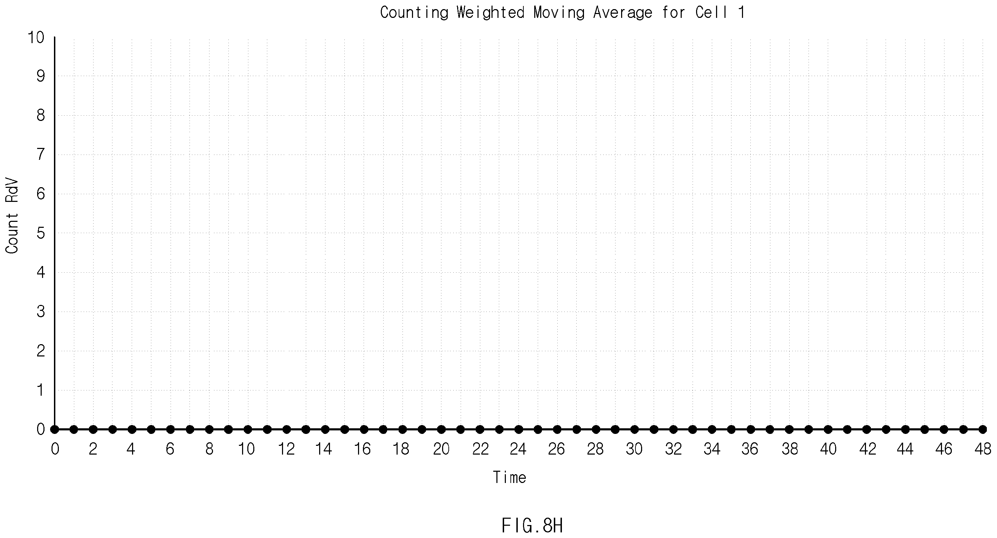

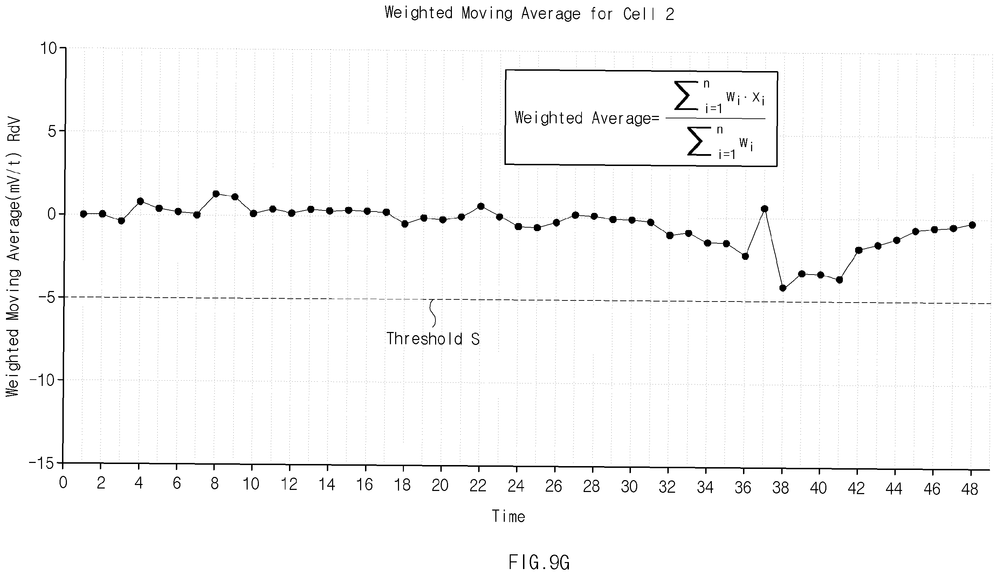

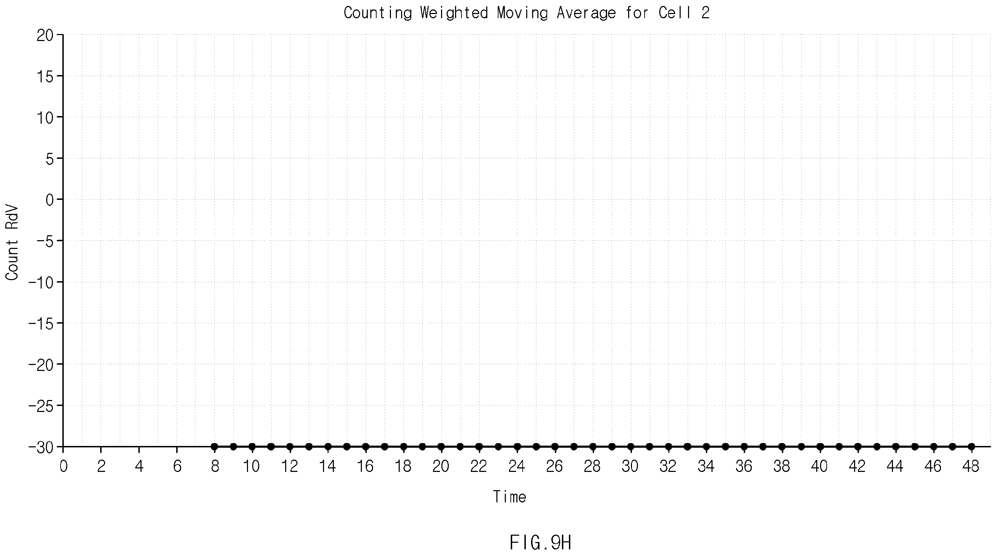

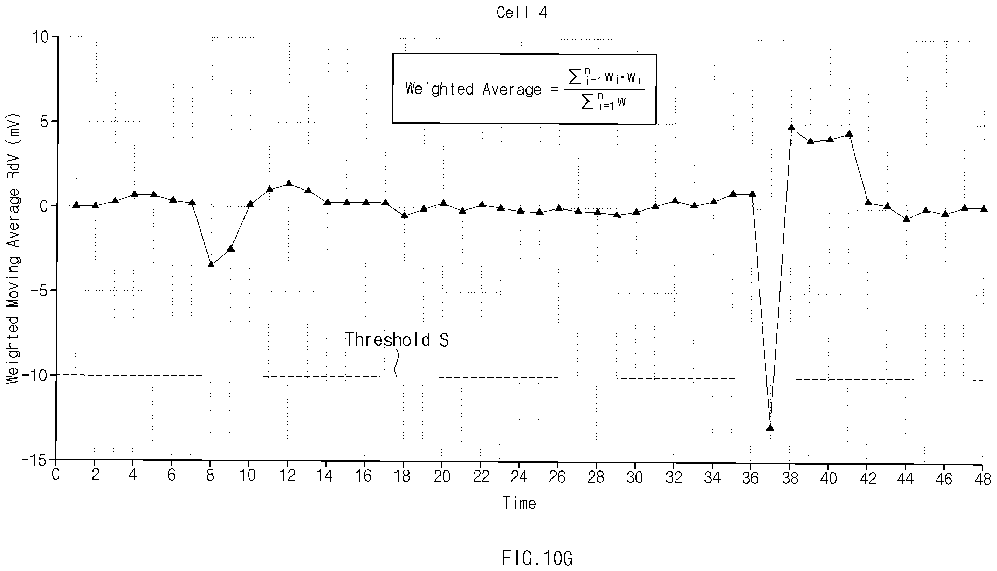

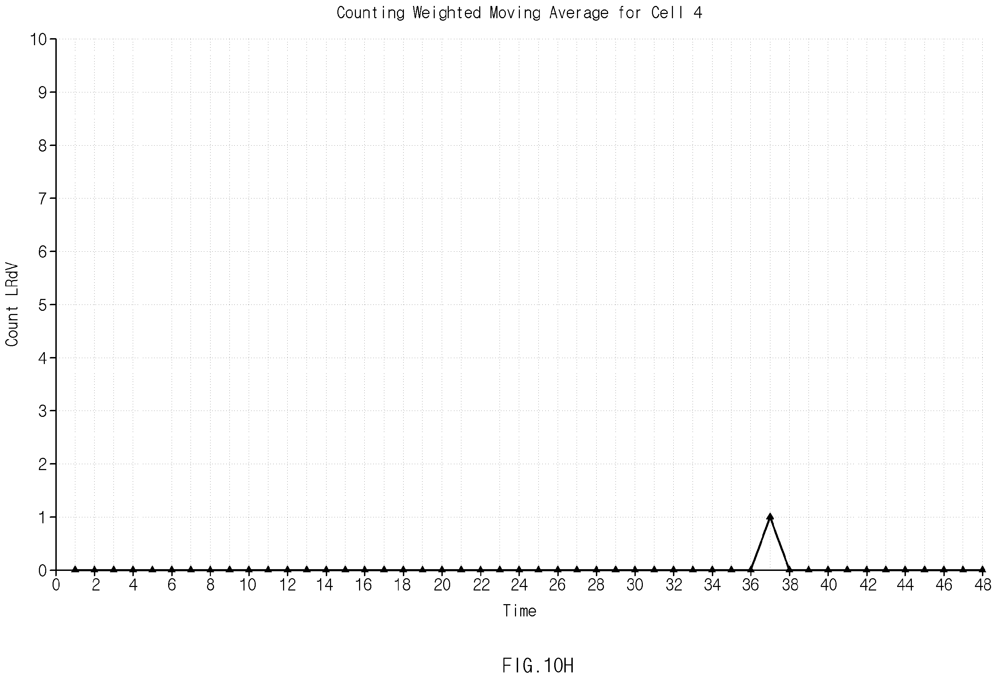

In FIGS. 8G, 8H, 9G, and 9H, the weighted average OCV data shows that, just like with the slope and simple moving average tests, everything is normal with battery cells 1 and 2 during the timeframe they are measured. However, as shown in FIGS. 10G and 10H, cell 4 shows a possible sign of fire risk, consistent with the slope and simple moving average tests

Another powerful way to analyze the OCV data is the Exponential Moving Average (EMA). This method is similar to a regular moving average but with a twist-it gives more weight to the most recent data points. This means that the EMA is very sensitive to recent changes, which makes it excellent at spotting sudden shifts in OCV. With this sensitivity, the EMA can quickly find any unusual behavior, which could help detect potential fire risks.

Cumulative Sum (CUSUM), is good at detecting even the smallest changes over time. CUSUM works by tracking how much the data deviates from a set reference point. This helps catch subtle trends that may not be obvious at first. CUSUM is especially helpful for spotting gradual changes in OCV, which could signal problems that might not yet be severe.

For even more advanced detection, machine learning techniques can be used. These algorithms can study historical OCV data to learn how batteries normally behave. By doing this, they can identify when new data points fall outside of the expected patterns. This results in a highly advanced method for finding potential problems or fire risks in the battery apparatus.

When combined, one or more methods like Moving Average (MA), Weighted Moving Average (WMA), Exponential Moving Average (EMA), Cumulative Sum (CUSUM), and machine learningbased anomaly detection can work alone or in combination in conjunction with the rate of change in OCV difference method to improve fire risk detection in battery systems. By continuously monitoring OCV values and applying these techniques, the system can detect potential hazards early.

It is understood that these data analysis methods are merely for illustration and non-limiting. There are many other ways to analyze the OCV data.

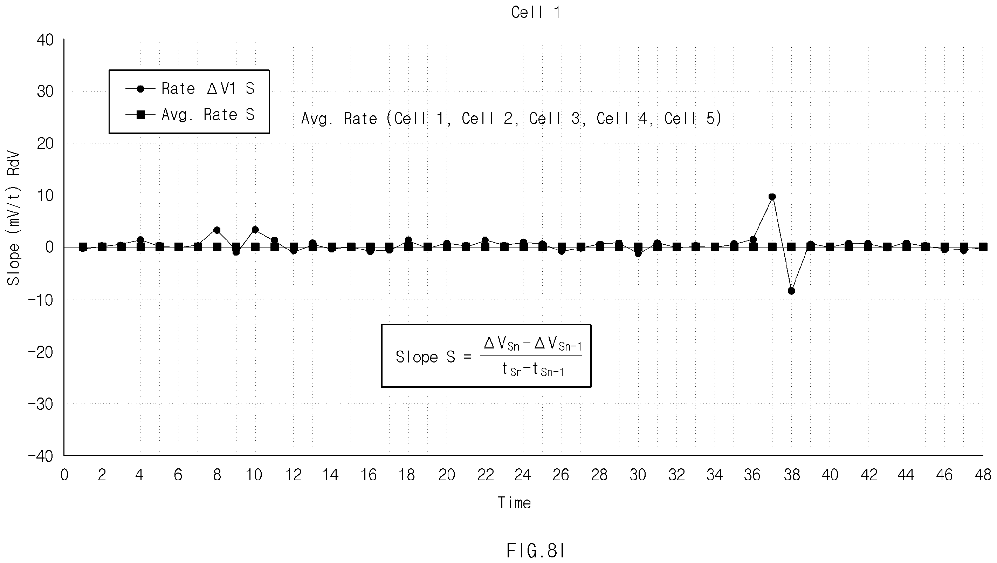

FIG. 8I compares the slope shown in FIG. 8C for battery cell 1 with the average slope for the five battery cells. This allows for a comparison between the behavior of one single cell and that of all the cells within the same system as whole, offering insights into whether the observed rate of change is normal or anomalous. The vertical axis represents the slope, and the horizontal axis represents time. A deviation from the average slope could indicate abnormal behavior specific to battery cell 1, which may be indicative of an increased fire risk.

## LONG-TERM VOLTAGE DROP ANALYSIS (LRdV)

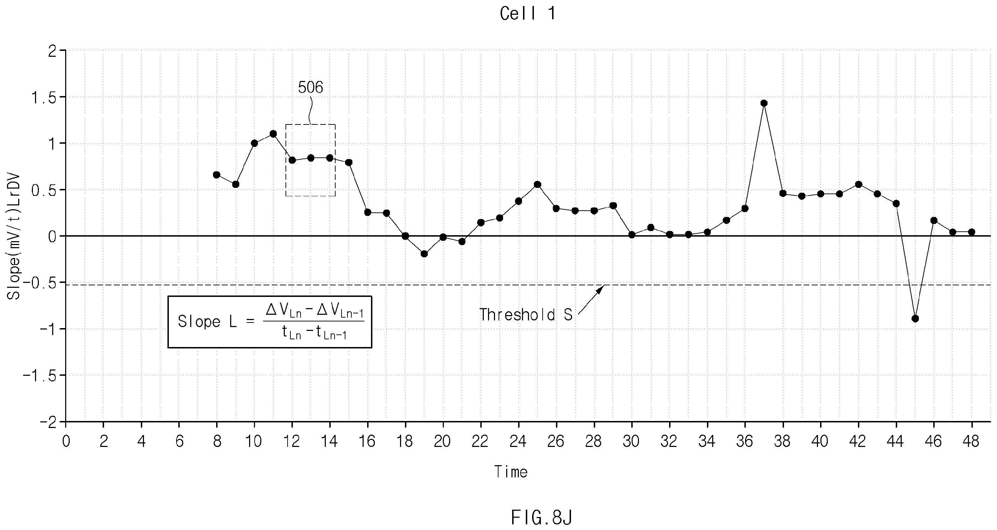

FIG. 8J depicts the slope (e.g. Slope L) of the OCV differential values ($\Delta V$) shown in FIG. 8B over an 8-month period as an example predetermined length of time. The vertical axis represents the slope, while the horizontal axis represents time. This slope is compared to a predetermined threshold (Threshold L), which may be different from the threshold in FIG. 8C. For example, the Threshold S may be (-)20 mV/t, while the Threshold L may be about (-)0.5 mV/t or (-)0.5375 mV/t. These thresholds are not limited to those in the examples illustrated in the figures. If the slope surpasses the predetermined threshold, it could signal that the battery cell is undergoing an unusual condition warranting further examination. For instance, in this scenario, cell 1 encounters the anomaly at time point 45 units, e.g., months.

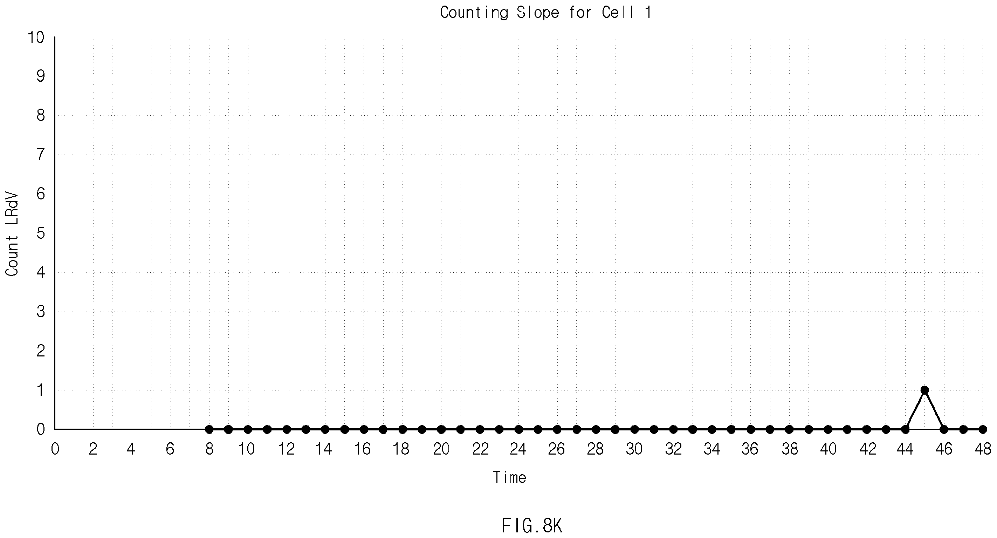

FIG. 8K presents the count of occurrences where the slope shown in FIG. 8J falls below the threshold, i.e., the absolute value of the slope being greater than the absolute value of the threshold. The vertical axis shows the count, and the horizontal axis represents time or different measurement time points. The count of occurrences below the threshold indicates that the battery is exhibiting abnormal behavior. In this example, since no slope has passed the threshold, all the count values are 0.

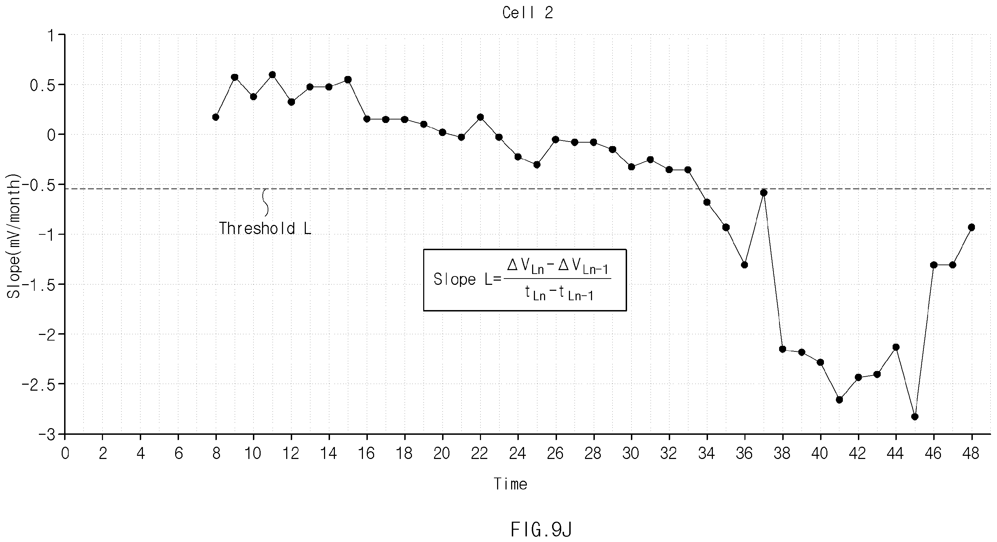

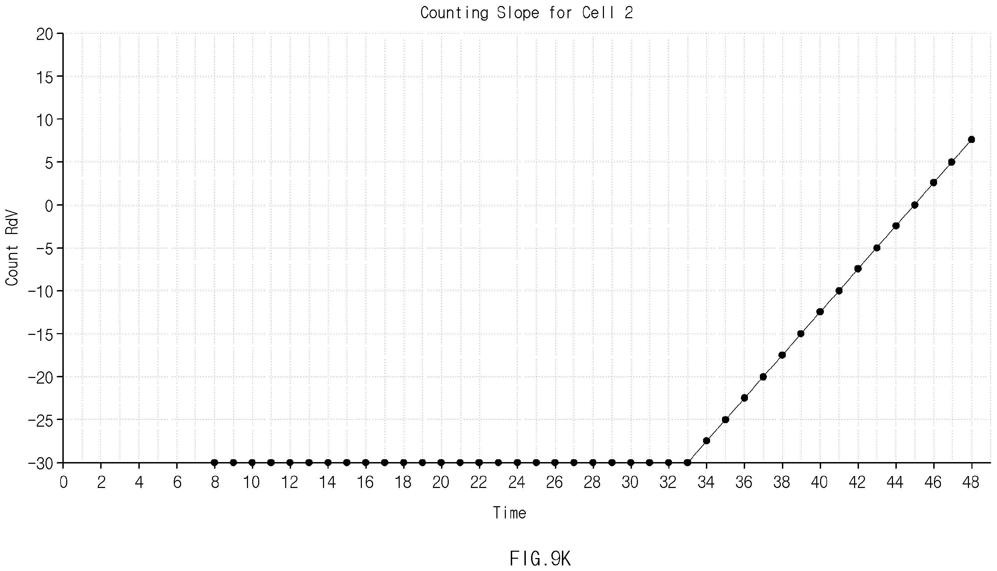

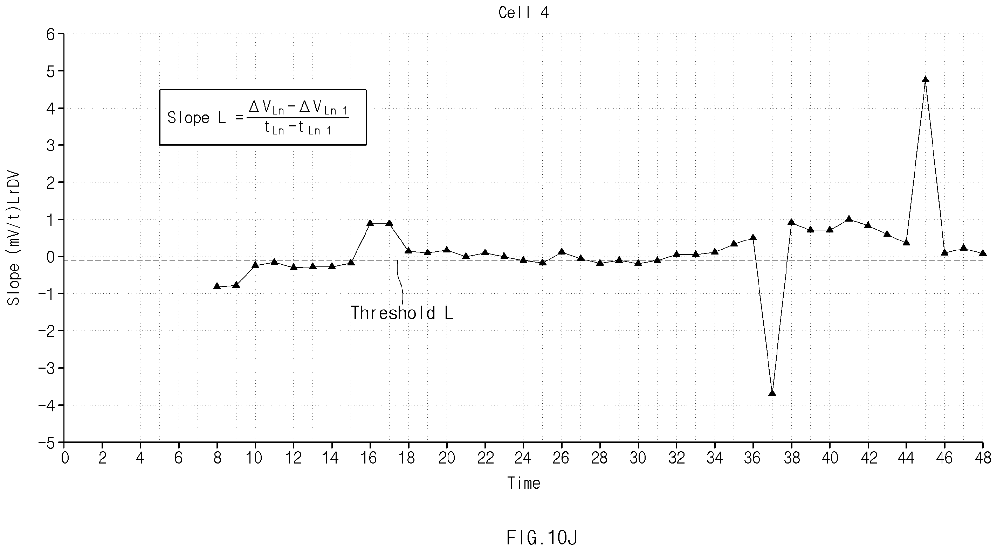

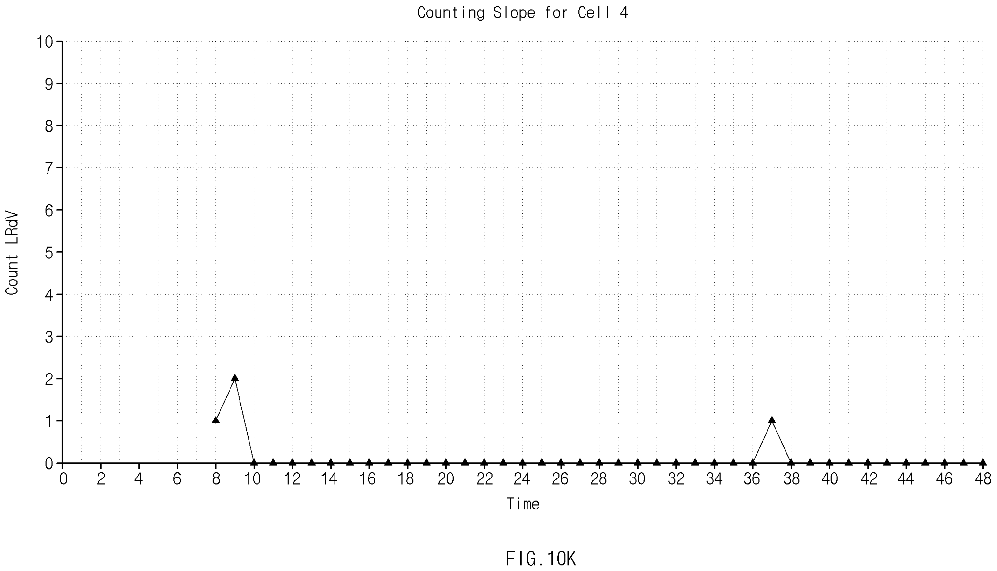

FIG. 9J illustrates the slope (e.g., Slope L) of the OCV difference values shown in FIG. 9B over an 8-month period. In this illustration, the slope drops below the threshold (e.g., ~0.5 mV/month) at the 40-unit (e.g., month) mark, indicating that the battery cell is at risk of fire. FIG. 9K shows the count of occurrences where the slope of battery cell 2 falls below the threshold as depicted in FIG. 9J. Since the slope starts dropping below the threshold at the 34-month mark, the count value starts at this mark. This count can be used to assess fire risk. For example, fire risk can be considered as soon as the slope meets the threshold, after a count of 2, or after a count of 3, etc. Through this, it can be seen that there is no fire risk in battery cell 1 (as shown in FIG. 8K), but there is a fire risk in battery cell 2 (as shown in FIG. 9K). Although the detailed description is omitted herein, cell 4 also has fire risk as shown in FIGS. 10J and 10K, which show that the slope falls below the threshold multiple times.

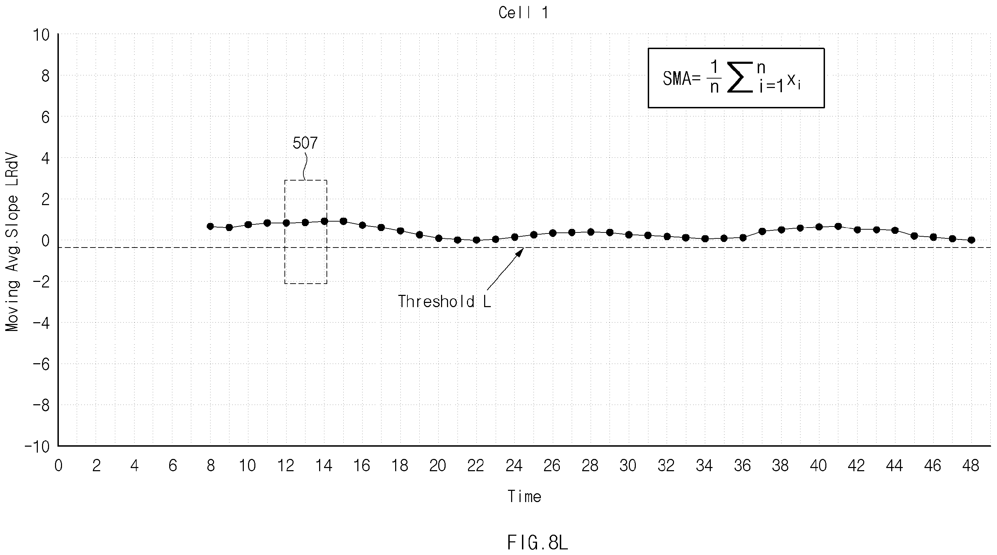

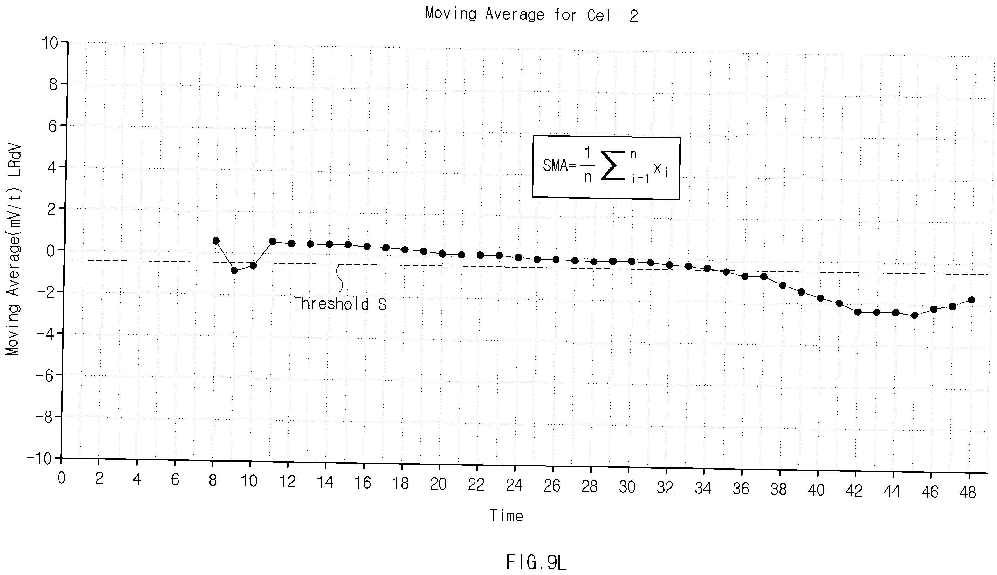

FIGS. 8L-8P for battery cell 1 show plots similar to FIGS. 8C-8I but focus on a longer duration of time using different data analysis methods, like moving average and weighted moving average. The same type of analysis is done for battery cell 2 in FIGS. 9L-9P and for battery cell 4 in FIGS. 9L-9P. The battery cells behave similarly in both short-term and long-term timeframes, showing some changes in the OCV drop. However, when looking at the data for a longer period, as shown in FIGS. 9J and 9K, with a smaller threshold for detection, more changes are spotted. For example, comparing the results from FIG. 9D (shorter timeframe analysis) to FIG. 9K (longer timeframe analysis), it becomes clear that a longer time of observation can detect fire risks that might be missed in the short-term analysis. This shows how important it is to use both short-term (steep voltage drop) and long-term (subtle voltage drop) analysis to properly monitor battery behavior and find potential problems.

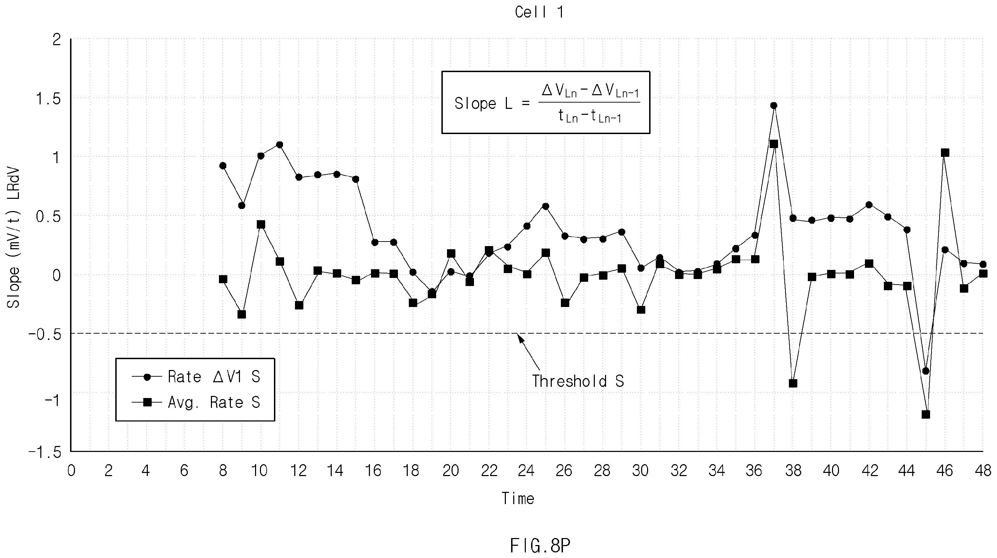

FIGS. 8P, 9P, and 10P each show two different types of slopes side by side: one for the steep voltage drop and one for the subtle voltage drop. These comparisons help to understand how the same battery data can look different depending on the type of analysis used. The steep voltage drop slope analysis looks for big, sudden changes in the battery's OCV, while the subtle voltage drop slope analysis focuses on slower, smaller changes over time. Even though both analyses are looking at the same OCV data, the results can change depending on how the data is processed. For example, a rapid drop in OCV might be caught by the steep drop analysis, while a slower, smaller drop might only show up with the subtle drop analysis.

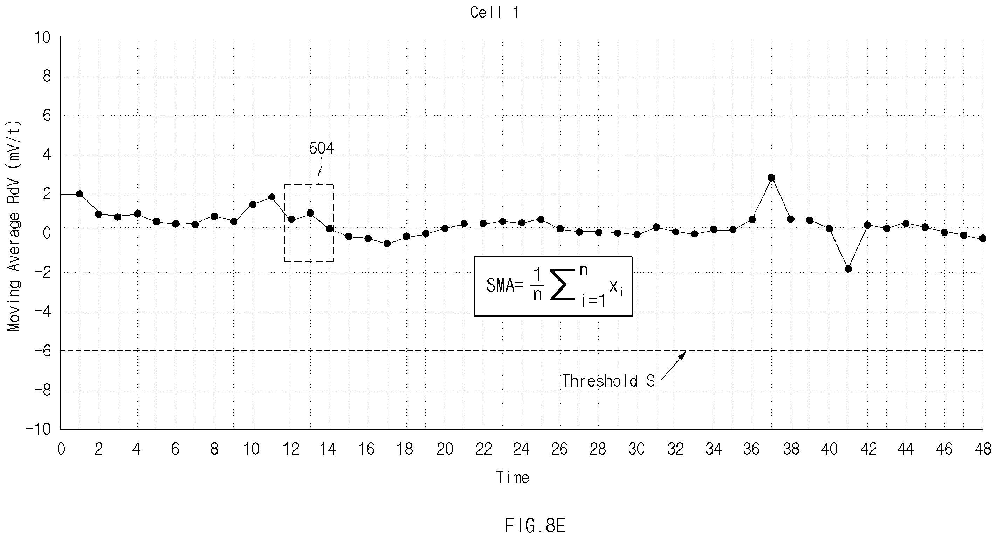

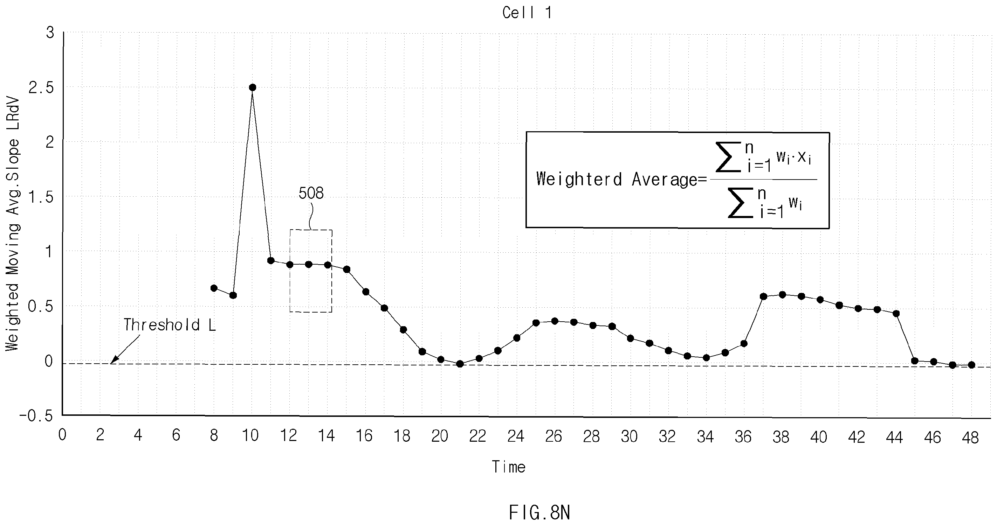

FIGS. 11A-11J show data measured much more often than the data in FIGS. 6-10P. In FIGS. 6-10P, the OCV data was taken once a month for 48 time units, such as 48 months. But in this third voltage drop analysis, the measurements are taken daily for the five battery cells in one battery module. FIGS. 11A-11J are the "zoom in" figures on what was shown in FIGS. 6-8C, 8E, 8G, 8J, 8L, and 8N, respectively, for example, with daily measurements instead of monthly ones. By measuring the battery every day, it becomes easier to see small changes or "noise" that might not have been visible with just monthly measurements.

The graphs with more frequent measurements show that sometimes the readings go way above both threshold lines, which could mean there is a high chance of fire risk. However, some of these changes might just be random noise from the way the data is collected. Thus, using different ways to analyze the data can help make sure the fire risk is detected correctly.

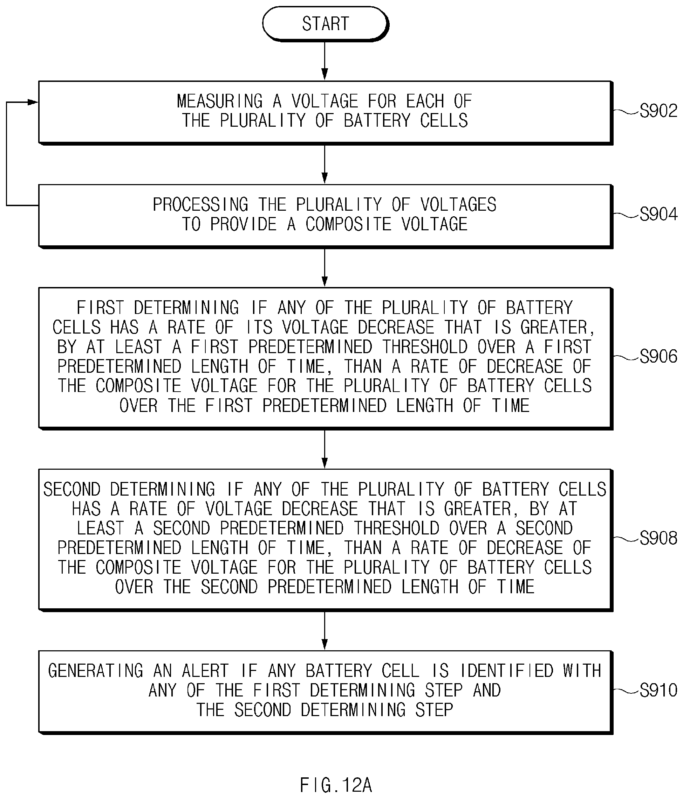

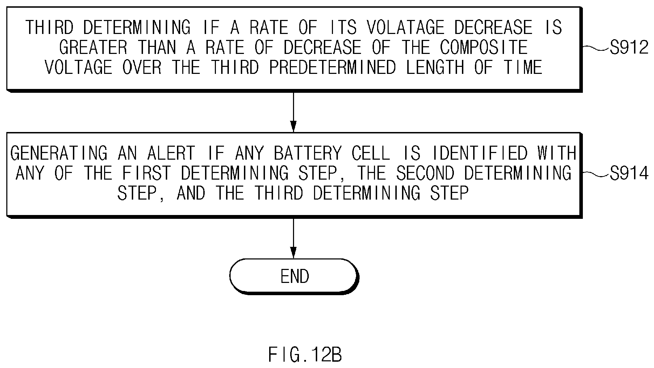

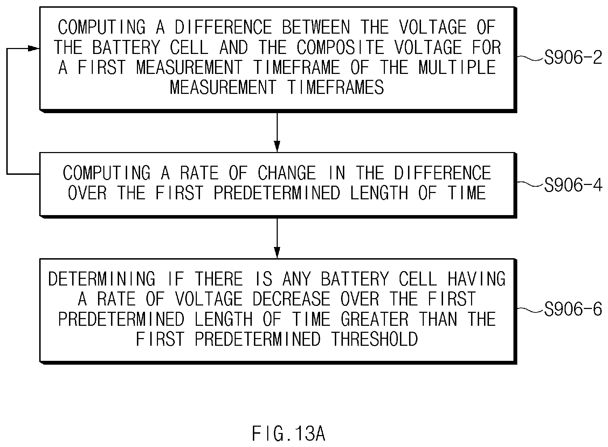

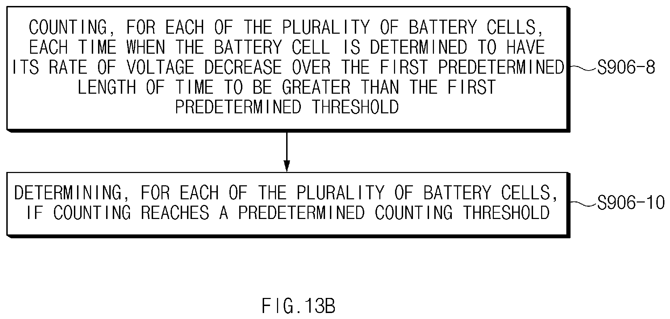

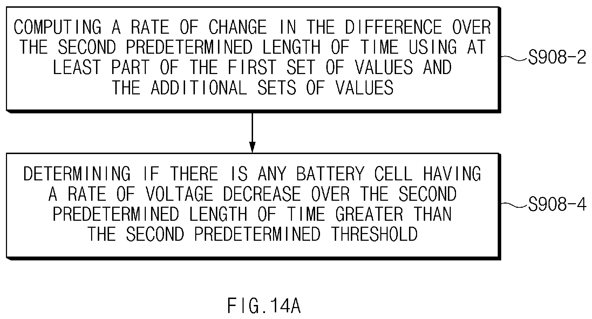

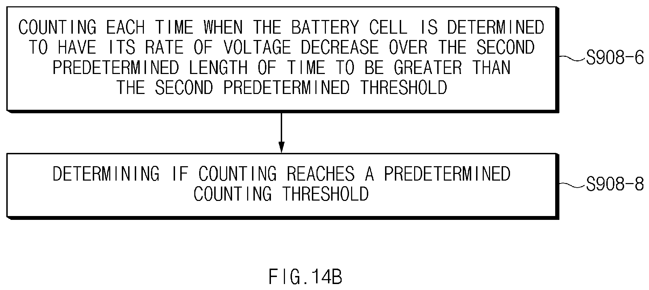

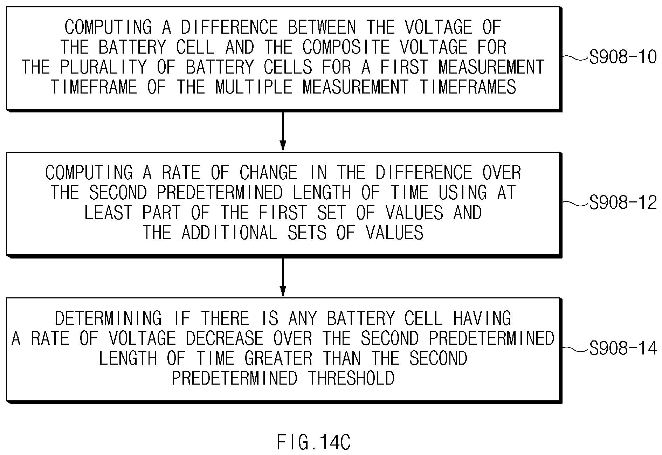

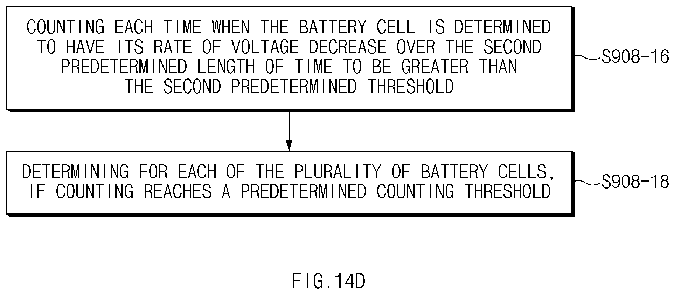

This section reiterates the method of monitoring a battery's health as provided in this disclosure, as illustrated in the flowcharts of FIGS. 12A-15, which are provided alongside the previously described exemplary graphs. FIG. 12 shows process 900, which outlines a method for diagnosing the health of a battery, according to one embodiment of the present disclosure. The method ensures that batteries remain safe and in good condition. Batteries are used in many devices, including phones, laptops, and electric cars. Occasionally, a battery may start to experience issues, such as losing power too quickly, which could become dangerous. This method helps monitor the battery's health by tracking its voltage over time. If the battery shows signs of problems, such as rapid power loss, an alert may be generated to notify users.

Process 900 begins by measuring the voltage of each battery cell at a specific moment in time in step S902. The voltage may be measured at the single measurement timeframe simultaneously or consecutively for the plurality of battery cells, such that measurements for the plurality of battery cells are completed within a generally same timeframe. Each battery cell can be thought of as a small battery within the larger battery. The voltage of each cell is checked to determine how much power it holds. These voltages are then recorded, creating a list of numbers that represent the power level of each individual cell at that moment. After the voltage of each battery cell is measured, the next step is to combine these voltages to calculate a composite voltage in step S904. The composite voltage can be an average voltage of multiple or all the battery cells. This provides an overall understanding of the battery apparatus' condition. To gain a more accurate understanding of how the battery is performing, the voltage of each cell is measured multiple times over a duration of time, such as a period of days or weeks.

After each set of voltage measurements is taken, the composite (e.g., average) voltage is calculated again. The process can be repeated multiple times to ensure the battery is regularly checked.

Now, the method checks if any battery cells have a big drop in voltage in step S906. If one of the little batteries drops its power faster than a certain limit (e.g., a shorter-term threshold), this could be a sign that something is wrong. This step checks whether the battery cells are losing power too quickly, which could be a sign of trouble.

In step S908, the method looks for even bigger drops in power, using a bigger limit (e.g., a longer-term threshold). This second check looks for more serious problems. If a battery cell loses power too fast, it could mean the battery is about to fail, so it needs to be fixed or replaced soon. The longer-term threshold is set substantially smaller than the shorter-term threshold to catch the more serious problems.

If any battery cells are found to be losing power too quickly, an alert is triggered in step S910. The alert serves as a warning This alert notifies users that the battery should be inspected, replaced, and/or repaired to prevent further issues. The alert can take various forms, including visual cues, sounds, vibrations, or other sensory signals. A non-limiting illustrative example of an alert can be a message saying, "Attention: A problem has been detected with this battery! It may pose a safety risk!"

To be even more careful, the method may further look at smaller problems that might not seem as bad at first but could get worse in step S912. This is the third check, where it looks at even smaller drops in power over a short amount of time. The method checks to make sure that small changes in power are not mistaken for big problems. This step makes sure that only real issues are flagged.

The individual cell measurements are compared to the module's average OCV. If any abnormal differences are detected, the system evaluates the data against predetermined thresholds to assess the severity of the anomaly. If the differences exceed the thresholds, an alert is generated in step S914, indicating the potential for a failure or fire risk. The system can also provide a detailed analysis of the OCV trends, allowing for the identification of both short-term and long-term degradation patterns.

First and second checking steps S906 and S908 each may include sub-steps (e.g., S906-2 through S906-10 and S908-2 through S908-18). These sub-steps make sure that the method checks all the battery cells at the same time, or as close to the same time as possible. By measuring all the cells together, it makes sure the results are accurate and fair. In addition, as time passes, the method also looks at how fast the battery's voltage is changing. For instance, the method checks the difference in voltage between each cell and the average voltage to see if the change is happening too quickly. This helps find any battery cells that are acting strangely. If a battery cell keeps having problems over time, it gets counted. The method keeps track of how many times a problem happens and when it happens. If a battery cell has too many problems, it gets flagged, and an alert is generated.

For every timeframe, the difference between the voltage of each individual cell and the composite voltage is computed. For example, if the voltage of a specific cell drops from 3.8V to 3.6V in a given timeframe, the difference would be 0.2V. This calculation is performed for each cell at each measurement timeframe. After gathering the differences for all cells over multiple timeframes, the rate at which each cell's voltage changes (decreases) over time is calculated. This rate is computed over the first, second, or third predetermined time intervals. If a cell's voltage decrease exceeds the predefined threshold during any timeframe, the system considers this a potential problem and generates an alert.

If a specific cell consistently shows significant voltage drops over multiple timeframes, the system keeps track of how often this happens. Each time the cell's data exceeds the threshold, a counter is incremented. Once the counter reaches a specific, predetermined threshold (for example, if a cell's voltage drop exceeds the threshold three times in a row), the system may automatically generate an alert. This alert notifies the user that a specific cell is experiencing issues and requires attention.

After all the steps have been completed, if any battery cell is found to be having problems, an alert may be generated. This alert tells the user that something is wrong with the battery, and it may need to be fixed or replaced. By doing all these checks, the method provided herein keeps the battery safe and ensures its proper performance. This method makes it easy to know when a battery is healthy and when it needs attention making sure the battery stays safe and works properly for a long time. The alert generated can include several types of information, such as, battery health alert for suggesting the battery may need maintenance or replacement, service suggestion for recommending that the battery system be checked for potential faults, and replacement suggestion for, if a cell is consistently underperforming, it may need to be replaced, etc.

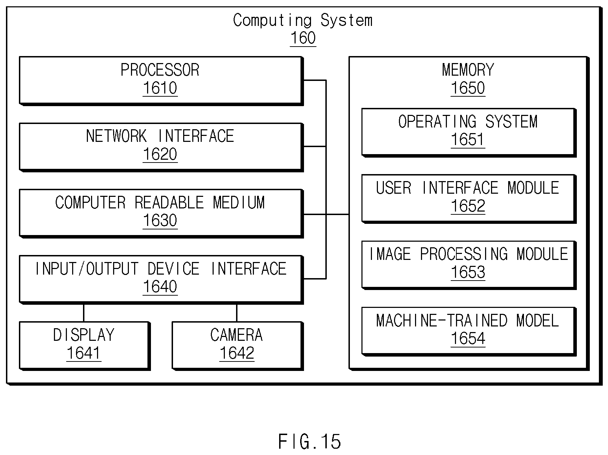

FIG. 15 depicts an example architecture of a computing system 160 that can be used to perform one or more of the techniques described herein and/or illustrated in other drawings. The general architecture of the computing system 160 may include an arrangement of computer hardware and software modules that may be used to implement one or more aspects of the present disclosure. The computing system 160 may include many more (or fewer) elements than those shown in FIG. 15. It is not necessary that all of these elements be shown in order to provide an enabling disclosure.

As illustrated, the computing system 160 includes a processor 1610, a network interface 1620, a computer readable medium 1630, and an input/output device interface 1640, all of which may communicate with one another by way of a communication bus. The network interface 1620 may provide connectivity to one or more networks or computing systems. The processor 1610 may also communicate with memory 1650 and further provide output information for one or more output devices, such as a display (e.g., display 1641), speaker, etc., via the input/output device interface 1640. The input/output device interface 1640 may also accept input from one or more input devices, such as a camera 1642 (e.g., 3D depth camera), a keyboard, a mouse, a digital pen, a microphone, a touch screen, a gesture recognition system, a voice recognition system, an accelerometer, a gyroscope, a thermometer, an optical temperature measurement system, a sonar, a LIDAR device, a laser device, etc.

The memory 1650 may store computer program instructions (grouped as modules in some implementations) that the processor 1610 executes in order to implement one or more aspects of the present disclosure. The memory 1650 may include RAM, ROM, and/or other persistent, auxiliary, or non-transitory computer-readable media. The memory 1650 may store an operating system 1651 that provides computer program instructions for use by the processor 1610 in the general administration and operation of the computing system 160. The memory 1650 may further include computer program instructions and other information for implementing one or more aspects of the present disclosure. In one implementation, for example, the memory 1650 includes a user interface module 1652 that generates user interfaces (and/or instructions therefor) for display, for example, via a browser or application installed on the computing system 160. As another example, the memory 1650 may store various programs regarding SOH calculation of a battery cell and determination of a cell balancing target, a battery engagement defect determination program, a battery data transmission program, a battery diagnosis program, etc. Moreover, the memory 1650 may store various data such as SOC data, SOH data, a sensing value, a temperature, etc., of each battery cell. The memory 1650 may be provided in plural, depending on a need. The memory 1650 may be a volatile or nonvolatile memory. For the memory 1650 as the volatile memory, random access memory (RAM), dynamic RAM (DRAM), static RAM (SRAM), etc., may be used. For the memory 1650 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1650 are merely examples and are not limited thereto. In addition to and/or in combination with the user interface module 1652, the memory 1650 may include an image processing module 1653, a machine-trained model 1654 that may be executed by the processor 1610.

The network I/F 1620, which is a component capable of transmitting and receiving various data to and from a server, may be various types of devices capable of supporting wired or wireless communication. For example, a program for SOH calculation of the battery cell or determination of a balancing target or various data, a battery data transmission program, a battery diagnosis program, etc., may be transmitted and received to and from a separately provided external server through the network I/F 1620.

As such, the operating method of the battery diagnosis apparatus according to an embodiment disclosed herein may be recorded in the memory 1650 and executed by the MCU 1610.

Although a single processor, a single network interface, a single computer readable medium, a singer input/output device interface, a single memory, a single camera, and a single display are illustrated in the example of FIG. 15, in other implementations, the computing system 160 can have a multiple of one or more of these components (e.g., two or more processors and/or two or more memories).

Logical blocks, modules or units described in connection with implementations disclosed herein can be implemented or performed by a computing device having at least one processor, at least one memory and at least one communication interface. The elements of a method, process, or algorithm described in connection with implementations disclosed herein can be embodied directly in hardware, in a software module executed by at least one processor, or in a combination of the two. Computer-executable instructions for implementing a method, process, or algorithm described in connection with implementations disclosed herein can be stored in a non-transitory computer readable storage medium.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

## Claims

1. A battery diagnosis apparatus comprising:

    an interface configured to obtain open circuit voltage (OCV) data of a battery cell; and
    one or more processors configured to calculate a plurality of OCV deviations indicating a difference between an average OCV corresponding to a plurality of points in time for each of a plurality of battery cells included in a specific battery unit and an OCV of the battery cell, based on the OCV data, obtain a plurality of OCV deviation variances indicating a change degree of the plurality of OCV deviations for each of the plurality of points in time, apply a weighted moving average to the plurality of OCV deviation variances to obtain an OCV moving average, and diagnose abnormality of the battery cell based on the OCV moving average.

2. The battery diagnosis apparatus of claim 1, wherein the one or more processors are further configured to, when a kth OCV deviation variance corresponding to a kth point in time among the plurality of points in time is less than a first threshold OCV deviation variance and a (k-1)th OCV deviation corresponding to a (k-1)th point in time previous to the kth point in time is greater than or equal to a threshold OCV deviation, change the kth OCV deviation variance into a specific OCV deviation variance and apply the weighted moving average to the plurality of OCV deviation variances comprising the specific OCV deviation variance to obtain the OCV moving average.

3. The battery diagnosis apparatus of claim 1, wherein the one or more processors are further configured to diagnose abnormality of the battery cell based on a result of comparing the OCV moving average with a threshold moving average.

4. The battery diagnosis apparatus of claim 3, wherein the one or more processors are further configured to, when the OCV moving average is less than the threshold moving average, increase a diagnosis count by a first increment and diagnose abnormality of the battery cell based on a result of comparing the diagnosis count with a threshold count.

**5.** The battery diagnosis apparatus of claim 4, wherein the one or more processors are further configured to calculate a second increment based on a degree to which the OCV moving average is less than the threshold moving average, and further increase the diagnosis count by the second increment.

**6.** The battery diagnosis apparatus of claim 4, wherein the one or more processors are further configured to reduce the diagnosis count when the OCV moving average is greater than or equal to the threshold moving average.

**7.** The battery diagnosis apparatus of claim 1, wherein the one or more processors are further configured to change some OCV deviation variances less than a second threshold OCV deviation variance among the plurality of OCV deviation variances into the second threshold OCV deviation variance and apply the weighted moving average to the plurality of OCV deviation variances comprising the some OCV deviation variances to obtain the OCV moving average.

**8.** The battery management apparatus of claim 1, wherein the one or more processors are further configured to apply an exponentially weighted moving average to the plurality of OCV deviation variances to obtain the OCV moving average.

**9.** The battery diagnosis apparatus of claim 1, wherein the OCV data comprises a result of compensating for beforecompensation OCV data of at least some of the battery cells by using a balancing capacity based on balancing processing performed on the at least some of the battery cells.

**10.** The battery diagnosis apparatus of claim 9, wherein the balancing capacity comprises a result of accumulating a discharging capacity of the battery cell based on the balancing processing.

**11.** A battery diagnosis method comprising:

obtaining open circuit voltage (OCV) data of a battery cell; calculating a plurality of OCV deviations indicating a difference between an average OCV corresponding to a plurality of points in time for each of a plurality of battery cells included in a specific battery unit and an OCV of the battery cell, based on the OCV data; obtaining a plurality of OCV deviation variances based on the plurality of OCV deviations; applying a weighted moving average to the plurality of OCV deviation variances to obtain an OCV moving average; and diagnosing abnormality of the battery cell based on the OCV moving average.

**12.** The battery diagnosis method of claim 11, wherein the obtaining of the OCV moving average comprises, when a kth OCV deviation variance corresponding to a kth point in time among the plurality of points in time is less than a first threshold OCV deviation variance and a (k-1)th OCV deviation corresponding to a (k-1)th point in time previous to the kth point in time is greater than or equal to a threshold OCV deviation, changing the kth OCV deviation variance into a specific OCV deviation variance and applying the weighted moving average to the plurality of OCV deviation variances comprising the specific OCV deviation variance to obtain the OCV moving average.

**13.** The battery diagnosis method of claim 11, wherein the diagnosing of abnormality of the battery cell comprises diagnosing abnormality of the battery cell based on a result of comparing the OCV moving average with a threshold moving average.

**14.** The battery diagnosis method of claim 13, wherein the diagnosing of abnormality of the battery cell comprises, when the OCV moving average is less than the threshold moving average, increasing a diagnosis count by a first increment and diagnosing abnormality of the battery cell based on a result of comparing the diagnosis count with a threshold count.

**15.** The battery diagnosis method of claim 14, wherein the diagnosing of abnormality of the battery cell comprises calculating a second increment based on a degree to which the OCV moving average is less than the threshold moving average, and further increasing the diagnosis count by the second increment.

**16.** The battery diagnosis method of claim 14, wherein the diagnosing of abnormality of the battery cell comprises reducing the diagnosis count when the OCV moving average is greater than or equal to the threshold moving average.

**17.** The battery diagnosis method of claim 11, wherein the obtaining of the OCV moving average comprises changing some OCV deviation variances less than a second threshold OCV deviation variance among the plurality of OCV deviation variances into the second threshold OCV deviation variance and applying the weighted moving average to the plurality of OCV deviation variances comprising the some OCV deviation variances to obtain the OCV moving average.

**18.** The battery diagnosis method of claim 11, wherein the obtaining of the OCV moving average comprises applying an exponentially weighted moving average to the plurality of OCV deviation variances to obtain the OCV moving average.

19. The battery diagnosis method of claim 11, wherein the OCV data comprises a result of compensating for beforecompensation OCV data of at least some of the battery cells by using a balancing capacity based on balancing processing performed on the at least some of the battery cells.

20. The battery diagnosis method of claim 19, wherein the balancing capacity comprises a result of accumulating a discharging capacity of the battery cell based on the balancing processing.

21. A method concerning on a battery's health, the method comprising:

providing a battery apparatus comprising a plurality of battery cells;
measuring a voltage for each of the plurality of battery cells at a single measurement timeframe, which provides a plurality of voltages of the plurality of battery cells measured at the single measurement timeframe;
processing the plurality of voltages for the plurality of battery cells measured at the single measurement timeframe to provide a composite voltage for the plurality of battery cells for the single measurement timeframe;
repeating the step of measuring a voltage multiple times to provide multiple voltages for each battery cell measured at multiple measurement timeframes, which provides multiple sets of voltages for the plurality of battery cells such that each set of voltages represents voltages for the plurality of battery cells measured at one of the multiple measurement timeframes;
repeating the step of processing each set of voltages to provide multiple composite voltages for the plurality of battery cells such that each of the multiple composite voltages represents a composite voltage for the plurality of battery cells at one of the multiple measurement timeframes;
first determining if any of the plurality of battery cells has a rate of its voltage decrease that is greater, by at least a first predetermined threshold over a first predetermined length of time, than a rate of decrease of the composite voltage for the plurality of battery cells over the first predetermined length of time;
second determining if any of the plurality of battery cells has a rate of voltage decrease that is greater, by at least a second predetermined threshold over a second predetermined length of time, than a rate of decrease of the composite voltage for the plurality of battery cells over the second predetermined length of time; and
generating an alert if any battery cell is identified with any of the first determining step and the second determining step,
wherein the first predetermined threshold is substantially smaller than the second predetermined threshold while the first predetermined length of time is longer than the second predetermined length of time such that the first determining step is to identify any battery cell that has its voltage decreasing substantially slower than any battery cell that would be identified with the second determining step and therefore would not be identified with the second determining step.

22. The method of Claim 21, wherein the voltage measured is an open circuit voltage (OCV),
wherein the composite voltage is an average voltage.

23. The method of Claim 21, wherein no alert is generated even if any of the plurality of battery cells has a rate of voltage decrease being greater, by at least the first predetermined threshold over a third predetermined length of time, than a rate of decrease of the composite voltage for the plurality of battery cells over the third predetermined length of time when the third predetermined length of time shorter than the second predetermined length of time and further when the rate of voltage decrease for any of the plurality of battery cells is within an acceptable range of fluctuation of the rate of voltage decrease for individual cells over the third predetermined length of time.

24. The method of Claim 23, wherein the third predetermined length of time is within a range formed with two ones selected from the group consisting of 1 hour, 2 hours, 3 hours, 4 hours, 5 hours, 6 hours, 7 hours, 8 hours, 10 hours, 11 hours, 12 hours, 13 hours, 14 hours, 15 hours, 16 hours, 17 hours, 18 hours, 19 hours, 20 hours, 21 hours, 22 hours, 23 hours, 1 day, 2 days, 3 days, 4 days, 5 days, 6 days, 7 days, 8 days, 9 days, and 10 days.

25. The method of Claim 23, wherein the acceptable range of fluctuation is within a range formed with two ones selected from the group consisting of 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50 mV/t.

26. The method of Claim 21, wherein the alert comprises information suggesting a consultation about the battery's health, suggesting a service with regard to the battery apparatus, and/or replacing at least part of the battery apparatus.

27. The method of Claim 21, further comprising:

third determining if any of the plurality of battery cells has a rate of its voltage decrease that is greater, by a third predetermined threshold over a third predetermined length of time, than a rate of decrease of the composite voltage for the plurality of battery cells over the third predetermined length of time; and

generating an alert if any battery cell is identified with any of the first determining step, the second determining step, and the third determining step,

wherein the second predetermined threshold is substantially smaller than the third predetermined threshold while the third predetermined length of time is shorter than the second predetermined length of time.

28. The method of Claim 27, wherein no alert is generated even if any of the plurality of battery cells has a rate of voltage decrease being greater, by at least the first predetermined threshold over the third predetermined length of time, than the rate of decrease of the composite voltage for the plurality of battery cells over the third predetermined length of time when the rate of voltage decrease for any of the plurality of battery cells is within an acceptable range of fluctuation of the rate of voltage decrease for individual cells over the third predetermined length of time.

29. The method of Claim 21, wherein measuring the voltage for each of the plurality of battery cells at the single measurement timeframe occurs simultaneously or consecutively such that measurements for the plurality of battery cells are completed within a generally same timeframe.

30. The method of Claim 21, wherein the step of first determining comprises:

for each of the plurality of battery cells, computing a difference between the voltage of the battery cell and the composite voltage for the plurality of battery cells for a first measurement timeframe of the multiple measurement timeframes, which provides a first set of values for the difference for the plurality of battery cells for the first measurement timeframe such that the first set of values comprises a value for the difference for each of the plurality of cells for the first measurement timeframe;

repeating the step of computing a difference for additional measurement timeframes of the multiple timeframes, which provides additional sets of values for the difference for the plurality of battery cells for the additional measurement timeframes such that each set of values comprises a value for the difference for each of the plurality of cells for one measurement timeframe of the additional measurement timeframes;

for each of the plurality of battery cells, computing a rate of change in the difference over the first predetermined length of time using at least part of the first set of values and the additional sets of values; and

determining if there is any battery cell having a rate of voltage decrease over the first predetermined length of time greater than the first predetermined threshold using the computed rate of change for each of the plurality of battery cells.

31. The method of Claim 30, wherein the step of computing a rate of change in the difference over the first predetermined length of time computes the rate of change in the difference for the first predetermined length of time beginning at the first measurement timeframe,

wherein the step of first determining further comprises:

for each of the plurality of battery cells, repeating the step of computing a rate of change in the difference over the first predetermined length of time beginning at one or more of the additional measurement timeframes, which provides rates of change in the difference for each of the plurality of battery cells such that each of the rates of change in the difference for each of the plurality of battery cells represents the rate of change for the battery cell for one of the one or more of the additional measurement timeframes; and

using at least part of the rates of change in the difference as computed for each of the plurality of battery cells to determine if there is any battery cell having a rate of voltage decrease over the first predetermined length of time greater than the first predetermined threshold for the first predetermined length of time beginning at one or more of the additional measurement timeframes.

32. The method of Claim 31, wherein, when at least one of the plurality of battery cell is determined to have its rate of voltage decrease greater than the first predetermined threshold over the first predetermined length of time beginning any of the measurement timeframes, the battery cell is identified, which causes generating the alert.

33. The method of Claim 31, wherein the step of first determining further comprises:

counting, for each of the plurality of battery cells, each time when the battery cell is determined to have its rate of voltage decrease over the first predetermined length of time to be greater than the first predetermined threshold; and determining, for each of the plurality of battery cells, if counting reaches a predetermined counting threshold.

34. The method of Claim 33, wherein, when counting for one of the plurality of battery cell reaches the predetermined counting threshold, the battery cell is identified, which causes generating the alert.

35. The method of Claim 30, wherein the step of second determining comprises:

for each of the plurality of battery cells, computing a rate of change in the difference over the second predetermined length of time using at least part of the first set of values and the additional sets of values; and determining if there is any battery cell having a rate of voltage decrease over the second predetermined length of time greater than the second predetermined threshold using the computed rate of change for each of the plurality of battery cells.

36. The method of Claim 35, wherein the step of computing a rate of change in the difference over the second predetermined length of time computes the rate of change in the difference for the second predetermined length of time beginning at the first measurement timeframe or another measurement timeframe, wherein the step of second determining further comprises:

for each of the plurality of battery cells, repeating the step of computing a rate of change in the difference over the second predetermined length of time beginning at one or more of the additional measurement timeframes, which provides rates of change in the difference for each of the plurality of battery cells such that each of the rates of change in the difference for each of the plurality of battery cells represents the rate of change for the battery cell for one of the one or more of the additional measurement timeframes; and using at least part of the rates of change in the difference as computed for each of the plurality of battery cells to determine if there is any battery cell having a rate of voltage decrease over the second predetermined length of time greater than the second predetermined threshold for the second predetermined length of time beginning at one or more of the additional measurement timeframes.

37. The method of Claim 36, wherein, when at least one of the plurality of battery cell is determined to have its rate of voltage decrease greater than the second predetermined threshold over the second predetermined length of time beginning any of the measurement timeframes, the battery cell is identified, which causes generating the alert.

38. The method of Claim 36, wherein the step of second determining further comprises:

counting, for each of the plurality of battery cells, each time when the battery cell is determined to have its rate of voltage decrease over the second predetermined length of time to be greater than the second predetermined threshold; and determining, for each of the plurality of battery cells, if counting reaches a predetermined counting threshold.

39. The method of Claim 38, wherein, when counting for one of the plurality of battery cell reaches the predetermined counting threshold, the battery cell is identified, which causes generating the alert.

40. The method of Claim 21, wherein the step of second determining comprises:

for each of the plurality of battery cells, computing a difference between the voltage of the battery cell and the composite voltage for the plurality of battery cells for a first measurement timeframe of the multiple measurement timeframes, which provides a first set of values for the difference for the plurality of battery cells for the first measurement timeframe such that the first set of values comprises a value for the difference for each of the plurality of cells for the first measurement timeframe; repeating the step of computing a difference for additional measurement timeframes of the multiple timeframes, which provides additional sets of values for the difference for the plurality of battery cells for the additional measurement timeframes such that each set of values comprises a value for the difference for each of the plurality of cells for one measurement timeframe of the additional measurement timeframes; for each of the plurality of battery cells, computing a rate of change in the difference over the second predetermined length of time using at least part of the first set of values and the additional sets of values; and determining if there is any battery cell having a rate of voltage decrease over the second predetermined length of time greater than the second predetermined threshold using the computed rate of change for each of the plurality of battery cells.

41. The method of Claim 40, wherein the step of computing a rate of change in the difference over the second predetermined length of time computes the rate of change in the difference for the second predetermined length of time beginning at the first measurement timeframe or another measurement timeframe,
wherein the step of second determining further comprises:

for each of the plurality of battery cells, repeating the step of computing a rate of change in the difference over the second predetermined length of time beginning at one or more of the additional measurement timeframes, which provides rates of change in the difference for each of the plurality of battery cells such that each of the rates of change in the difference for each of the plurality of battery cells represents the rate of change for the battery cell for one of the one or more of the additional measurement timeframes; and
using at least part of the rates of change in the difference as computed for each of the plurality of battery cells to determine if there is any battery cell having a rate of voltage decrease over the second predetermined length of time greater than the second predetermined threshold for the second predetermined length of time beginning at one or more of the additional measurement timeframes.

42. The method of Claim 41, wherein, when at least one of the plurality of battery cell is determined to have its rate of voltage decrease greater than the second predetermined threshold over the second predetermined length of time beginning any of the measurement timeframes, the battery cell is identified, which causes generating the alert.

43. The method of Claim 42, wherein the step of second determining further comprises:

counting, for each of the plurality of battery cells, each time when the battery cell is determined to have its rate of voltage decrease over the second predetermined length of time to be greater than the second predetermined threshold; and
determining, for each of the plurality of battery cells, if counting reaches a predetermined counting threshold.

44. The method of Claim 43, wherein, when counting for one of the plurality of battery cell reaches the predetermined counting threshold, the battery cell is identified, which causes generating the alert.

45. A non-transitory computer readable medium storing instructions that, when executed, performs the method of Claim 21.

100

BATTERY PACK
102

| BATTERY MODULE 1 | BATTERY MODULE 2 | BATTERY MODULE 3 |
| 110 | 120 | 130 |

BATTERY CELL 1
112

BATTERY CELL 1
122

BATTERY CELL 1
132

BATTERY CELL 2
114

BATTERY CELL 2
124

BATTERY CELL 2
134

⋮

⋮

. . .

⋮

BATTERY CELL N
116

BATTERY CELL N
126

BATTERY CELL N
136

BMS
104

INTERFACE
106

PROCESSOR
108

FIG.1

FIG.2

FIG.3A

FIG.3B

FIG.3C

```
                    ┌─────────────┐
                    │    START    │
                    └─────────────┘
                           │
                           ▼
   ┌──────────────────────────────────────────────┐
   │      OBTAIN OCV DATA OF BATTERY CELL          │───405
   └──────────────────────────────────────────────┘
                           │
                           ▼
   ┌──────────────────────────────────────────────┐
   │   CALCULATE OCV DEVIATION OF BATTERY CELL     │───410
   │     INCLUDED IN SPECIFIC BATTERY MODULE       │
   └──────────────────────────────────────────────┘
                           │
                           ▼
   ┌──────────────────────────────────────────────┐
   │   OBTAIN PLURALITY OF OCV DEVIATION VARIANCES │───415
   └──────────────────────────────────────────────┘
                           │
                           ▼
   ┌──────────────────────────────────────────────┐
   │          OBTAIN OCV MOVING AVERAGE            │───420
   └──────────────────────────────────────────────┘
                           │
                           ▼
   ┌──────────────────────────────────────────────┐
   │      DIAGNOSE ABNORMALITY OF BATTERY CELL     │───425
   └──────────────────────────────────────────────┘
                           │
                           ▼
                    ┌─────────────┐
                    │     END     │
                    └─────────────┘
```

FIG.4

FIG.5

F I G. 6

FIG.7

EP 4 764 545 A1

FIG.8A

Cell 1

$\Delta V = ( Cell\ 1\ OCV - Avg.\ OCV )$

$Slope\ L = \dfrac{\Delta V_L - \Delta V_{Ln-1}}{t_{Ln} - t_{Ln-1}}$

$Slope\ S = \dfrac{\Delta V_{Sn} - \Delta V_{Sn-1}}{t_{Sn} - t_{Sn-1}}$

502

Time

ΔV (Mv)

FIG.8B

EP 4 764 545 A1

Cell 1

$$\text{Slope } S = \frac{\Delta V_{Sn} - \Delta V_{Sn-1}}{t_{Sn} - t_{Sn-1}}$$

Slope (mV/t) RdV

503

Threshold S

Time

EP 4 764 545 A1

FIG.8C

Counting Slope for Cell 1

FIG.8D

EP 4 764 545 A1

Cell 1

$$SMA = \frac{1}{n} \sum_{i=1}^{n} x_i$$

Threshold S

FIG.8E

Counting Moving Average for Cell 1

FIG.8F

EP 4 764 545 A1

Cell 1

FIG.8G

Counting Weighted Moving Average for Cell 1

FIG.8H

FIG.8I

EP 4 764 545 A1

Cell 1

$$\text{Slope } L = \frac{\Delta V_{Ln} - \Delta V_{Ln-1}}{t_{Ln} - t_{Ln-1}}$$

FIG.8J

Counting Slope for Cell 1

FIG.8K

EP 4 764 545 A1

Cell 1

$$SMA = \frac{1}{n} \sum_{i=1}^{n} x_i$$

507

Threshold L

Moving Avg.Slope LRdV

Time

FIG.8L

Counting Moving Average for Cell 1

FIG.8M

Cell 1

$$Weighterd\ Average = \frac{\sum_{i=1}^{n} W_i \cdot X_i}{\sum_{i=1}^{n} W_i}$$

FIG.8N

Counting Weighted Moving Average for Cell 1

FIG.80

Cell 1

$$\text{Slope } L = \frac{\Delta V_{Ln} - \Delta V_{Ln-1}}{t_{Ln} - t_{Ln-1}}$$

Threshold S

Rate $\Delta V1$ S
Avg. Rate S

Time

Slope (mV/t) LRdV

FIG.8P

EP 4 764 545 A1

Cell 1

FIG.8Q

EP 4 764 545 A1

Cell 2

FIG.9A

EP 4 764 545 A1

Cell 2

$\Delta V=(Cell\ 2\ OCV-Avg.OCV)$

$Slope\ S=\dfrac{\Delta V_{Sn}-\Delta V_{Sn-1}}{t_{Sn}-t_{Sn-1}}$

$Slope\ L=\dfrac{\Delta V_{Ln}-\Delta V_{Ln-1}}{t_{Ln}-t_{Ln-1}}$

$\Delta V(mV)$

Month

FIG.9B

Cell 2

FIG.9C

EP 4 764 545 A1

Counting Slope for Cell 2

FIG.9D

Moving Average for Cell 2

$$SMA = \frac{1}{n} \sum_{i=1}^{n} x_i$$

Threshold S

FIG.9E

Counting Moving Average for Cell 2

FIG.9F

Weighted Moving Average for Cell 2

$$\text{Weighted Average} = \frac{\sum_{i=1}^{n} w_i \cdot x_i}{\sum_{i=1}^{n} w_i}$$

Threshold S

FIG.9G

EP 4 764 545 A1

EP 4 764 545 A1

Counting Weighted Moving Average for Cell 2

FIG.9H

Cell 2

Avg Rate(Cell1,Cell2,Cell3,Cell4,Cell5)

Rate $\Delta V2$ S
Avg.Rate S

$$\text{Slope } S = \frac{\Delta V_{Sn} - \Delta V_{Sn-1}}{t_{Sn} - t_{Sn-1}}$$

Slope(mV/t)

Time

FIG.9I

Cell 2

Threshold L

$$Slope \ L = \frac{\Delta V_{Ln} - \Delta V_{Ln-1}}{t_{Ln} - t_{Ln-1}}$$

FIG.9J

Counting Slope for Cell 2

FIG.9K

EP 4 764 545 A1

Moving Average for Cell 2

$$SMA = \frac{1}{n} \sum_{i=1}^{n} x_i$$

Threshold S

Moving Average(mV/t) LRdV

Time

FIG.9L

Counting Moving Average for Cell 2

FIG.9M

EP 4 764 545 A1

Weighted Moving Average for Cell 2

$$\text{Weighted Average} = \frac{\sum_{i=1}^{n} w_i \cdot x_i}{\sum_{i=1}^{n} w_i}$$

FIG.9N

Counting Weight Moving Average for Cell 2

FIG.90

EP 4 764 545 A1

Cell 2

$$\text{Slope } L = \frac{\Delta V_{Ln} - \Delta V_{Ln-1}}{t_{Ln} - t_{Ln-1}}$$

● Rate $\Delta V2$ L
▲ Avg.Rate L

Slope(mV/t)

Time

FIG.9P

EP 4 764 545 A1

FIG.9Q

EP 4 764 545 A1

Cell 4

FIG.10A

Cell 4

$$\Delta V = (\text{Cell 4 OCV} - \text{Avg. OCV})$$

$$\text{Slope S} = \frac{\Delta V_{Sn} - \Delta V_{Sn-1}}{t_{Sn} - t_{Sn-1}}$$

$$\text{Slope L} = \frac{\Delta V_{Ln} - \Delta V_{Ln-1}}{t_{Ln} - t_{Ln-1}}$$

Time

FIG.10B

EP 4 764 545 A1

FIG.10C

EP 4 764 545 A1

EP 4 764 545 A1

Counting Slope for Cell 4

FIG.10D

Cell 4

$$SMA = \frac{1}{n} \sum_{i=1}^{n} W_i$$

Threshold S

FIG.10E

EP 4 764 545 A1

Counting Weighted Moving Average for Cell 4

FIG.10F

Cell 4

$$\text{Weighted Average} = \frac{\sum_{i=1}^{n} w_i \cdot w_i}{\sum_{i=1}^{n} w_i}$$

Threshold S

Time

FIG.10G

Counting Weighted Moving Average for Cell 4

FIG.10H

$$\text{Slope } S = \frac{\Delta V_{Sn} - \Delta V_{Sn-1}}{t_{Sn} - t_{Sn-1}}$$

FIG.10I

Cell 4

$$\text{Slope } L = \frac{\Delta V_{Ln} - \Delta V_{Ln-1}}{t_{Ln} - t_{Ln-1}}$$

Threshold L

Slope (mV/t)LrDV

Time

FIG.10J

Counting Slope for Cell 4

FIG.10K

Cell 4

$$SMA = \frac{1}{n} \sum_{i=1}^{n} W_i$$

FIG.10L

EP 4 764 545 A1

Counting Weighted Moving Average for Cell 4

FIG.10M

FIG. 10N

EP 4 764 545 A1

Counting Weighted Moving Average for Cell 4

FIG.100

Cell 4

Legend:
- Rate ΔV4 S
- Avg. Rate L

Threshold S

Slope (mV/t)

Time

FIG. 10P

86

Cell 4

FIG.10Q

FIG.11A

EP 4 764 545 A1

FIG.11B

EP 4 764 545 A1

FIG.11C

FIG.11D

EP 4 764 545 A1

EP 4 764 545 A1

Cell 1

FIG.11E

FIG.11F

Cell 1

Weighted Moving Average RdV

Time

FIG.11G

FIG.11H

FIG. 111

Cell 1

FIG.11J

START

MEASURING A VOLTAGE FOR EACH OF
THE PLURALITY OF BATTERY CELLS — S902

PROCESSING THE PLURALITY OF VOLTAGES
TO PROVIDE A COMPOSITE VOLTAGE — S904

FIRST DETERMINING IF ANY OF THE PLURALITY OF BATTERY
CELLS HAS A RATE OF ITS VOLTAGE DECREASE THAT IS GREATER,
BY AT LEAST A FIRST PREDETERMINED THRESHOLD OVER A FIRST
PREDETERMINED LENGTH OF TIME, THAN A RATE OF DECREASE OF
THE COMPOSITE VOLTAGE FOR THE PLURALITY OF BATTERY CELLS
OVER THE FIRST PREDETERMINED LENGTH OF TIME — S906

SECOND DETERMINING IF ANY OF THE PLURALITY OF BATTERY CELLS
HAS A RATE OF VOLTAGE DECREASE THAT IS GREATER, BY AT
LEAST A SECOND PREDETERMINED THRESHOLD OVER A SECOND
PREDETERMINED LENGTH OF TIME, THAN A RATE OF DECREASE OF
THE COMPOSITE VOLTAGE FOR THE PLURALITY OF BATTERY CELLS
OVER THE SECOND PREDETERMINED LENGTH OF TIME — S908

GENERATING AN ALERT IF ANY BATTERY CELL IS IDENTIFIED WITH
ANY OF THE FIRST DETERMINING STEP AND
THE SECOND DETERMINING STEP — S910

FIG.12A

THIRD DETERMINING IF A RATE OF ITS VOLATAGE DECREASE IS GREATER THAN A RATE OF DECREASE OF THE COMPOSITE VOLTAGE OVER THE THIRD PREDETERMINED LENGTH OF TIME  —S912

GENERATING AN ALERT IF ANY BATTERY CELL IS IDENTIFIED WITH ANY OF THE FIRST DETERMINING STEP, THE SECOND DETERMINING STEP, AND THE THIRD DETERMINING STEP  —S914

END

FIG.12B

COMPUTING A DIFFERENCE BETWEEN THE VOLTAGE OF THE BATTERY CELL AND THE COMPOSITE VOLTAGE FOR A FIRST MEASUREMENT TIMEFRAME OF THE MULTIPLE MEASUREMENT TIMEFRAMES — S906-2

COMPUTING A RATE OF CHANGE IN THE DIFFERENCE OVER THE FIRST PREDETERMINED LENGTH OF TIME — S906-4

DETERMINING IF THERE IS ANY BATTERY CELL HAVING A RATE OF VOLTAGE DECREASE OVER THE FIRST PREDETERMINED LENGTH OF TIME GREATER THAN THE FIRST PREDETERMINED THRESHOLD — S906-6

FIG.13A

COUNTING, FOR EACH OF THE PLURALITY OF BATTERY CELLS, EACH TIME WHEN THE BATTERY CELL IS DETERMINED TO HAVE ITS RATE OF VOLTAGE DECREASE OVER THE FIRST PREDETERMINED LENGTH OF TIME TO BE GREATER THAN THE FIRST PREDETERMINED THRESHOLD ~S906-8

DETERMINING, FOR EACH OF THE PLURALITY OF BATTERY CELLS, IF COUNTING REACHES A PREDETERMINED COUNTING THRESHOLD ~S906-10

FIG.13B

COMPUTING A RATE OF CHANGE IN THE DIFFERENCE OVER THE SECOND PREDETERMINED LENGTH OF TIME USING AT LEAST PART OF THE FIRST SET OF VALUES AND THE ADDITIONAL SETS OF VALUES ~S908-2

DETERMINING IF THERE IS ANY BATTERY CELL HAVING A RATE OF VOLTAGE DECREASE OVER THE SECOND PREDETERMINED LENGTH OF TIME GREATER THAN THE SECOND PREDETERMINED THRESHOLD ~S908-4

FIG.14A

COUNTING EACH TIME WHEN THE BATTERY CELL IS DETERMINED TO HAVE ITS RATE OF VOLTAGE DECREASE OVER THE SECOND PREDETERMINED LENGTH OF TIME TO BE GREATER THAN THE SECOND PREDETERMINED THRESHOLD ～S908-6

DETERMINING IF COUNTING REACHES A PREDETERMINED COUNTING THRESHOLD ～S908-8

F I G.14B

COMPUTING A DIFFERENCE BETWEEN THE VOLTAGE OF THE BATTERY CELL AND THE COMPOSITE VOLTAGE FOR THE PLURALITY OF BATTERY CELLS FOR A FIRST MEASUREMENT TIMEFRAME OF THE MULTIPLE MEASUREMENT TIMEFRAMES ⌐S908-10

COMPUTING A RATE OF CHANGE IN THE DIFFERENCE OVER THE SECOND PREDETERMINED LENGTH OF TIME USING AT LEAST PART OF THE FIRST SET OF VALUES AND THE ADDITIONAL SETS OF VALUES ⌐S908-12

DETERMINING IF THERE IS ANY BATTERY CELL HAVING A RATE OF VOLTAGE DECREASE OVER THE SECOND PREDETERMINED LENGTH OF TIME GREATER THAN THE SECOND PREDETERMINED THRESHOLD ⌐S908-14

FIG.14C

COUNTING EACH TIME WHEN THE BATTERY CELL IS DETERMINED TO HAVE ITS RATE OF VOLTAGE DECREASE OVER THE SECOND PREDETERMINED LENGTH OF TIME TO BE GREATER THAN THE SECOND PREDETERMINED THRESHOLD ~S908-16

DETERMINING FOR EACH OF THE PLURALITY OF BATTERY CELLS, IF COUNTING REACHES A PREDETERMINED COUNTING THRESHOLD ~S908-18

FIG.14D

Computing System
160

PROCESSOR
1610

NETWORK INTERFACE
1620

COMPUTER READABLE MEDIUM
1630

INPUT/OUTPUT DEVICE INTERFACE
1640

DISPLAY
1641

CAMERA
1642

MEMORY
1650

OPERATING SYSTEM
1651

USER INTERFACE MODULE
1652

IMAGE PROCESSING MODULE
1653

MACHINE-TRAINED MODEL
1654

FIG.15

## INTERNATIONAL SEARCH REPORT

| International application No. |
| --- |
| **PCT/KR2025/004443** |

### A. CLASSIFICATION OF SUBJECT MATTER

**G01R 31/392**(2019.01)i; **G01R 31/3835**(2019.01)i; **G01R 31/36**(2006.01)i; **G01R 19/10**(2006.01)i; **G01R 31/367**(2019.01)i; **G01R 19/165**(2006.01)i; **G01R 19/00**(2006.01)i; **G01R 19/12**(2006.01)i; **G01R 31/52**(2020.01)i

According to International Patent Classification (IPC) or to both national classification and IPC

### B. FIELDS SEARCHED

Minimum documentation searched (classification system followed by classification symbols)

G01R 31/392(2019.01); G01R 19/00(2006.01); G01R 31/36(2006.01); G01R 31/367(2019.01); H01M 10/44(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 평균(average), 개방회로전압(OCV, Open Circuit Voltage), 가중이동평균(weighted moving average)

### C. DOCUMENTS CONSIDERED TO BE RELEVANT

| Category* | Citation of document, with indication, where appropriate, of the relevant passages | Relevant to claim No. |
| --- | --- | --- |
| A | KR 10-2024-0041810 A (LG ENERGY SOLUTION, LTD.) 01 April 2024 (2024-04-01) <br> See paragraphs [0047]-[0056] and figures 2-3. | 1-45 |
| A | KR 10-2196668 B1 (KOREA ELECTRIC POWER CORPORATION) 30 December 2020 (2020-12-30) <br> See paragraphs [0055]-[0096] and figures 7-8. | 1-45 |
| A | KR 10-2024-0014216 A (KOREA INSTITUTE OF ENERGY RESEARCH) 01 February 2024 (2024-02-01) <br> See paragraphs [0096]-[0101] and figures 6-7. | 1-45 |
| A | KR 10-2023-0016530 A (LG ENERGY SOLUTION, LTD.) 02 February 2023 (2023-02-02) <br> See claims 1-14. | 1-45 |
| A | JP 2018-179682 A (NISSAN MOTOR CO., LTD.) 15 November 2018 (2018-11-15) <br> See claims 1-12. | 1-45 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **11 July 2025** | **13 July 2025** |

| Name and mailing address of the ISA/KR | Authorized officer |
| --- | --- |
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/004443**

| Patent document cited in search report | | | Publication date (day/month/year) | Patent family member(s) | | | Publication date (day/month/year) |
|---|---|---|---|---|---|---|---|
| KR | 10-2024-0041810 | A | 01 April 2024 | EP | 4560330 | A2 | 28 May 2025 |
| | | | | KR | 10-2024-0119021 | A | 06 August 2024 |
| | | | | KR | 10-2690411 | B1 | 05 August 2024 |
| | | | | US | 2025-0123334 | A1 | 17 April 2025 |
| | | | | WO | 2024-063418 | A2 | 28 March 2024 |
| | | | | WO | 2024-063418 | A3 | 23 May 2024 |
| KR | 10-2196668 | B1 | 30 December 2020 | | None | | |
| KR | 10-2024-0014216 | A | 01 February 2024 | KR | 10-2753063 | B1 | 14 January 2025 |
| KR | 10-2023-0016530 | A | 02 February 2023 | CN | 116324450 | A | 23 June 2023 |
| | | | | EP | 4286870 | A1 | 06 December 2023 |
| | | | | JP | 2023-543779 | A | 18 October 2023 |
| | | | | JP | 2024-174964 | A | 17 December 2024 |
| | | | | JP | 7556634 | B2 | 26 September 2024 |
| | | | | KR | 10-2025-0047965 | A | 07 April 2025 |
| | | | | KR | 10-2791127 | B1 | 02 April 2025 |
| | | | | US | 2024-0044999 | A1 | 08 February 2024 |
| | | | | WO | 2023-008883 | A1 | 02 February 2023 |
| JP | 2018-179682 | A | 15 November 2018 | JP | 6898585 | B2 | 07 July 2021 |

Form PCT/ISA/210 (patent family annex) (July 2022)

**REFERENCES CITED IN THE DESCRIPTION**

**Patent documents cited in the description**

- KR 1020240045175
- KR 1020240059709
- KR 1020250042886